# EUROPEAN PATENT APPLICATION

(11) **EP 4 827 289 A1**
(43) Date of publication of application: **21.10.2026**
(21) Application number: 26169278.4
(22) Date of filing: 30.03.2026
(51) Int. Cl.: H10K 50/11, H10K 50/15, H10K 85/60

(54) **LIGHT-EMITTING DEVICE, ELECTRONIC APPARATUS INCLUDING THE SAME AND ELECTRONIC EQUIPMENT INCLUDING THE LIGHT-EMITTING DEVICE**

(30) Priority: 14.04.2025 KR 20250048393
(71) Applicant: Samsung Display Co., Ltd., Yongin-si, Gyeonggi-do 17113 (KR); Hodogaya Chemical Co., Ltd., Tokyo, 105-0021 (JP)
(72) Inventor: PARK, Hyejeong, 17113 Yongin-si (KR); KASE, Kouki, Tokyo, 105-0021 (JP); PARK, Young Hwan, Tokyo, 105-0021 (JP); LIM, Jea Geon, Tokyo, 105-0021 (JP)
(74) Representative: Marks & Clerk LLP

(57) **Abstract**

A light-emitting device includes a first compound represented by Formula 1 and a second compound represented by Formula 2:

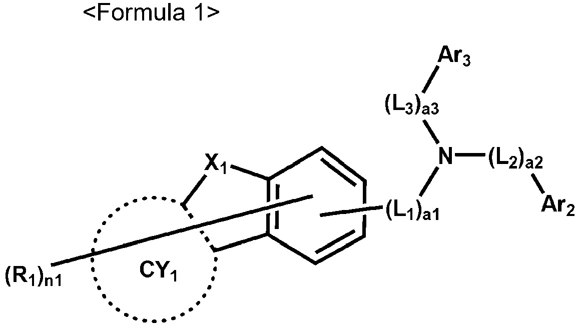

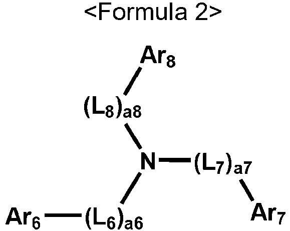

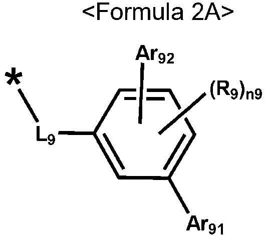

In the Formula 2, at least one of Ar₆ to Ar₈ is a group represented by Formula 2A, and
detailed descriptions of the Formulae 1, 2, and 2A are provided in the specification.

## Description

### BACKGROUND

### 1. Field

Embodiments relate to a light-emitting device, an electronic apparatus including the same and electronic equipment that includes the light-emitting device.

### 2. Description of the Related Art

From among light-emitting devices, self-emissive devices have wide viewing angles, high contrast ratios, short response times, and excellent characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. The excitons may transition from an excited state to a ground state, thereby generating light.

### SUMMARY

Embodiments include a novel light-emitting device, an electronic apparatus including the same and electronic equipment that includes the novel light-emitting device.

Additional features will be set forth in part in the description which follows and, in part, will be apparent from the description, or may be learned by practice of the presented embodiments of the disclosure.

In an embodiment, a light-emitting device includes a first electrode, a second electrode facing the first electrode, and an interlayer disposed between the first electrode and the second electrode and including an emission layer, where the interlayer includes a first compound represented by Formula 1 and a second compound represented by Formula 2: 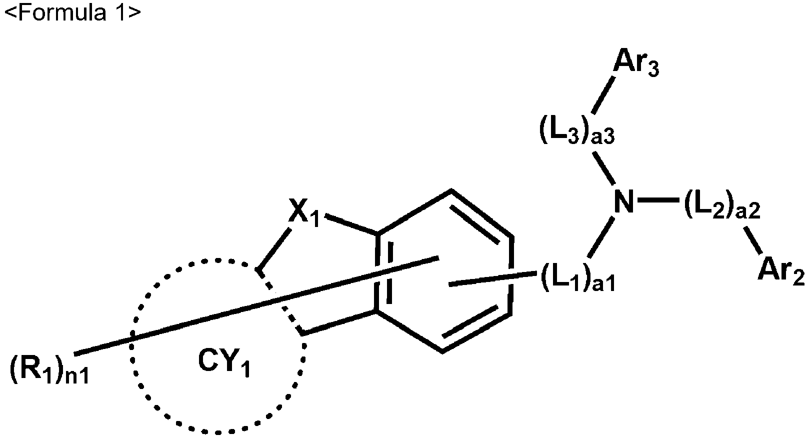 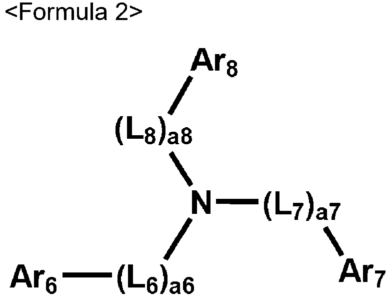 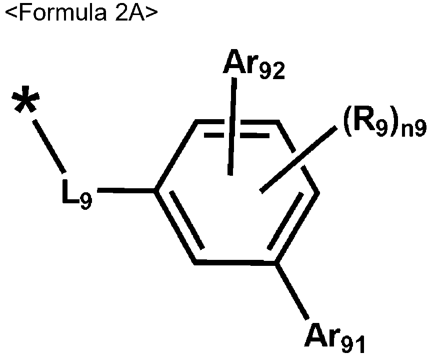 wherein, in the Formulae 1 and 2 and Formula 2A,
CY₁ is a C₃-C₆₀ carbocyclic group or a C₁-C₆₀ heterocyclic group,
X₁ is O, S, C(R₄)(R₅), Si(R₄)(R₅), N(R₄), or P(R₄),
Ar₂, Ar₃, Ar₉₁, and Ar₉₂ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
Ar₆ to Ar₈ are each independently a group represented by the Formula 2A, a C₃-C₆₀ carbocyclic group unsubstituted or substituted with at least one R₁₀ₐ, or a C₁-C₆₀ heterocyclic group unsubstituted or substituted with at least one R₁₀ₐ, provided that at least one of Ar₆ to Ar₈ is the group represented by the Formula 2A,
L₁ to L₃ and L₆ to L₉ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
a1 to a3 and a6 to a8 are each independently an integer from 0 to 3,
when a1 is 0, *-(L₁)ₐ₁-*' is a single bond, when a2 is 0, *-(L₂)ₐ₂-*' is a single bond, when a3 is 0, *-(L₃)ₐ₃-*' is a single bond, when a6 is 0, *-(L₆)ₐ₆-*' is a single bond, when a7 is 0, *-(L₇)ₐ₇-*' is a single bond, and when a8 is 0, *-(L₈)ₐ₈-*' is a single bond,
L₁(s) in the number of a1 are identical to or different from each other, L₂(s) in the number of a2 are identical to or different from each other, L₃(s) in the number of a3 are identical to or different from each other, L₆(s) in the number of a6 are identical to or different from each other, L₇(s) in the number of a7 are identical to or different from each other, and L₈(s) in the number of a8 are identical to or different from each other,
R₁, R₄, R₅, and R₉ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
n1 is an integer from 0 to 10,
n9 is an integer from 0 to 3,
R₁(s) in the number of n1 are identical to or different from each other, and R₉(s) in the number of n9 are identical to or different from each other,
two or more of R₁(s) in the number of n1 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₄ and R₅ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
two or more of R₉(s) in the number of n9 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
   deuterium, -F, -Cl, -Br, -I, a hydroxyl group, a cyano group, or a nitro group,
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or any combinations thereof,
   a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof, or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂),
Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof, and
* and *' each indicate a binding site to a neighboring (adjacent) atom.

In an embodiment, an electronic apparatus includes the light-emitting device.

In an embodiment, electronic equipment includes the light-emitting device.

At least some of the above and other features of the invention are set out in the claims.

### BRIEF DESCRIPTION OF THE DRAWINGS

The above and other features and advantages of illustrative embodiments of the disclosure will be more apparent from the following description taken in conjunction with the accompanying drawings, in which:
FIG. 1 is a schematic cross-sectional view of an embodiment of a light-emitting device;
FIG. 2 is a schematic cross-sectional view of an embodiment of an electronic apparatus;
FIG. 3 is a schematic cross-sectional view of another embodiment of an electronic apparatus;
FIG. 4 is a block diagram of an embodiment of electronic equipment;
FIG. 5 depicts schematic views of embodiments of electronic equipment;
FIG. 6 is a schematic perspective view of an embodiment of electronic equipment including a light-emitting device;
FIG. 7 is a diagram schematically illustrating an embodiment of the exterior of a vehicle as electronic equipment including a light-emitting device; and
FIGS. 8A to 8C are each a diagram schematically illustrating embodiments of the interior of a vehicle.

### DETAILED DESCRIPTION

Reference will now be made in detail to embodiments, illustrative embodiments of which are illustrated in the accompanying drawings, where like reference numerals refer to like elements throughout the specification. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

Hereinafter, embodiments of the disclosure will be described in detail with reference to the accompanying drawings. The same or corresponding components will be denoted by the same reference numerals, and thus redundant description thereof will be omitted.

It will be understood that although the terms "first," "second," etc. may be used herein to describe various components, these components should not be limited by these terms. These components are only used to distinguish one component from another.

An expression used in the singular encompasses the expression of the plural, unless it has a clearly different meaning in the context.

It will be further understood that the terms "comprises" and/or "comprising" used herein specify the presence of stated features or elements, but do not preclude the presence or addition of one or more other features or elements.

In the following embodiments, when various components such as layers, films, regions, plates, etc. are said to be "on" another component, this may include not only a case in which other components are "immediately on" the layers, films, regions, or plates, but also a case in which other components may be placed therebetween. Sizes of elements in the drawings may be exaggerated for convenience of explanation. In other words, because sizes and thicknesses of components in the drawings are arbitrarily illustrated for convenience of explanation, the following disclosure is not limited thereto.

The term "interlayer" as used herein refers to a single layer and/or all of multiple layers arranged between the first electrode and the second electrode of the light-emitting device.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

An embodiment of the disclosure provides a light-emitting device including:
a first electrode;
a second electrode facing the first electrode; and
an interlayer disposed between the first electrode and the second electrode and including an emission layer,
where the interlayer includes a first compound represented by Formula 1 and a second compound represented by Formula 2: 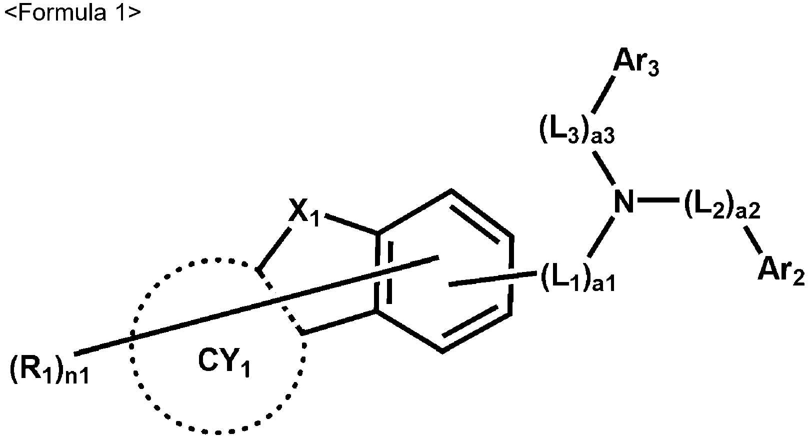 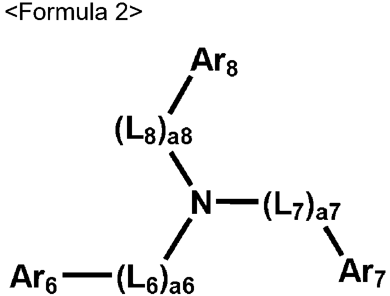 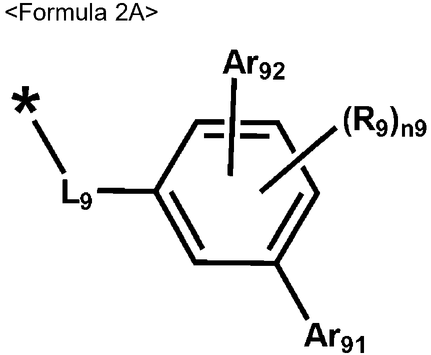
where, in Formulae 1, 2, and 2A,
CY₁ is a C₃-C₆₀ (e.g. C₆-C₂₀) carbocyclic group or a C₁-C₆₀ (e.g. C₁-C₂₀) heterocyclic group,
X₁ is O, S, C(R₄)(R₅), Si(R₄)(R₅), N(R₄), or P(R₄),
Ar₂, Ar₃, Ar₉₁, and Ar₉₂ are each independently a C₃-C₆₀ (e.g. C₃-C₂₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
Ar₆ to Ar₈ are each independently a group represented by Formula 2A, a C₃-C₆₀ (e.g. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ, provided that at least one of Ar₆ to Ar₈ is the group represented by Formula 2A,
L₁ to L₃ and L₆ to L₉ are each independently a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
a1 to a3 and a6 to a8 are each independently an integer from 0 to 3,
when a1 is 0, *-(L₁)ₐ₁-*' is a single bond, when a2 is 0, *-(L₂)ₐ₂-*' is a single bond, when a3 is 0, *-(L₃)ₐ₃-*' is a single bond, when a6 is 0, *-(L₆)ₐ₆-*' is a single bond, when a7 is 0, *-(L₇)ₐ₇-*" is a single bond, and when a8 is 0, *-(L₈)ₐ₈-*' is a single bond,
L₁(s) in the number of a1 are identical to or different from each other, L₂(s) in the number of a2 are identical to or different from each other, L₃(s) in the number of a3 are identical to or different from each other, L₆(s) in the number of a6 are identical to or different from each other, L₇(s) in the number of a7 are identical to or different from each other, and L₈(s) in the number of a8 are identical to or different from each other,
R₁, R₄, R₅, and R₉ are each independently hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, a C₆-C₆₀ (*e.g*. C₆-C₃₀) aryloxy group unsubstituted or substituted with at least one R₁₀ₐ, a C₆-C₆₀ (*e.g*. C₆-C₃₀) arylthio group unsubstituted or substituted with at least one R₁₀ₐ, a C₇-C₆₀ (*e.g*. C₇-C₃₀) arylalkyl group unsubstituted or substituted with at least one R₁₀ₐ, a C₂-C₆₀ (*e.g*. C₂-C₃₀) heteroarylalkyl group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
n1 is an integer from 0 to 10,
n9 is an integer from 0 to 3,
R₁(s) in the number of n1 are identical to or different from each other, and R₉(s) in the number of n9 are identical to or different from each other,
two or more of R₁(s) in the number of n1 are optionally bonded to each other to form a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
R₄ and R₅ are optionally bonded to each other to form a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
two or more of R₉(s) in the number of n9 are optionally bonded to each other to form a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
R₁₀ₐ is:
   deuterium, -F, -Cl, -Br, -I, a hydroxyl group, a cyano group, or a nitro group;
   a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₁-C₆₀ (e.g. C₁-C₂₀) heteroaryloxy group, a C₁-C₆₀ (e.g. C₁-C₂₀) heteroarylthio group, a C₇-C₆₀ (e.g. C₇-C₃₀) arylalkyl group, a C₂-C₆₀ (e.g. C₂-C₃₀) heteroarylalkyl group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
   a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₁-C₆₀ (e.g. C₁-C₂₀) heteroaryloxy group, a C₁-C₆₀ (e.g. C₁-C₂₀) heteroarylthio group, a C₇-C₆₀ (e.g. C₇-C₃₀) arylalkyl group, or a C₂-C₆₀ (*e.g.* C₂-C₃₀) heteroarylalkyl group, each unsubstituted or substituted with deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (e.g. C₁-C₂₀) alkoxy group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryloxy group, a C₁-C₆₀ (*e.g.* C₁-C₂₀) heteroarylthio group, a C₇-C₆₀ (*e.g.* C₇-C₃₀) arylalkyl group, a C₂-C₆₀ (*e.g.* C₂-C₃₀) heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combinations thereof; or
      -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
   Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ (e.g. C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (e.g. C₁-C₂₀) alkoxy group, a C₁-C₆₀ (*e.g.* C₁-C₂₀) alkylthio group, a C₃-C₆₀ (e.g. C₃-C₃₀) carbocyclic group, a C₁-C₆₀ (e.g. C₁-C₂₀) heterocyclic group, a C₆-C₆₀ (*e.g.* C₆-C₃₀) aryloxy group, a C₆-C₆₀ (*e.g.* C₆-C₃₀) arylthio group, a C₇-C₆₀ (*e.g.* C₇-C₃₀) arylalkyl group, or a C₂-C₆₀ (*e.g.* C₂-C₃₀) heteroarylalkyl group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a phenyl group, a biphenyl group, a pyridinyl group, a pyrimidinyl group, a pyridazinyl group, a pyrazinyl group, a triazinyl group, or any combinations thereof, and
   * and *' each indicate a binding site to a neighboring (adjacent) atom.

In an embodiment, the first electrode may be an anode, and the second electrode may be a cathode. Here, the interlayer may further include a hole transport region disposed between the first electrode and the emission layer and an electron transport region disposed between the emission layer and the second electrode. The hole transport region may include a hole injection layer, a hole transport layer, an emission auxiliary layer, an electron blocking layer, or any combinations thereof, and the electron transport region may include a buffer layer, a hole blocking layer, an electron control layer, an electron transport layer, an electron injection layer, or any combinations thereof.

In an embodiment, the first electrode may be an anode, the second electrode may be a cathode, and the interlayer may further include a hole transport region disposed between the first electrode and the emission layer. Here, the hole transport region may include the first compound and the second compound.

In an embodiment, the hole transport region may include: a hole transport layer; and a plurality of emission auxiliary layers formed between the hole transport layer and the emission layer, where the plurality of emission auxiliary layers may include a first emission auxiliary layer next (adjacent) to the hole transport layer and a second emission auxiliary layer next (adjacent) to the emission layer. Here, the first emission auxiliary layer may include the first compound, and the second emission auxiliary layer may include the second compound.

The emission auxiliary layer is a layer that increases light emission efficiency by compensating for an optical resonance distance according to a wavelength of light emitted from the emission layer. The first emission auxiliary layer may mainly function to inject holes from the hole transport layer to the emission auxiliary layer and to transport the injected holes, and the second emission auxiliary layer may mainly function to inject holes from the emission auxiliary layer to a host and to block electrons.

Therefore, when the first emission auxiliary layer uses a material with relatively high hole mobility, transport of holes to the emission layer may be facilitated, thereby lowering a driving voltage of the device, and when the second emission auxiliary layer adjusts energy level differences (e.g., a highest occupied molecular orbital (HOMO) energy level, a lowest unoccupied molecular orbital (LUMO) energy level, and a triplet excited state (T1) energy level) with the emission layer, electrons delivered from the emission layer may be blocked, thereby improving luminescence efficiency and a lifespan of the device.

In an embodiment, the first compound may have a hole mobility in a range of about 5.1 X 10⁻⁵ centimeter per volt-second (cm/V•S) to about 5.1 X 10⁻³ cm/V•S or about 5.1 X 10⁻⁵ cm/V•S to about 1.5 X 10⁻³ cm/V•S. In an embodiment, the first compound may have a hole mobility in a range of about 1.6 X 10⁻⁴ cm/V•S to about 1.5 X 10⁻³ cm/V•S, for example.

In an embodiment, the second compound may have a T1 energy level in a range of about 2.0 electronvolts (eV) to about 3.0 eV, preferably, about 2.3 eV to about 3.0 eV. In an embodiment, the second compound may have a T1 energy level in a range of about 2.3 eV to about 2.7 eV, for example. When the T1 energy level of the second compound included in the second emission auxiliary layer is within the ranges above, triplet electrons moving from a dopant to the hole transport layer may be effectively blocked, thereby improving luminescence efficiency and a lifespan of the device.

In an embodiment, the second compound may have a HOMO energy level in a range of about -4.90 eV to about -5.30 eV, preferably, about -5.00 eV to about -5.20 eV. When the HOMO energy level of the second compound included in the second emission auxiliary layer is within the ranges above, the injection of holes from the second emission auxiliary layer to a host may be smoothly performed, thereby improving luminescence efficiency of the device.

In an embodiment, the second compound may have a LUMO energy level in a range of about -1.00 eV to about -1.70 eV, preferably, about -1.15 eV to about -1.55 eV. When the LUMO energy level of the second compound included in the second emission auxiliary layer is within the ranges above, electrons moving from a host to the hole transport layer may be effectively blocked, thereby improving a lifespan of the device.

In an embodiment, the first emission auxiliary layer may have a thickness in a range of about 25 angstroms (Å) to about 900 Å. In the case of a blue light-emitting device, the thickness of the first emission auxiliary layer may be in a range of about 25 Å to about 75 Å, preferably, about 25 Å to about 50 Å. In the case of a green light-emitting device, the thickness of the first emission auxiliary layer may be in a range of about 100 Å to about 450 Å, preferably, about 250 Å to about 450 Å. In the case of a red light-emitting device, the thickness of the first emission auxiliary layer may be in a range of about 500 Å to about 900 Å, preferably, about 650 Å to about 850 Å.

In an embodiment, the second emission auxiliary layer may have a thickness in a range of about 10 Å to about 300 Å. Preferably, the thickness of the second emission auxiliary layer may be in a range of about 20 Å to about 100 Å, e.g., about 25 Å to about 75 Å.

In an embodiment, the emission layer may emit red light.

The first compound is represented by Formula 1:

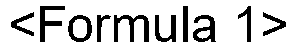

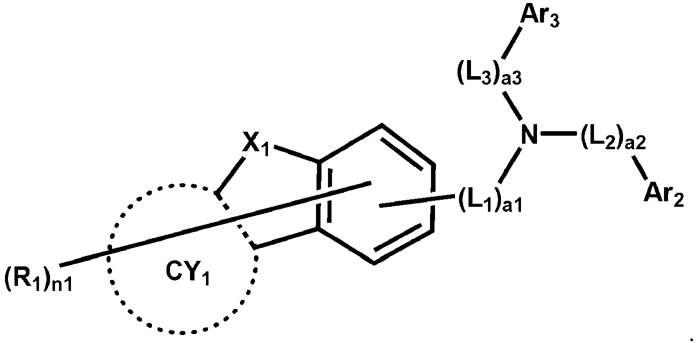

In Formula 1, CY₁ is a C₃-C₆₀ carbocyclic group or a C₁-C₆₀ heterocyclic group.

In an embodiment, CY₁ may be a benzene group. In an embodiment, the first compound may be represented by Formula 1-1, for example:

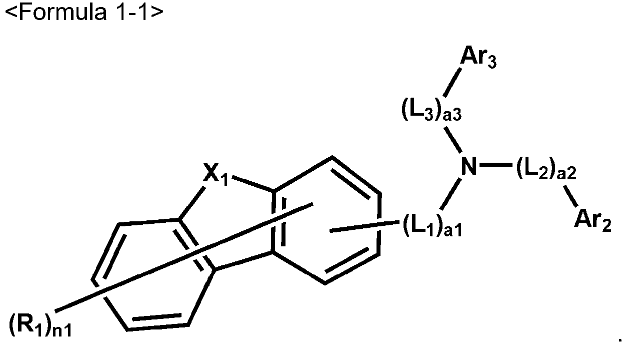

X₁, Ar₂, Ar₃, L₁ to L₃, a1 to a3, R₁, and n1 are the same as described elsewhere herein.

In Formula 1, X₁ is O, S, C(R₄)(R₅), Si(R₄)(R₅), N(R₄), or P(R₄).

In an embodiment, X₁ may be O, S, C(R₄)(R₅), or Si(R₄)(R₅).

In Formula 1, Ar₂ and Ar₃ are each independently a C₃-C₆₀ carbocyclic group unsubstituted or substituted with at least one R₁₀ₐ or a C₁-C₆₀ heterocyclic group unsubstituted or substituted with at least one R₁₀ₐ.

In an embodiment, Ar₂ and Ar₃ may each independently be a C₃-C₃₀ cycloalkyl group unsubstituted or substituted with at least one R₁₀ₐ, a C₃-C₃₀ cycloalkenyl group unsubstituted or substituted with at least one R₁₀ₐ, a C₆-C₃₀ aryl group unsubstituted or substituted with at least one R₁₀ₐ, a C₁-C₃₀ heteroaryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a monovalent non-aromatic condensed polycyclic group unsubstituted or substituted with at least one R₁₀ₐ, or a monovalent non-aromatic condensed heteropolycyclic group unsubstituted or substituted with at least one R₁₀ₐ.

In Formula 1, L₁ to L₃ are each independently a C₃-C₆₀ carbocyclic group unsubstituted or substituted with at least one R₁₀ₐ or a C₁-C₆₀ heterocyclic group unsubstituted or substituted with at least one R₁₀ₐ.

In an embodiment, L₁ to L₃ may each independently be a phenylene group unsubstituted or substituted with at least one R₁₀ₐ.

In Formula 1, a1 to a3 are each independently an integer from 0 to 3. When a1 is 0, *-(L₁)ₐ₁-*' is a single bond, when a2 is 0, *-(L₂)ₐ₂-*' is a single bond, and when a3 is 0, *-(L₃)ₐ₃-*' is a single bond. Here, L₁(s) in the number of a1 are identical to or different from each other, L₂(s) in the number of a2 are identical to or different from each other, and L₃(s) in the number of a3 are identical to or different from each other.

In Formula 1, R₁, R₄, and R₅ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and n1 is an integer from 0 to 10. Here, R₁(s) in the number of n1 are identical to or different from each other.

At least two of R₁(s) in the number of n1 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

R₄ and R₅ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof.

In an embodiment, the first compound may satisfy one of Conditions 1 to 3:
<Condition 1>
   at least two of R₁(s) in the number n1 are bonded to each other to form a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ;
<Condition 2>
   at least one of R₁(s) in the number of n1 is not hydrogen; and
<Condition 3>
   X₁ is C(R₄)(R₅) or Si(R₄)(R₅), and
   at least one of Ar₂ and Ar₃ is a C₃-C₆₀ (e.g. C₃-C₃₀) cycloalkyl group unsubstituted or substituted with at least one R₁₀ₐ.

In an embodiment, at least two of R₁(s) in the number of n1 in Formula 1 (or Formula 1-1) may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ. The first compound may be represented by one of Formulae 1-11 to 1-14:

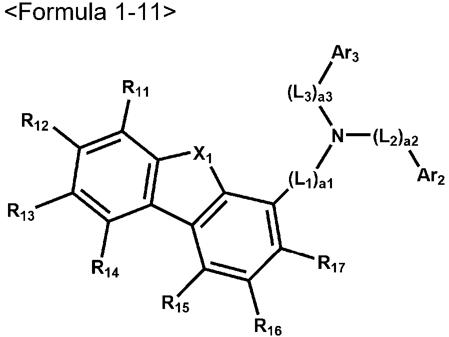

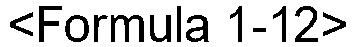

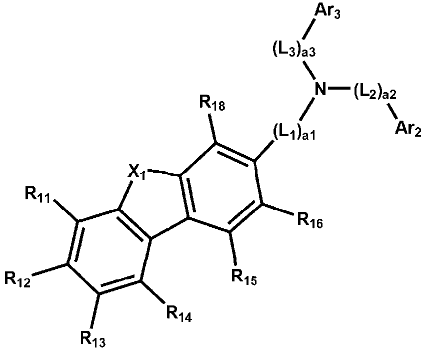

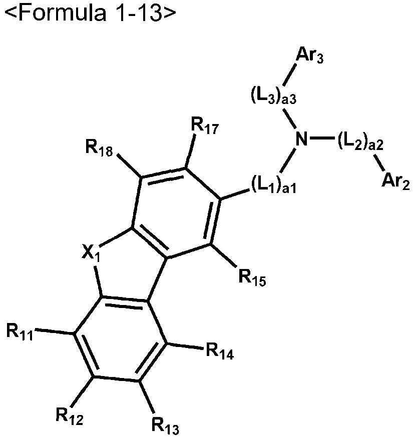

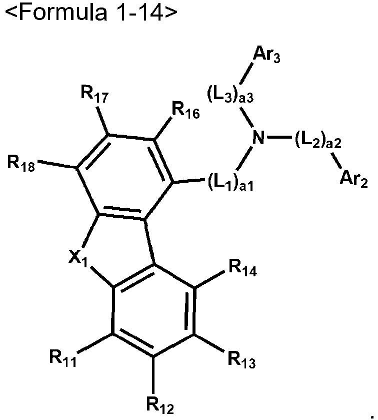

In Formulae 1-11 to 1-14,
X₁, Ar₂, Ar₃, L₁ to L₃, and a1 to a3 are the same as described elsewhere herein.

R₁₁ to R₁₈ are the same as described in connection with R₁, and at least two of R₁₁ to R₁₈ may be bonded to each other to form a C₃-C₆₀ (e.g. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ.

In an embodiment, the first compound may be represented by one of Formulae 1-11A to 1-11F, 1-12A to 1-12E, 1-13A to 1-13E, and 1-14A to 1-14F:

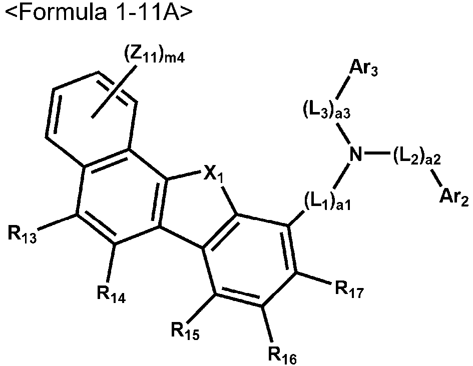

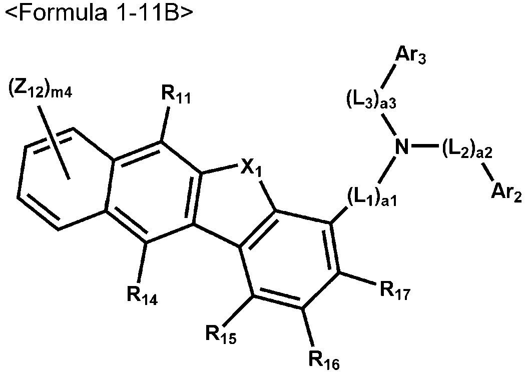

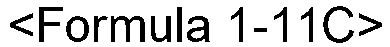

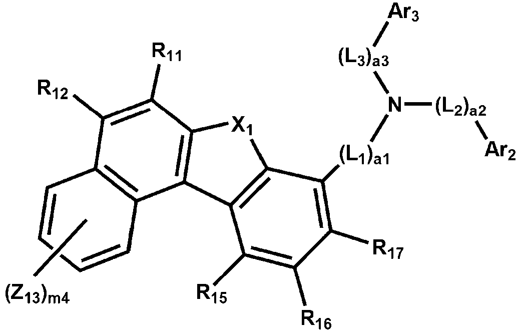

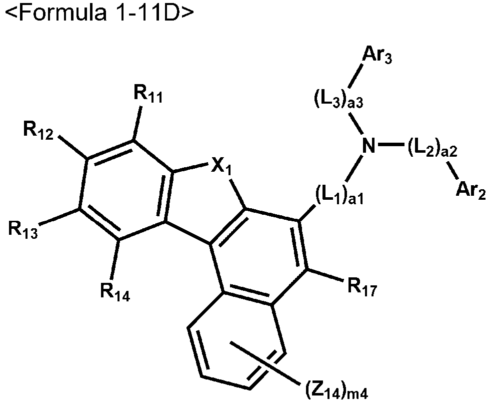

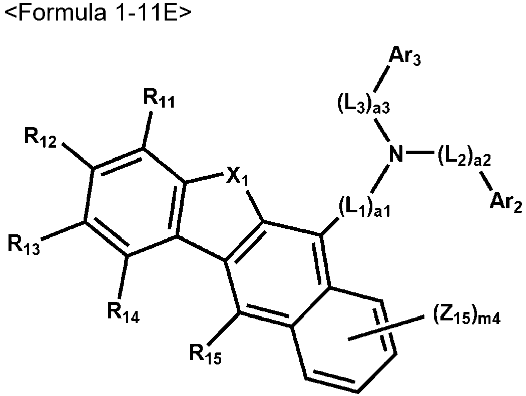

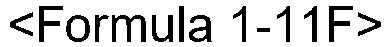

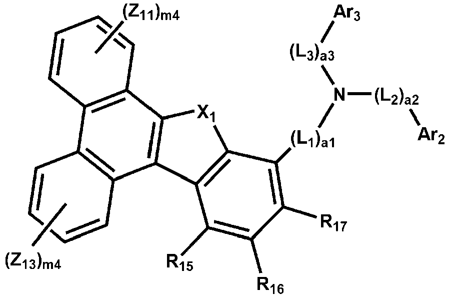

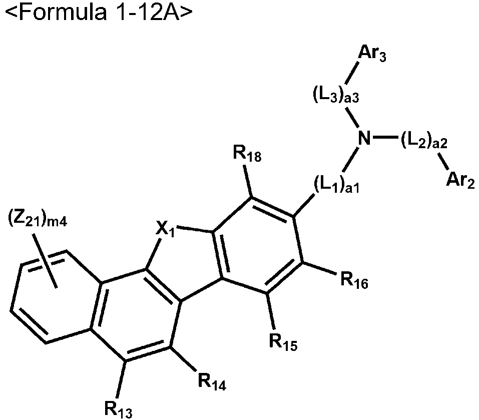

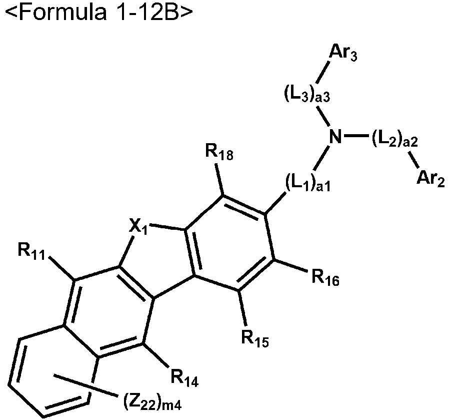

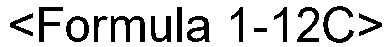

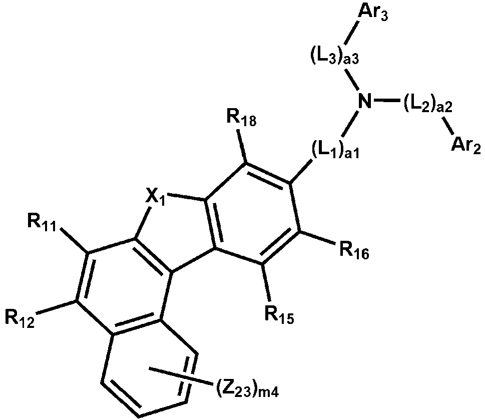

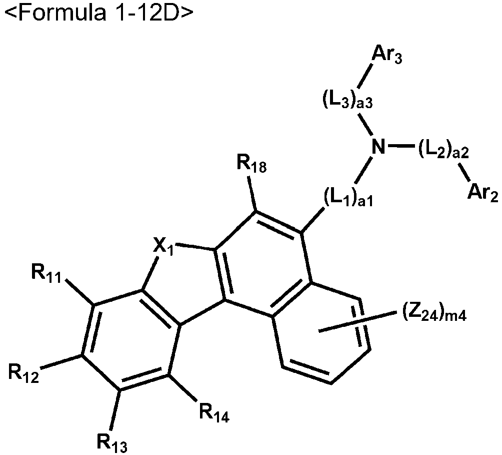

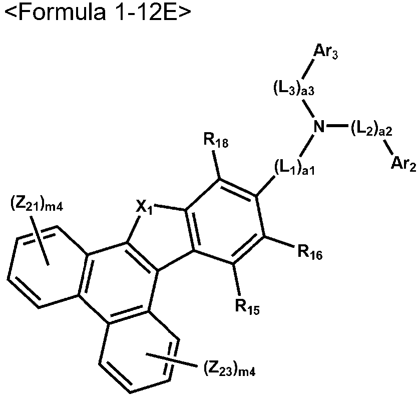

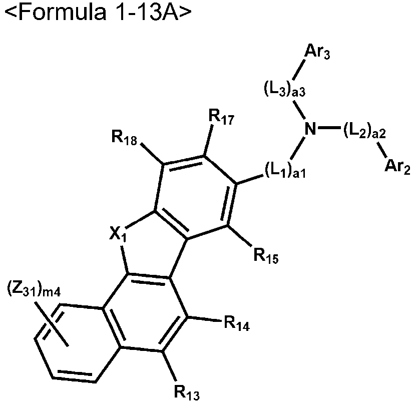

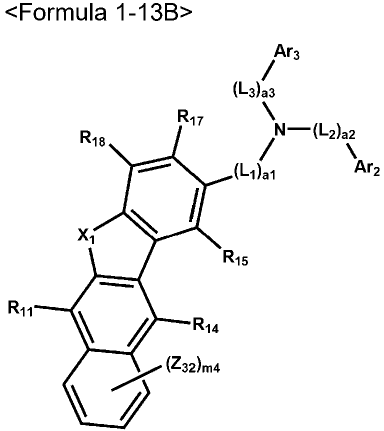

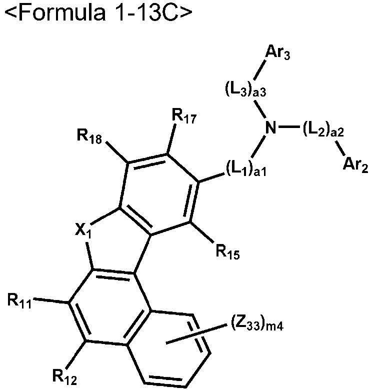

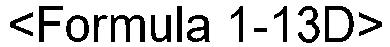

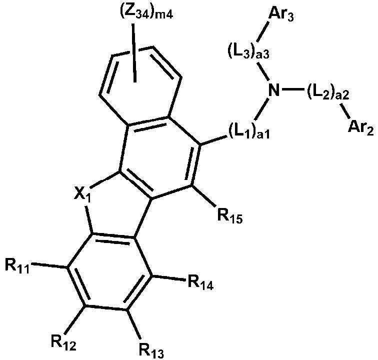

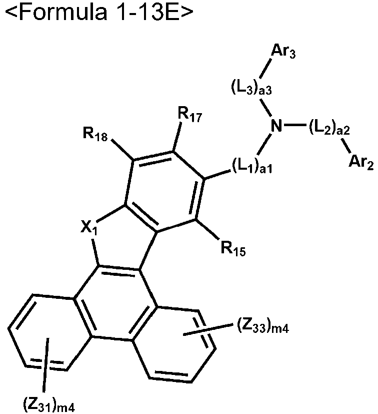

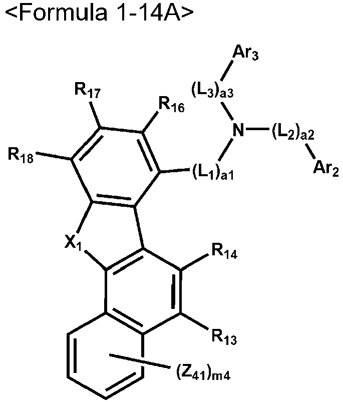

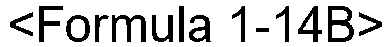

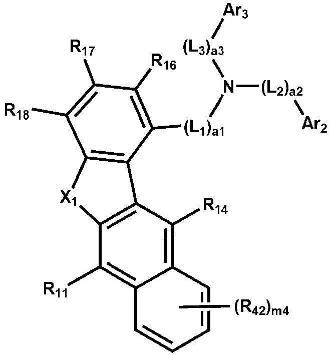

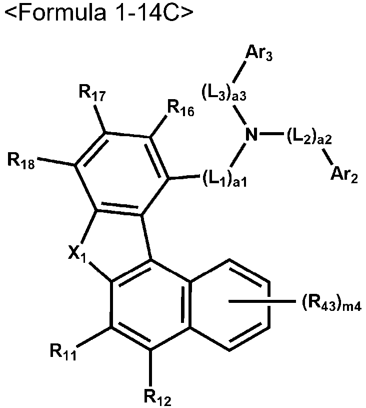

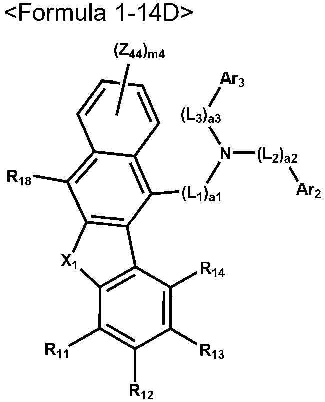

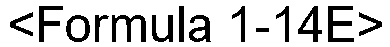

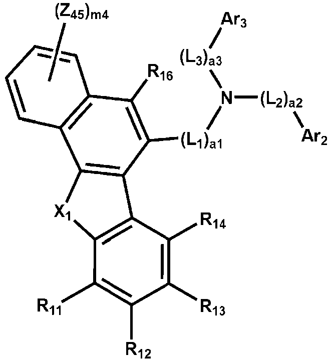

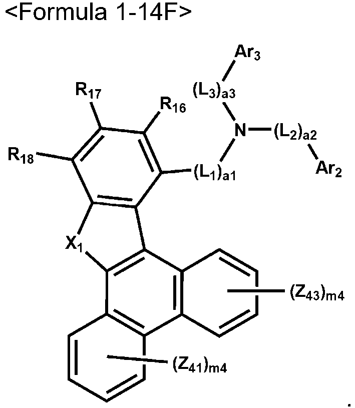

In Formulae 1-11A to 1-11F, 1-12A to 1-12E, 1-13A to 1-13E, and 1-14A to 1-14F,
X₁, Ar₂, Ar₃, L₁ to L₃, and a1 to a3 are the same as described elsewhere herein,
R₁₁ to R₁₈ are each the same as described in connection with R₁,
Z₁₁ to Z₁₅, Z₂₁ to Z₂₄, Z₃₁ to Z₃₄, and Z₄₁ to Z₄₅ are the same as described in connection with R₁₀ₐ, and
m4 is an integer from 0 to 4.

In another embodiment, in Formula 1 (or Formula 1-1), at least one of R₁(s) in the number of n1 may not be hydrogen. In an embodiment, at least one of R₁(s) in the number of n1 may be a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₃-C₃₀ cycloalkyl group unsubstituted or substituted with at least one R₁₀ₐ, a C₃-C₃₀ cycloalkenyl group unsubstituted or substituted with at least one R₁₀ₐ, a C₆-C₃₀ aryl group unsubstituted or substituted with at least one R₁₀ₐ, or a C₁-C₃₀ heteroaryl group unsubstituted or substituted with at least one R₁₀ₐ, for example.

In another embodiment, the first compound may be represented by one of Formulae 1-31 to 1-34:

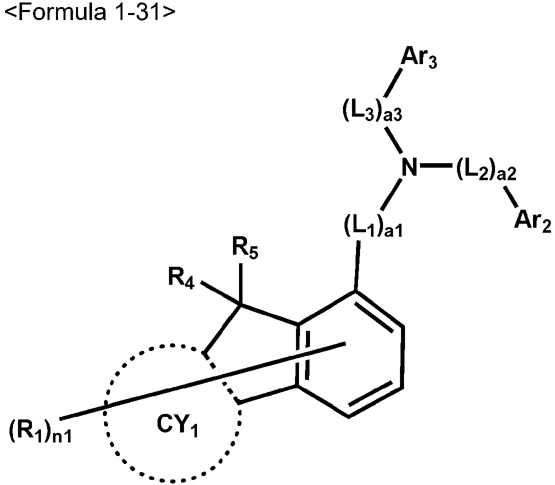

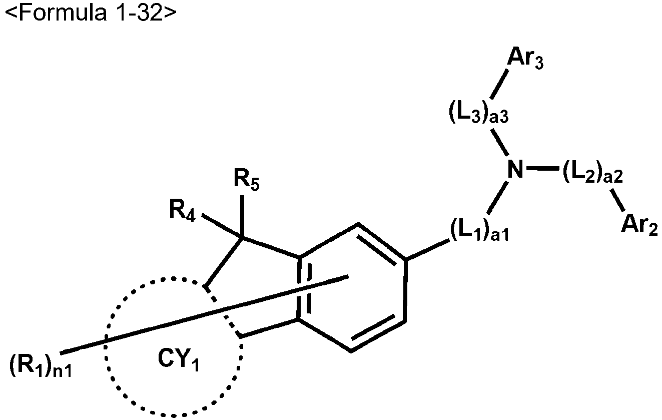

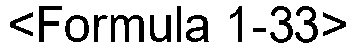

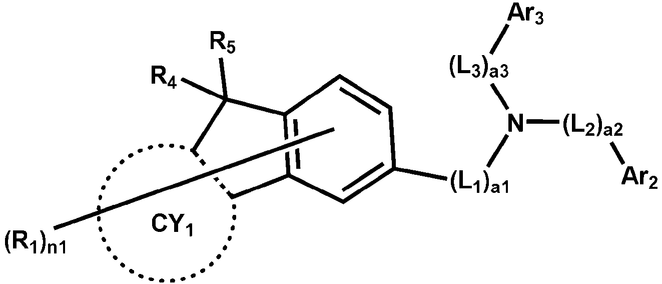

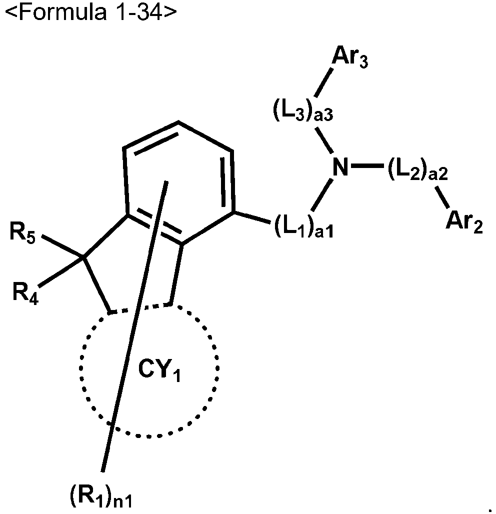

In Formulae 1-31 to 1-34,
CY₁, Ar₂, Ar₃, L₁ to L₃, a1 to a3, R₁, R₄, R₅, and n1 are the same as described elsewhere herein, provided that
at least one of Ar₂ and Ar₃ is a C₃-C₃₀ (e.g. C₃-C₂₀) cycloalkyl group unsubstituted or substituted with at least one R₁₀ₐ.

In an embodiment, in Formulae 1-31 to 1-34, at least one of Ar₂ and Ar₃ may be a group represented by one of Formulae Ar-1 to Ar-7: 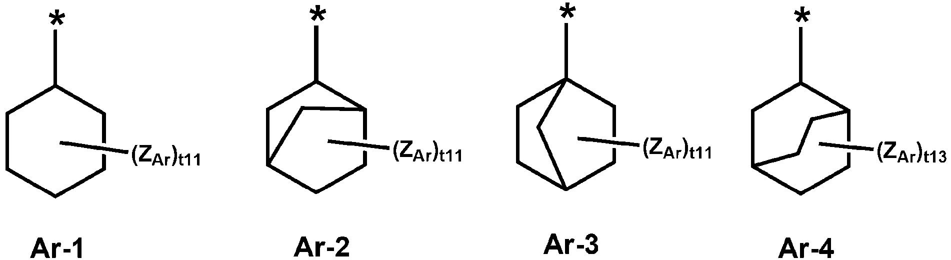 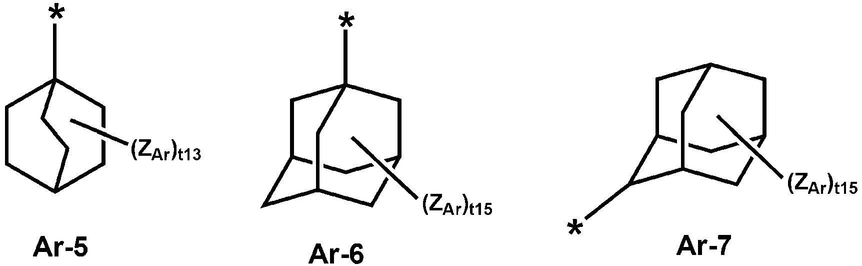 In Formulae Ar-1 to Ar-7,
Z_{Ar} is the same as described in connection with R₁₀ₐ,
t11 is an integer from 0 to 11,
t13 is an integer from 0 to 13,
t15 is an integer from 0 to 15, and
* indicates a binding site to a neighboring atom.

In an embodiment, the first compound may be one of Compounds P1-1 to P1-92:

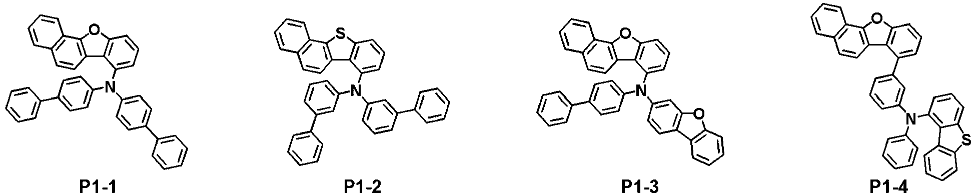

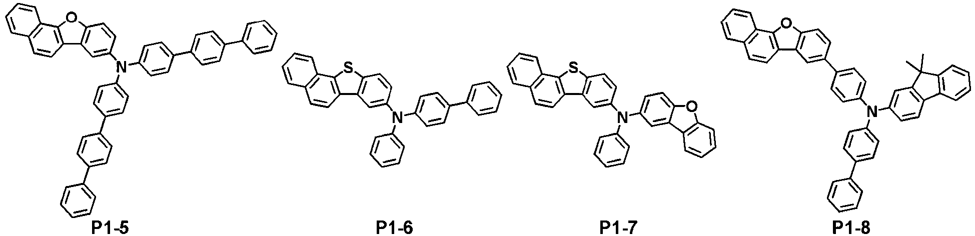

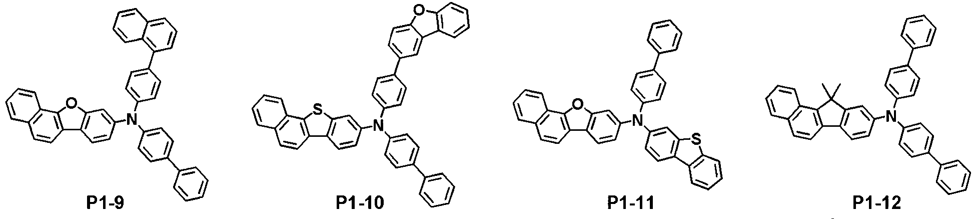

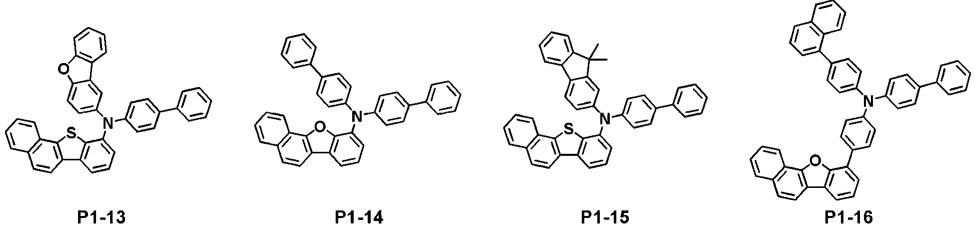

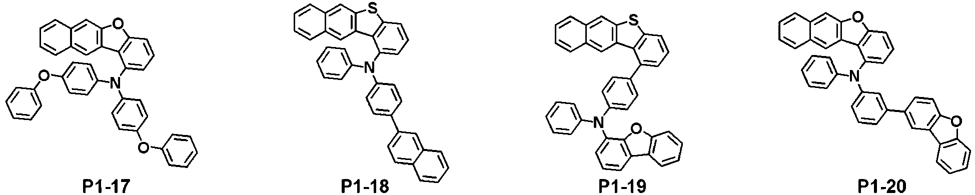

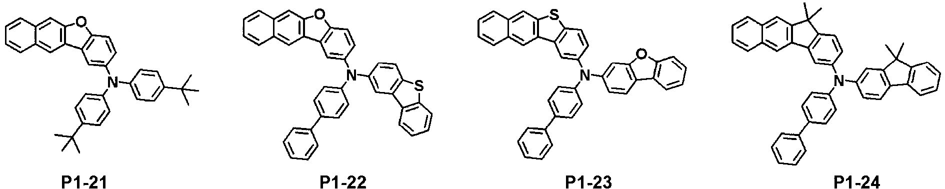

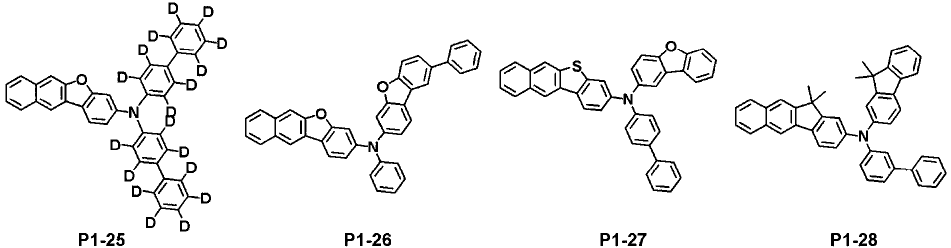

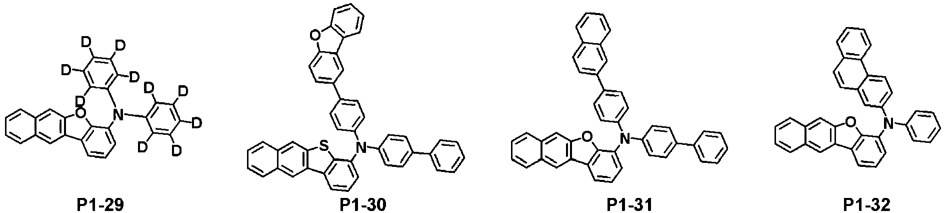

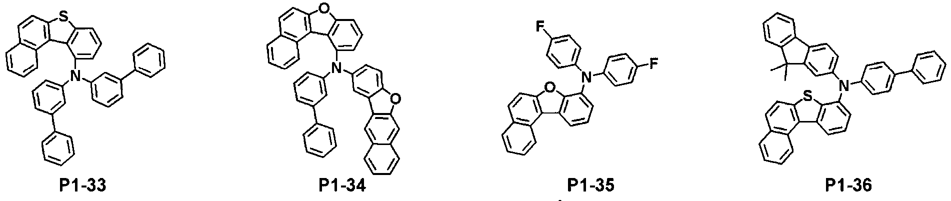

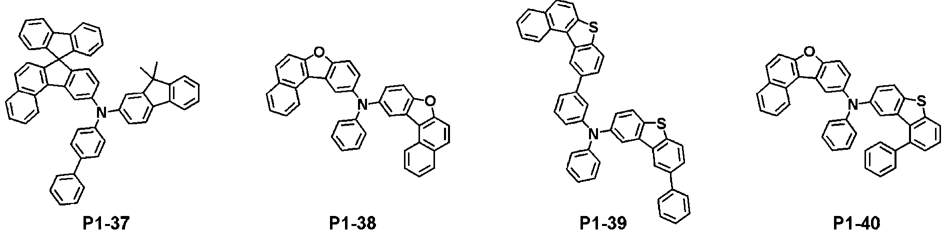

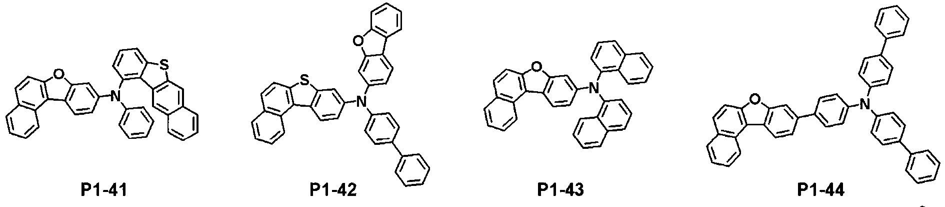

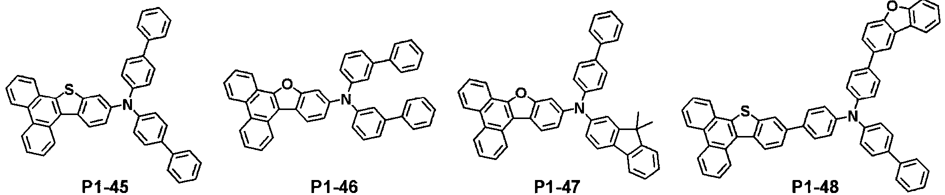

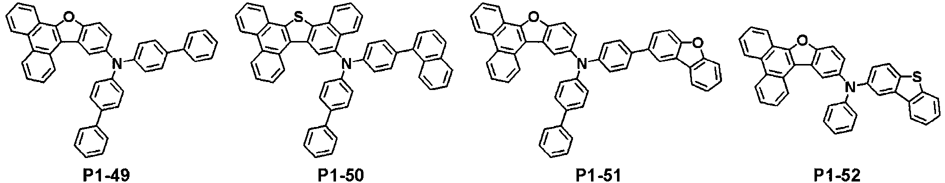

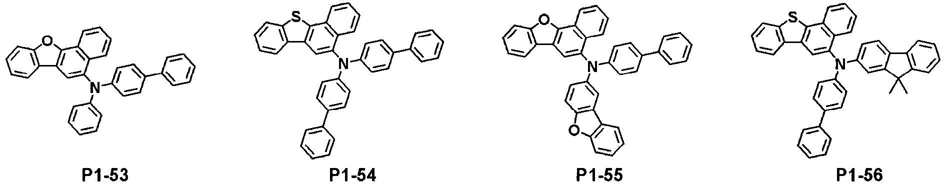

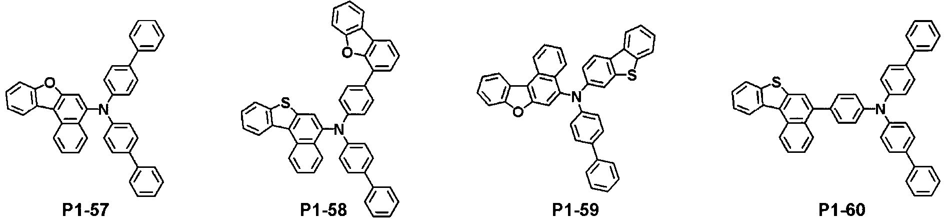

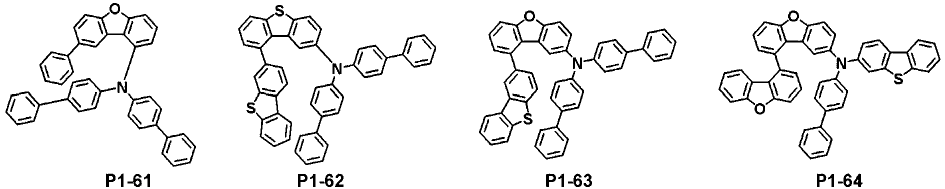

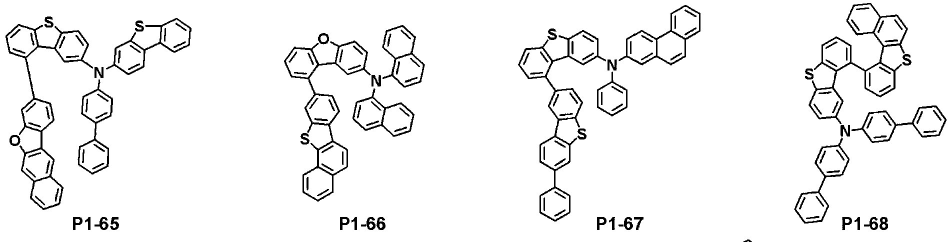

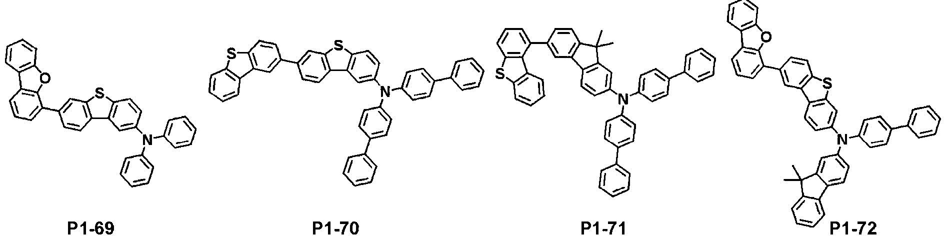

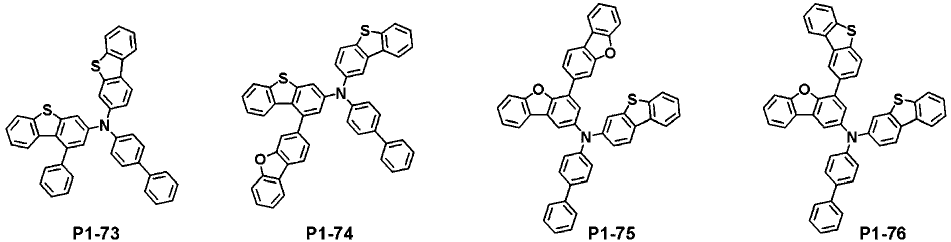

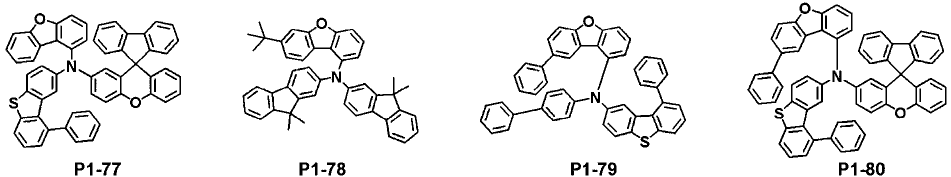

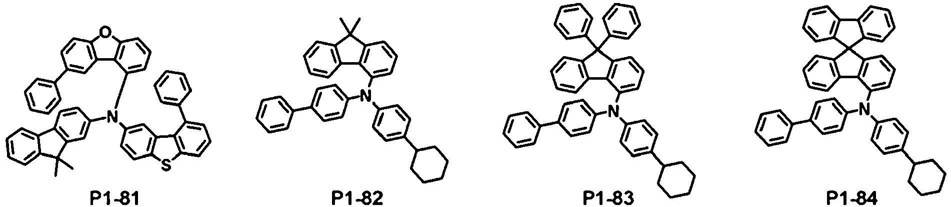

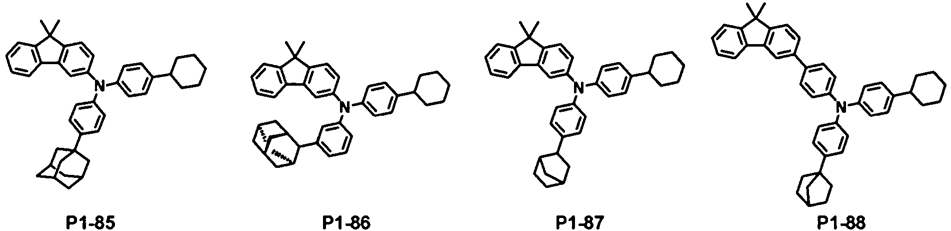

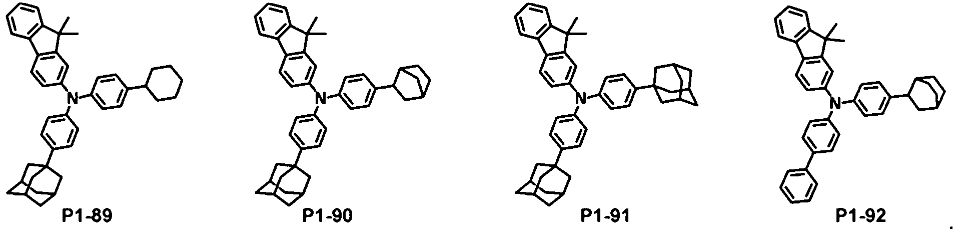

The second compound is represented by Formula 2:

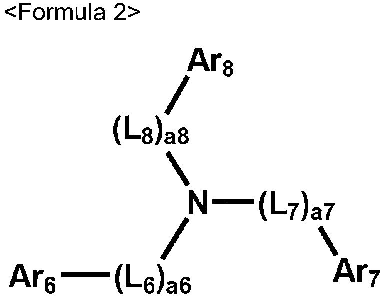

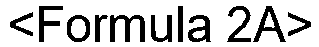

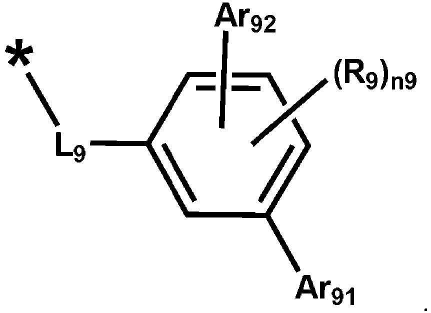

In Formula 2, Ar₆ to Ar₈ are each independently a group represented by Formula 2A, a C₃-C₆₀ carbocyclic group unsubstituted or substituted with at least one R₁₀ₐ, or a C₁-C₆₀ heterocyclic group unsubstituted or substituted with at least one R₁₀ₐ, provided that at least one of Ar₆ to Ar₈ is the group represented by Formula 2A.

In an embodiment, Ar₆ to Ar₈ may each independently be the group represented by Formula 2A, a benzene group unsubstituted or substituted with at least one R₁₀ₐ, a naphthalene group unsubstituted or substituted with at least one R₁₀ₐ, an anthracene group unsubstituted or substituted with at least one R₁₀ₐ, a phenanthrene group unsubstituted or substituted with at least one R₁₀ₐ, a triphenylene group unsubstituted or substituted with at least one R₁₀ₐ, or a fluorene group unsubstituted or substituted with at least one R₁₀ₐ.

In Formula 2A, Ar₉, and Ar₉₂ are each independently a C₃-C₆₀ carbocyclic group unsubstituted or substituted with at least one R₁₀ₐ or a C₁-C₆₀ heterocyclic group unsubstituted or substituted with at least one R₁₀ₐ.

In an embodiment, Ar₉₁ and Ar₉₂ may each independently be a benzene group unsubstituted or substituted with at least one R₁₀ₐ, a naphthalene group unsubstituted or substituted with at least one R₁₀ₐ, an anthracene group unsubstituted or substituted with at least one R₁₀ₐ, a phenanthrene group unsubstituted or substituted with at least one R₁₀ₐ, or a fluorene group unsubstituted or substituted with at least one R₁₀ₐ.

In Formulae 2 and 2A, L₆ to L₉ are each independently a C₃-C₆₀carbocyclic group unsubstituted or substituted with at least one R₁₀ₐ or a C₁-C₆₀ heterocyclic group unsubstituted or substituted with at least one R₁₀ₐ.

In an embodiment, L₆ to L₉ may each independently be a group represented by one of Formulae L-1 to L-13:

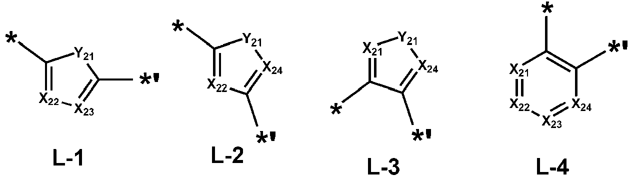

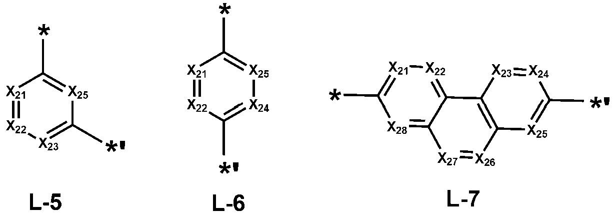

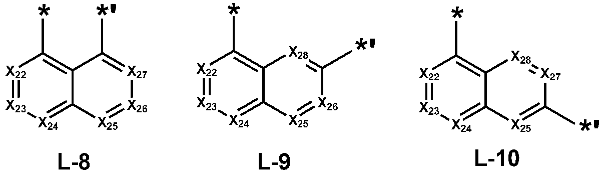

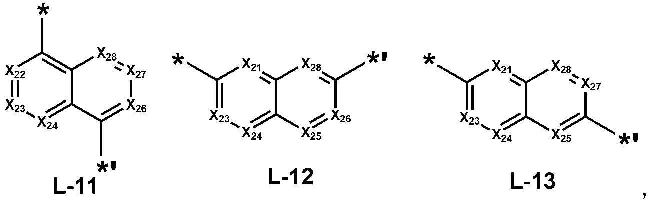

in Formulae L-1 to L-13,
Y₂₁ is O or S,
X₂₁ to X₂₈ are each independently N or C(Z_{L}),
Z_{L} is the same as described in connection with R₁₀ₐ, and
* and *' each indicate a binding site to a neighboring (adjacent) atom.

In Formula 2, a6 to a8 are each independently an integer from 0 to 3. When a6 is 0, *-(L₆)ₐ₆-*' is a single bond, when a7 is 0, *-(L₇)ₐ₇-*' is a single bond, and when a8 is 0, *-(L₈)ₐ₈-*' is a single bond. Here, L₆(s) in the number of a6 are identical to or different from each other, L₇(s) in the number of a7 are identical to or different from each other, and L₃(s) in the number of a8 are identical to or different from each other.

In Formula 2A, R₉ is hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), **or** -P(=O)(Q₁)(Q₂), and n9 is an integer from 0 to 3. Here, R₉(s) in the number of n9 are identical to or different from each other.

At least two of R₉(s) in the number of n9 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In an embodiment, the group represented by Formula 2A may be represented by one of Formulae 2A-1 to 2A-3, preferably, Formula 2A-1:

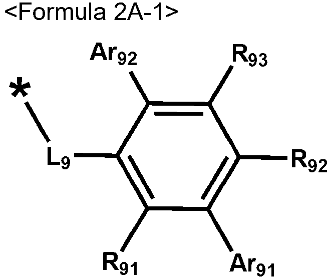

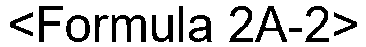

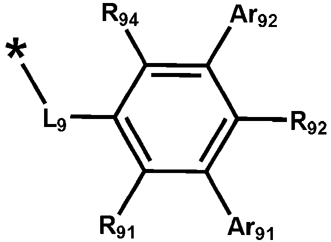

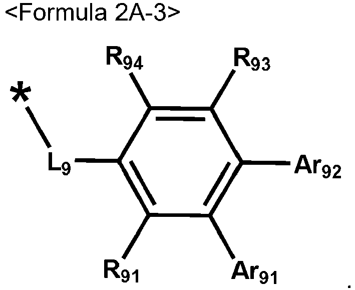

**In** Formulae 2A-1 to 2A-3,
Ar₉₁, Ar₉₂, and L₉ are the same as described elsewhere herein,
R₉₁ to R₉₄ are each the same as described in connection with R₉, and
* indicates a binding site to a neighboring atom.

R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof.

In an embodiment, the second compound may be selected from Compounds P2-1 to P2-51:

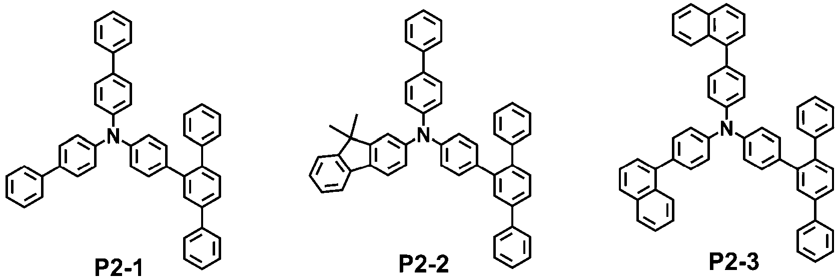

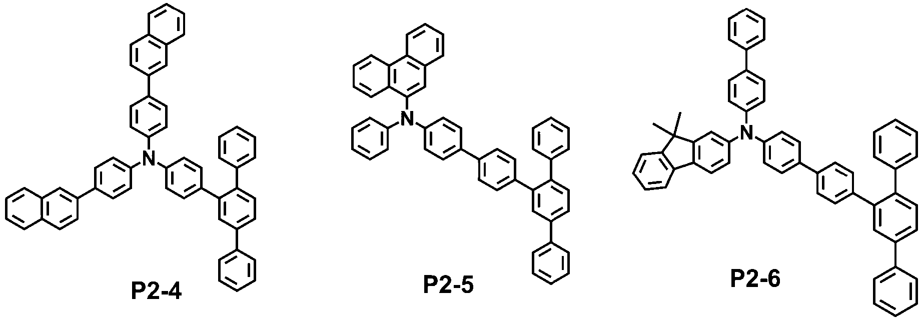

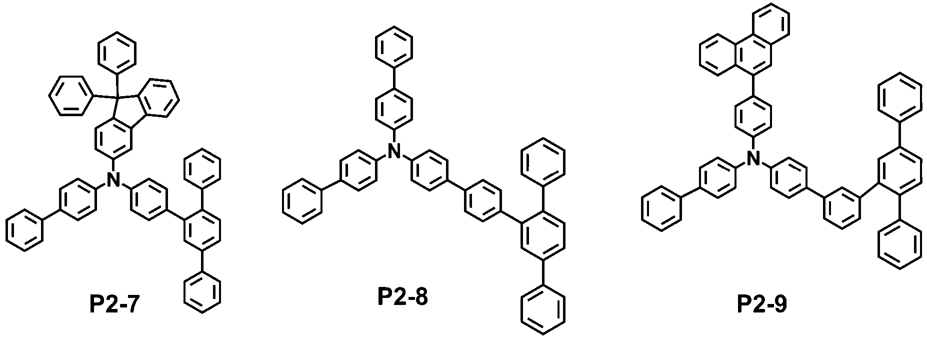

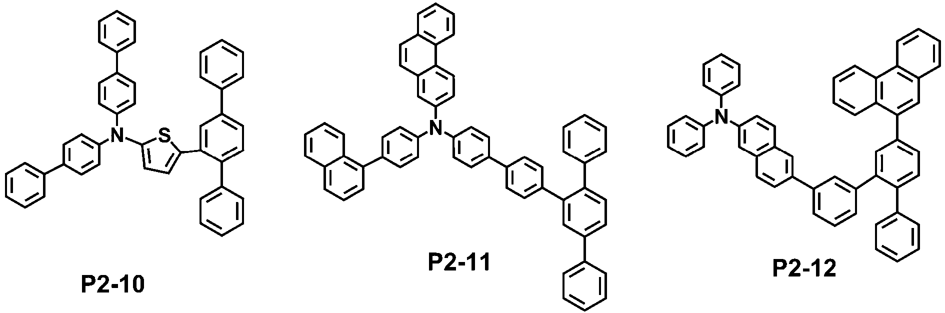

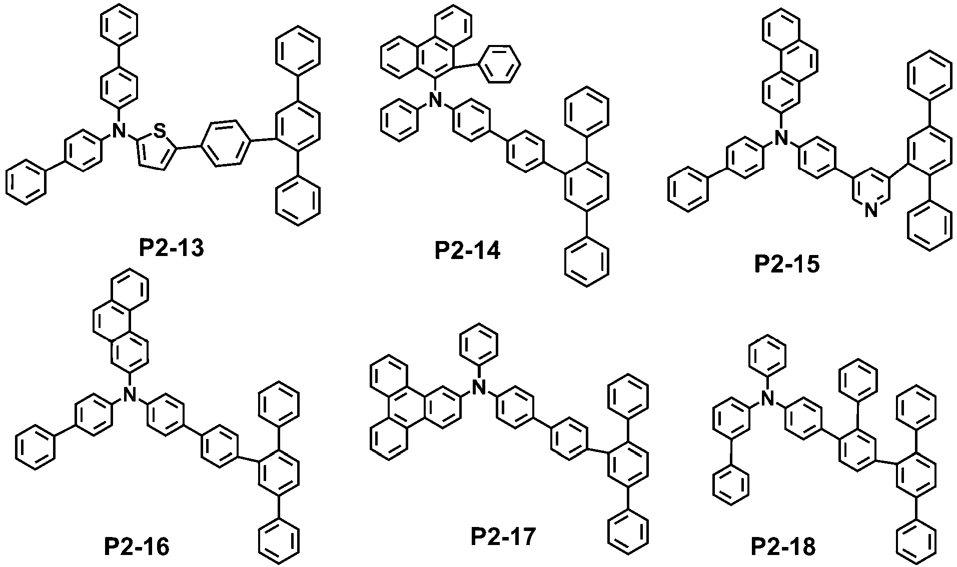

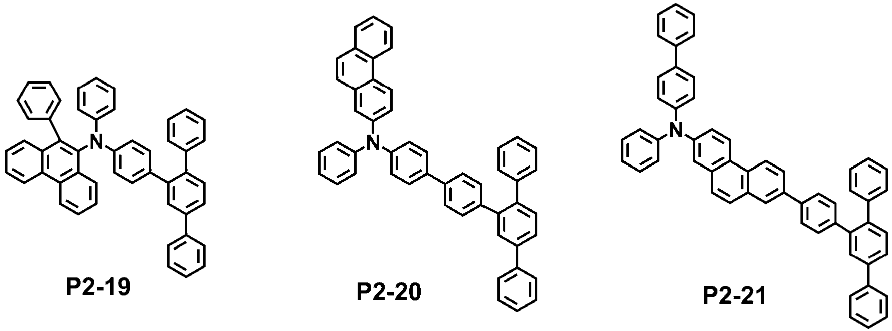

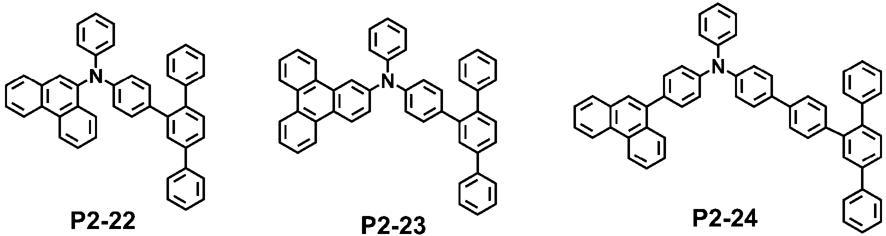

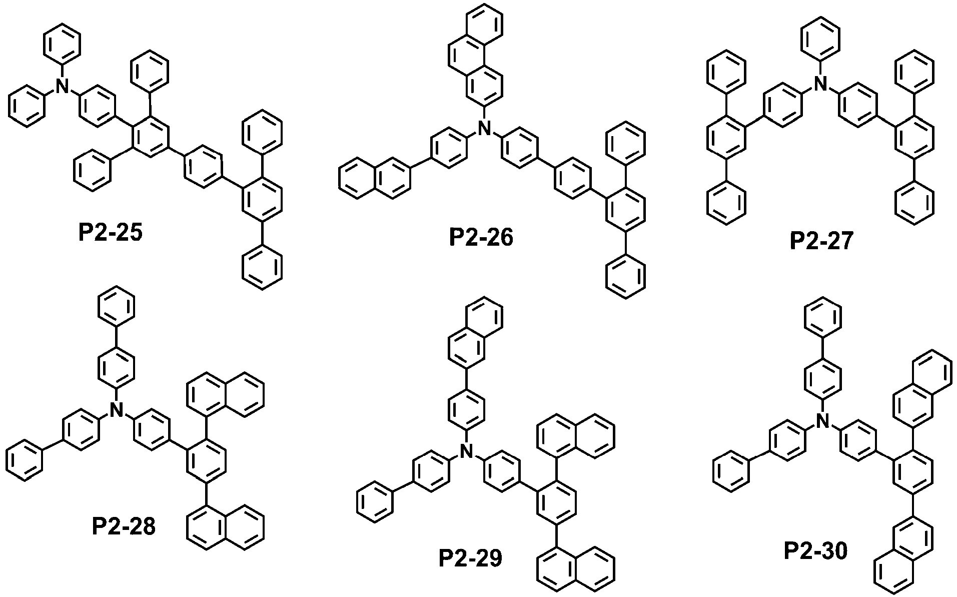

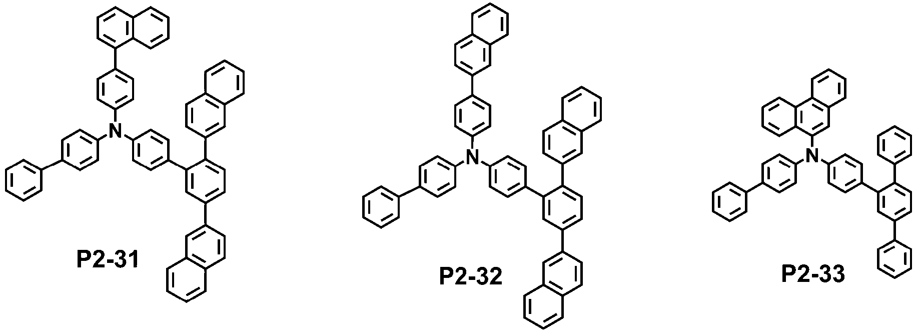

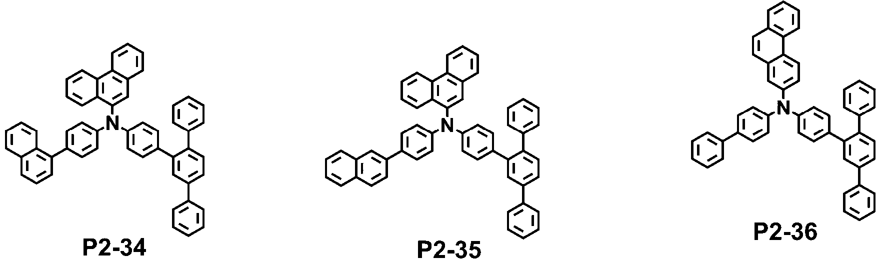

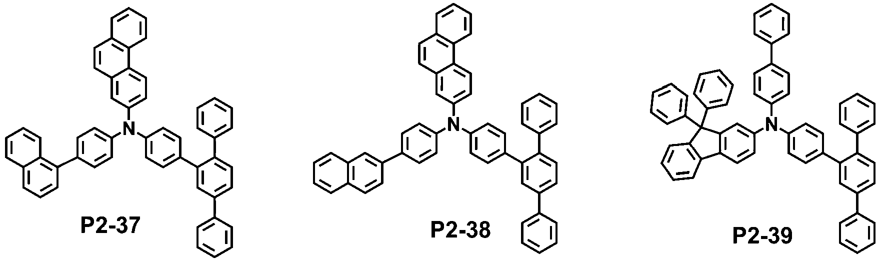

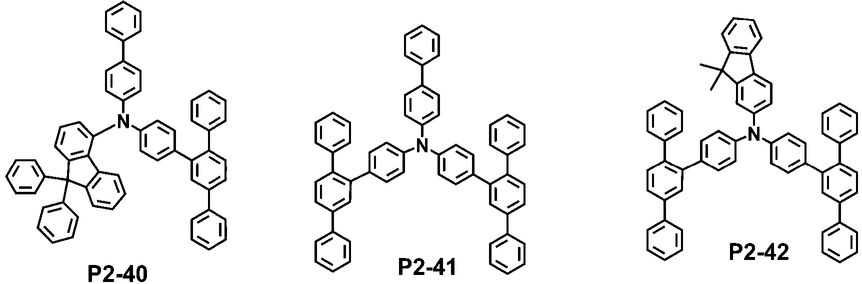

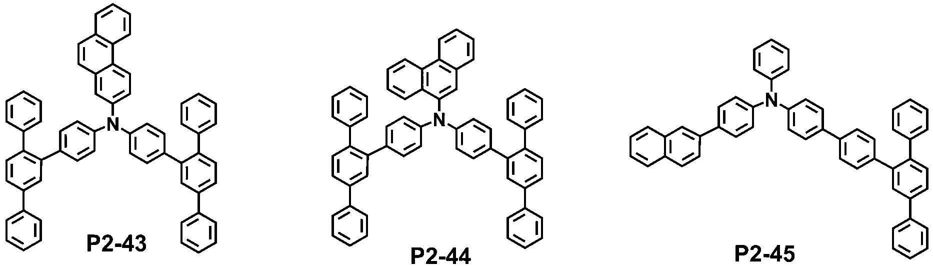

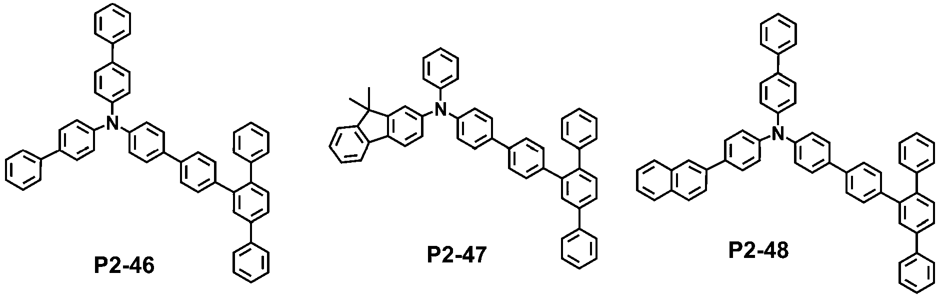

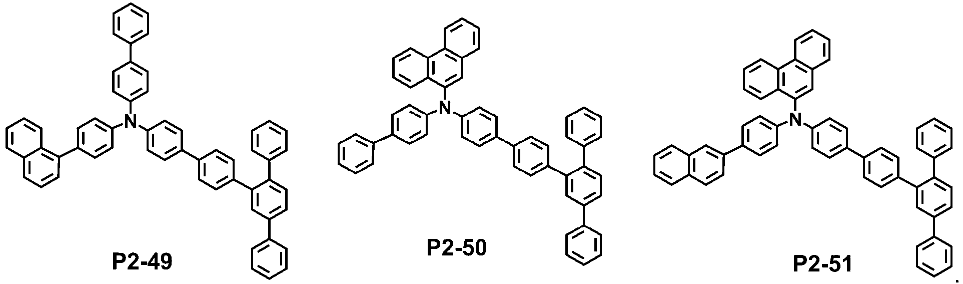

The first compound represented by Formula 1 may have relatively high hole mobility. Therefore, as the first emission auxiliary layer may include the first compound, the light-emitting device having relatively low driving voltage characteristics may be implemented.

The second compound represented by Formula 2 has a relatively low HOMO energy level, and thus as the second emission auxiliary layer may include the second compound, the injection of holes from the emission auxiliary layer to a host may be facilitated. Accordingly, the light-emitting device having relatively high luminescence efficiency characteristics may be implemented.

In addition, the second compound represented by Formula 2 has a relatively high LUMO energy level, and thus as the second emission auxiliary layer may include the second compound, electrons injected from a host to the emission auxiliary layer may be effectively blocked. Accordingly, the light-emitting device having long lifespan characteristics may be implemented.

In addition, the second compound represented by Formula 2 has a relatively high triplet excited state (T1) energy level, and thus triplet electrons injected from a dopant to the emission auxiliary layer may be effectively blocked. Accordingly, the light-emitting device having relatively high luminescence efficiency and long lifespan characteristics may be implemented.

Another embodiment of the disclosure provides electronic apparatus including the light-emitting device. The electronic apparatus may further include a thin-film transistor. In an embodiment, the electronic apparatus may further include a thin-film transistor including a source electrode and a drain electrode, where the first electrode of the light-emitting device may be electrically connected to the source electrode or the drain electrode, for example. In an embodiment, the electronic apparatus may further include a color filter, a color conversion layer, a touch screen layer, a polarizing layer, or any combinations thereof. More details on the electronic apparatus may be referred to the descriptions provided herein.

Another embodiment of the disclosure provides electronic equipment including the light-emitting device. In an embodiment, the electronic equipment may be one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant ("PDA"), a wearable device, a laptop computer, a digital camera, a camcorder, a viewfinder, a micro display, a three-dimensional ("3D") display, a virtual reality display, an augmented reality display, a vehicle, a video wall with multiple displays tiled together, a theater screen, a stadium screen, a phototherapy device, and a signboard, for example. More details on the electronic equipment may be the same as described herein.

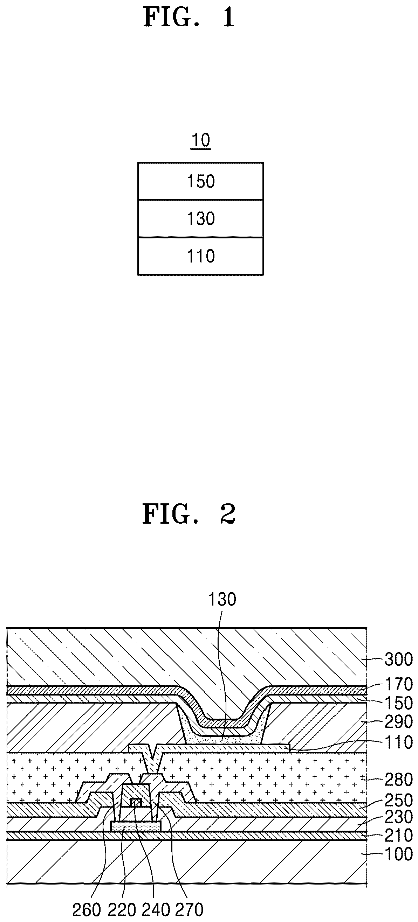

FIG. 1 is a schematic cross-sectional view of an embodiment of a light-emitting device 10. The light-emitting device 10 includes a first electrode 110, an interlayer 130, and a second electrode 150.

Hereinafter, a structure of the light-emitting device 10 in an embodiment and a method of manufacturing the light-emitting device 10 are described with reference to FIG. 1.

In FIG. 1, a substrate may be additionally disposed under the first electrode 110 or on the second electrode 150. As the substrate, a glass substrate or a plastic substrate may be used. In an embodiment, the substrate may be a flexible substrate and may include plastics with excellent heat resistance and durability, such as polyimide, polyethylene terephthalate ("PET"), polycarbonate, polyethylene naphthalate, polyarylate ("PAR"), polyetherimide, or any combinations thereof.

The first electrode 110 may be formed by depositing or sputtering a material for forming the first electrode 110 on the substrate, for example. When the first electrode 110 is an anode, a material for forming the first electrode 110 may be a high-work function material that facilitates injection of holes.

The first electrode 110 may be a reflective electrode, a transflective electrode, or a transmissive electrode. When the first electrode 110 is a transmissive electrode, a material for forming the first electrode 110 may include indium tin oxide ("ITO"), indium zinc oxide ("IZO"), tin oxide (SnO₂), zinc oxide (ZnO), or any combinations thereof. In an embodiment, when the first electrode 110 is a transflective electrode or a reflective electrode, a material for forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combinations thereof.

The first electrode 110 may have a single-layer structure consisting of a single layer or a multilayer structure including a plurality of layers. In an embodiment, the first electrode 110 may have a three-layer structure of ITO/Ag/ITO.

The interlayer 130 is disposed above the first electrode 110. The interlayer 130 includes the emission layer.

The interlayer 130 may further include a hole transport region disposed between the first electrode 110 and the emission layer, and an electron transport region disposed between the emission layer and the second electrode 150.

The interlayer 130 may further include, in addition to various organic materials, a metal-containing compound such as an organometallic compound, an inorganic material such as quantum dots, or the like.

In an embodiment, the interlayer 130 may include, i) two or more emitting units sequentially stacked between the first electrode 110 and the second electrode 150, and ii) a charge generation layer between emitting units next (adjacent) to each other among the two or more emitting units. When the interlayer 130 includes emitting units and a charge generation layer as described above, the light-emitting device 10 may be a tandem light-emitting device.

The hole transport region may have: i) a single-layer structure consisting of a single layer consisting of a single material, ii) a single-layer structure consisting of a single layer including a plurality of materials that are different from each other, or iii) a multilayer structure including a plurality of layers including a plurality of materials that are different from each other.

The hole transport region may include a hole injection layer, a hole transport layer, an emission auxiliary layer, an electron blocking layer, or any combinations thereof. In an embodiment, the emission auxiliary layer may have a multilayer structure including multiple layers. In an embodiment, the emission auxiliary layer may include a first emission auxiliary layer next (adjacent) to the hole transport layer and a second emission auxiliary layer next (adjacent) to the emission layer, for example.

In an embodiment, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, where layers in each structure are sequentially stacked from the first electrode 110, for example.

The hole transport region may include a compound represented by Formula 201, a compound represented by Formula 202, or any combinations thereof: 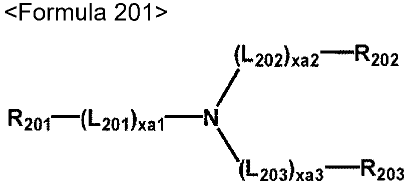 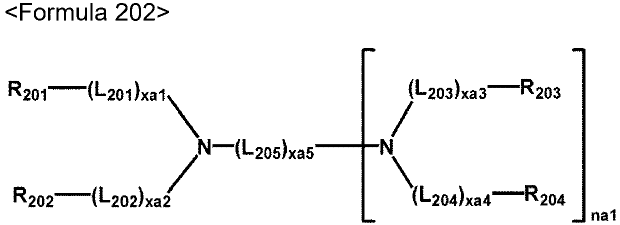 where, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group (e.g., a carbazole group) that is unsubstituted or substituted with at least one R₁₀ₐ (e.g., Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In an embodiment, each of Formulae 201 and 202 may include at least one of groups represented by Formulae CY201 to CY217: 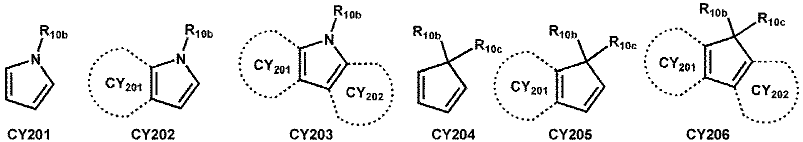 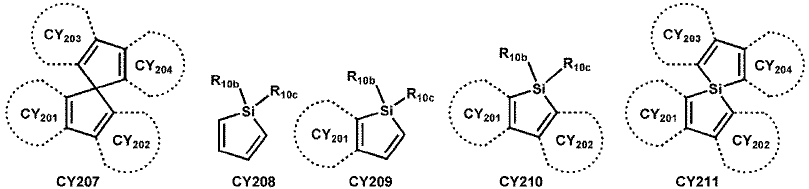 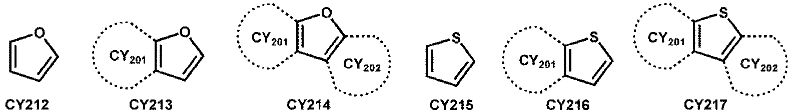 where, in Formulae CY201 to CY217, R_{10b} and R_{10c} are each the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, in Formulae CY201 to CY217, ring CY₂₀₁ to ring CY₂₀₄ may each independently be a benzene group, a naphthalene group, a phenanthrene group, or an anthracene group.

In an embodiment, each of Formulae 201 and 202 may include at least one of groups represented by Formulae CY201 to CY203.

In an embodiment, Formula 201 may include at least one of groups represented by Formulae CY201 to CY203 and at least one of groups represented by Formulae CY204 to CY217.

In another embodiment, in Formula 201, xa1 may be 1, R₂₀₁ may be a group represented by one of Formulae CY201 to CY203, xa2 may be 0, and R₂₀₂ may be a group represented by one of Formulae CY204 to CY207.

In another embodiment, each of Formulae 201 and 202 may not include groups represented by Formulae CY201 to CY203.

In another embodiment, each of Formulae 201 and 202 may not include groups represented by Formulae CY201 to CY203 and may include at least one of groups represented by Formulae CY204 to CY217.

In another embodiment, each of Formulae 201 and 202 may not include groups represented by Formulae CY201 to CY217.

In an embodiment, the hole transport region may include one of Compounds HT1 to HT46, 4,4',4"-tris[(3-methylphenyl)phenylamino]triphenylamine ("m-MTDATA"), Tris(4-(9H-carbazol-9-yl)phenyl)amine ("TDATA"), 2,2',2"-(1,3,5-Benzinetriyl)-tris(1-phenyl-1H-benzimidazole-4-amine) ("2-TNATA"), N,N'-Di(1-naphthyl)-N,N'-diphenylbenzidine ("NPB" or "NPD"), N,N'-Bis(β-naphthyl)-N,N'-diphenylbenzidine ("β-NPB"), N,N'-Bis(3-methylphenyl)-N,N'-diphenylbenzidine ("TPD"), 2,2',7,7'-Tetrakis(N,N-diphenylamino)-9,9'-spirobifluorene ("Spiro-TPD"), 2,2',7,7'-Tetrakis(N-(naphthalen-1-yl)-N-phenylamino)-9,9'-spirobifluorene ("Spiro-NPB"), N,N'-Bis(1-naphthyl)-N,N'-bis(4-methylphenyl)benzidine ("methylated NPB"), 1,1-Bis[4-(diphenylamino)phenyl]cyclohexane ("TAPC"), N,N,N',N'-Tetrakis(4-methoxyphenyl)-benzidine ("HMTPD"), 4,4',4"-tris(N-carbazolyl)triphenylamine ("TCTA"), polyaniline/dodecylbenzenesulfonic acid ("PANI/DBSA"), poly(3,4-ethylenedioxythiophene)/poly(4-styrenesulfonate) ("PEDOT/PSS"), polyaniline/camphor sulfonic acid ("PANI/CSA"), polyaniline/poly(4-styrenesulfonate) ("PANI/PSS"), CzSi, or any combinations thereof:

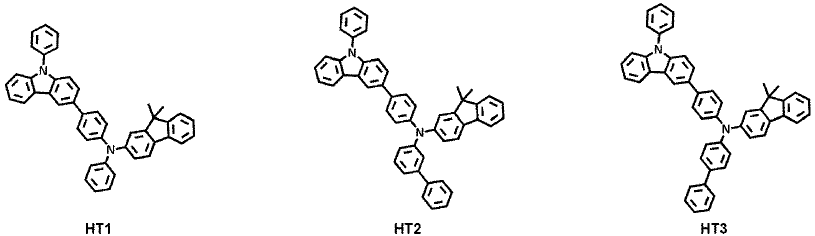

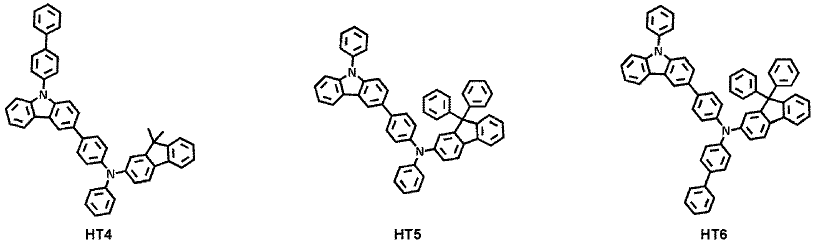

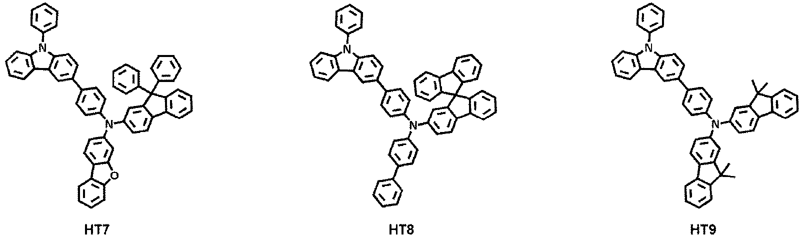

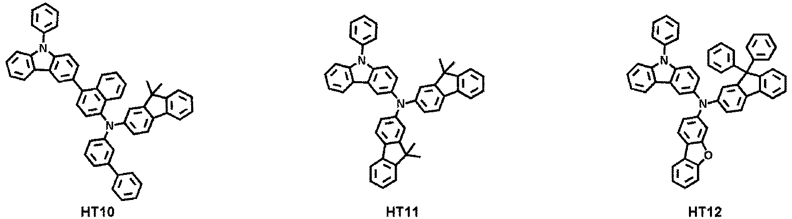

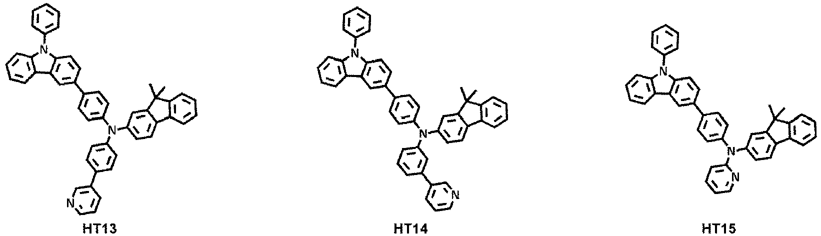

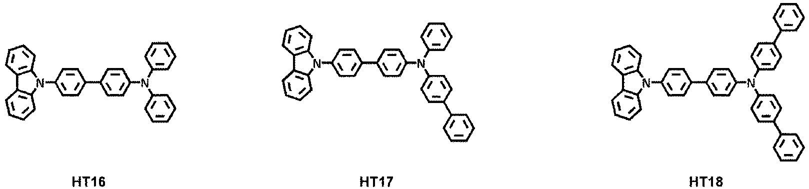

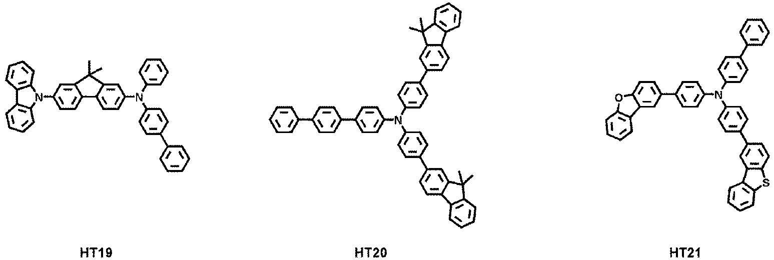

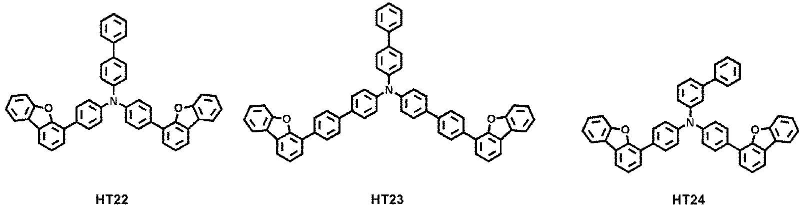

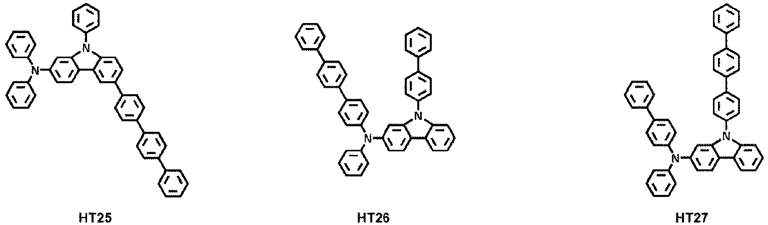

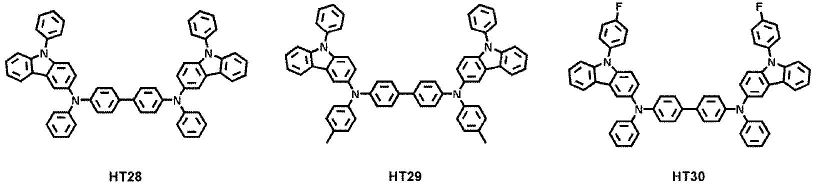

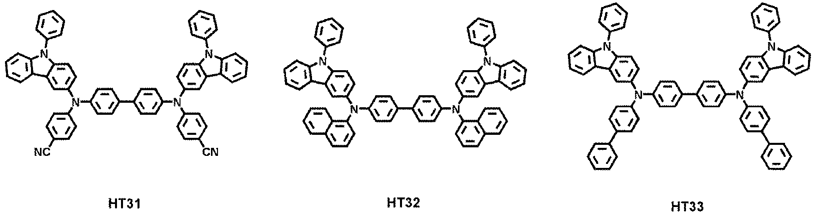

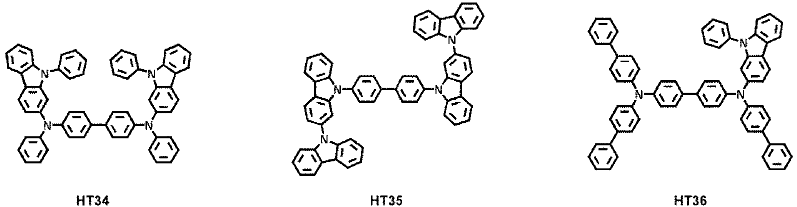

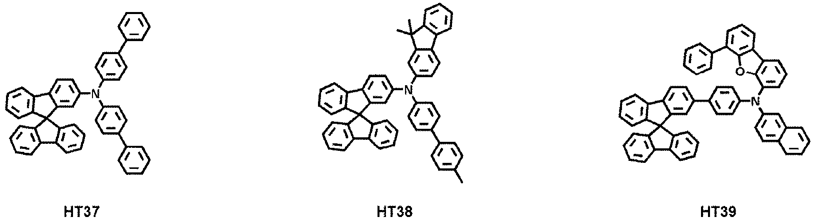

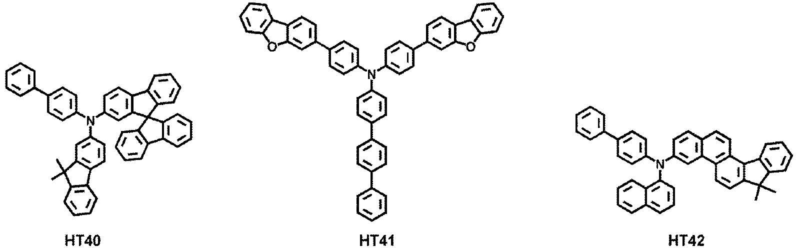

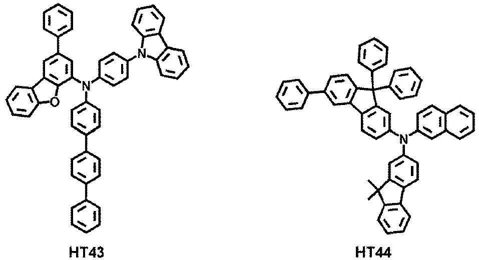

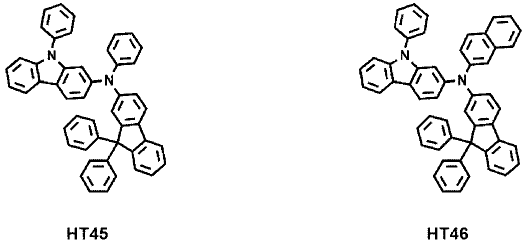

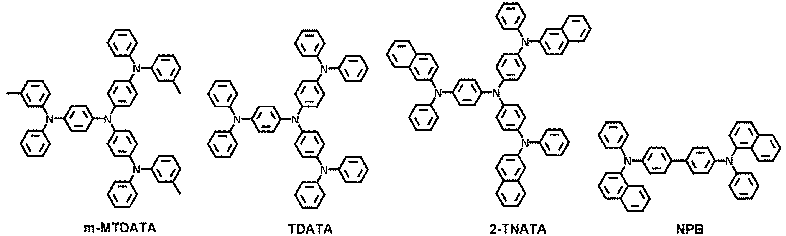

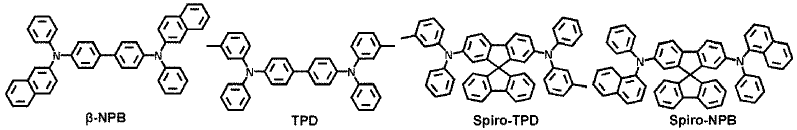

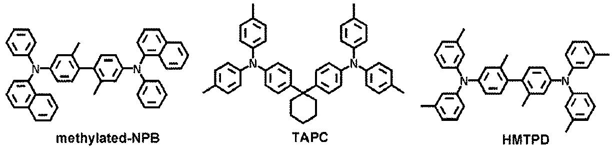

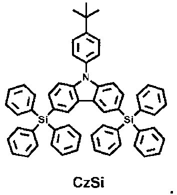

In an embodiment, the hole transport region may include the first compound represented by Formula 1 and the second compound represented by Formula 2. In an embodiment, the emission auxiliary layer may include the first compound and the second compound, for example.

A thickness of the hole transport region may be in a range of about 50 Å to about 10,000 Å, e.g., about 100 Å to about 4,000 Å. When the hole transport region includes a hole injection layer, a hole transport layer, or any combinations thereof, a thickness of the hole injection layer may be about 100 Å to about 9,000 Å, e.g., about 100 Å to about 1,000 Å, and a thickness of the hole transport layer may be about 50 Å to about 2,000 Å, e.g., about 100 Å to about 1,500 Å. When the thicknesses of the hole transport region, the hole injection layer, and the hole transport layer are within the ranges described above, satisfactory hole transporting characteristics may be obtained without a substantial increase in driving voltage.

The emission auxiliary layer may increase light emission efficiency by compensating for an optical resonance distance according to the wavelength of light emitted by the emission layer, and the electron blocking layer may block the leakage of electrons from the emission layer to the hole transport region. Materials that may be included in the hole transport region may be included in the emission auxiliary layer and the electron blocking layer.

The hole transport region may further include, in addition to these materials, a charge-generation material for the improvement of conductive properties. The charge-generation material may be uniformly or non-uniformly dispersed in the hole transport region (e.g., in the form of a single layer consisting of a charge-generation material).

The charge-generation material may be a p-dopant, for example.

In an embodiment, the LUMO energy of the p-dopant may be less than or equal to -3.5 eV, for example.

In an embodiment, the p-dopant may include a quinone derivative, a cyano group-containing compound, a compound including an element EL1 and an element EL2, or any combinations thereof.

In embodiments, the quinone derivative may include TCNQ and F4-TCNQ.

In embodiments, the cyano group-containing compound may include HAT-CN and a compound represented by Formula 221:

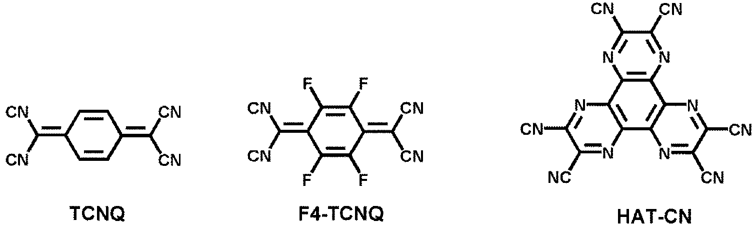

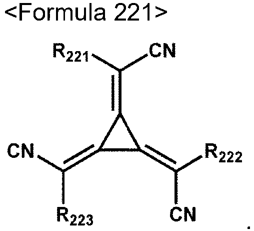

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combinations thereof; or any combinations thereof.

In the compound including the element EL1 and the element EL2, the element EL1 may be a metal, a metalloid, or any combinations thereof, and the element EL2 may be a non-metal, a metalloid, or any combinations thereof.

In embodiments, the metal may include an alkali metal (e.g., lithium (Li), sodium (Na), potassium (K), rubidium (Rb), cesium (Cs), etc.); alkaline earth metal (e.g., beryllium (Be), magnesium (Mg), calcium (Ca), strontium (Sr), barium (Ba), etc.); transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (e.g., zinc (Zn), indium (In), tin (Sn), etc.); or lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

In embodiments, the metalloid may include silicon (Si), antimony (Sb), or tellurium (Te).

In embodiments, the non-metal may include oxygen (O) and halogen (e.g., F, Cl, Br, I, etc.).

In embodiments, the compound including the element EL1 and the element EL2 may include a metal oxide, a metal halide (e.g., a metal fluoride, a metal chloride, a metal bromide, a metal iodide, etc.), a metalloid halide (e.g., a metalloid fluoride, a metalloid chloride, a metalloid bromide, a metalloid iodide, etc.), a metal telluride, or any combinations thereof.

In embodiments, the metal oxide may include a tungsten oxide (e.g., WO, W₂O₃, WO₂, WO₃, W₂O₅, etc.), a vanadium oxide (e.g., VO, V₂O₃, VO₂, V₂O₅, etc.), a molybdenum oxide (e.g., MoO, Mo₂O₃, MoO₂, MoO₃, Mo₂O₅, etc.), or a rhenium oxide (e.g., ReO₃, etc.).

In embodiments, the metal halide may include an alkali metal halide, an alkaline earth metal halide, a transition metal halide, a post-transition metal halide, or a lanthanide metal halide.

In embodiments, the alkali metal halide may include LiF, NaF, KF, RbF, CsF, LiCl, NaCl, KCI, RbCl, CsCl, LiBr, NaBr, KBr, RbBr, CsBr, Lil, Nal, KI, Rbl, or Csl.

In embodiments, the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, or BaI₂.

In embodiments, the transition metal halide may include a titanium halide (e.g., TiF₄, TiCl₄, TiBr₄, TiI₄, etc.), a zirconium halide (e.g., ZrF₄, ZrCl₄, ZrBr₄, ZrI₄, etc.), a hafnium halide (e.g., HfF₄, HfCl₄, HfBr₄, HfI₄, etc.), a vanadium halide (e.g., VF₃, VCl₃, VBr₃, Vl₃, etc.), a niobium halide (e.g., NbF₃, NbCl₃, NbBr₃, NbI₃, etc.), a tantalum halide (e.g., TaF₃, TaCl₃, TaBr₃, TaI₃, etc.), a chromium halide (e.g., CrF₃, CrCl₃, CrBr₃, CrI₃, etc.), a molybdenum halide (e.g., MoF₃, MoCl₃, MoBr₃, MoI₃, etc.), a tungsten halide (e.g., WF₃, WCl₃, WBr₃, Wl₃, etc.), a manganese halide (e.g., MnF₂, MnCl₂, MnBr₂, MnI₂, etc.), a technetium halide (e.g., TcF₂, TcCl₂, TcBr₂, TcI₂, etc.), a rhenium halide (e.g., ReF₂, ReCl₂, ReBr₂, ReI₂, etc.), an iron halide (e.g., FeF₂, FeCl₂, FeBr₂, FeI₂, etc.), a ruthenium halide (e.g., RuF₂, RuCl₂, RuBr₂, RuI₂, etc.), an osmium halide (e.g., OsF₂, OsCl₂, OsBr₂, OsI₂, etc.), a cobalt halide (e.g., CoF₂, CoCl₂, CoBr₂, CoI₂, etc.), a rhodium halide (e.g., RhF₂, RhCl₂, RhBr₂, RhI₂, etc.), an iridium halide (e.g., IrF₂, IrCl₂, IrBr₂, IrI₂, etc.), a nickel halide (e.g., NiF₂, NiCl₂, NiBr₂, NiI₂, etc.), a palladium halide (e.g., PdF₂, PdCl₂, PdBr₂, PdI₂, etc.), a platinum halide (e.g., PtF₂, PtCl₂, PtBr₂, PtI₂, etc.), a copper halide (e.g., CuF, CuCl, CuBr, Cul, etc.), a silver halide (e.g., AgF, AgCl, AgBr, Agl, etc.), or a gold halide (e.g., AuF, AuCl, AuBr, Aul, etc.).

In embodiments, the post-transition metal halide may include a zinc halide (e.g., ZnF₂, ZnCl₂, ZnBr₂, Znl₂, etc.), an indium halide (e.g., InI₃, etc.), or a tin halide (e.g., SnI₂, etc.).

In embodiments, the lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, or SmI₃.

In embodiments, the metalloid halide may include an antimony halide (e.g., SbCl₅, etc.).

In embodiments, the metal telluride may include an alkali metal telluride (e.g., Li₂Te, Na₂Te, K₂Te, Rb₂Te, Cs₂Te, etc.), an alkaline earth metal telluride (e.g., BeTe, MgTe, CaTe, SrTe, BaTe, etc.), a transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (e.g., ZnTe, etc.), or a lanthanide metal telluride (e.g., LaTe, CeTe, PrTe, NdTe, PmTe, EuTe, GdTe, TbTe, DyTe, HoTe, ErTe, TmTe, YbTe, LuTe, etc.).

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact each other or are separated from each other, to emit white light. In another embodiment, the emission layer may include two or more materials of a red light-emitting material, a green light-emitting material, and a blue light-emitting material, in which the two or more materials are mixed with each other in a single layer, to emit white light. In an embodiment, the emission layer may emit blue light, for example.

In an embodiment, the emission layer may include the first compound represented by Formula 1 as described in the specification. In an embodiment, the emission layer may include the second compound represented by Formula 2 as described in the specification.

The emission layer may include a host and a dopant.

In an embodiment, the dopant may include a phosphorescent dopant, a fluorescent dopant, or any combinations thereof. The phosphorescent dopant, the fluorescent dopant, or the like that may be included in the emission layer are each the same as described below.

The amount of the dopant in the emission layer may be from about 0.01 part by weight to about 15 parts by weight based on 100 parts by weight of the host.

In an embodiment, the emission layer may include quantum dots.

In an embodiment, the emission layer may include a delayed fluorescence material. The delayed fluorescence material may act as a host or a dopant in the emission layer.

A thickness of the emission layer may be in a range of about 100 Å to about 1,000 Å, e.g., about 200 Å to about 600 Å. When the thickness of the emission layer is within this range, excellent light-emission characteristics may be obtained without a substantial increase in driving voltage.

The host may include a carbazole-containing compound, an anthracene-containing compound, or any combinations thereof, for example.

In an embodiment, the host may include a compound represented by Formula 301:

<Formula 301> [Ar₃₀₁]_{xb11}-[(L₃₀₁)_{xb1}-R₃₀₁]_{xb21}

where, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each be as described in connection with Q₁.

In an embodiment, when xb11 in Formula 301 is 2 or more, two or more of Ar₃₀₁ may be linked to each other via a single bond.

In another embodiment, the host may include a compound represented by Formula 301-1, a compound represented by Formula 301-2, or any combinations thereof:

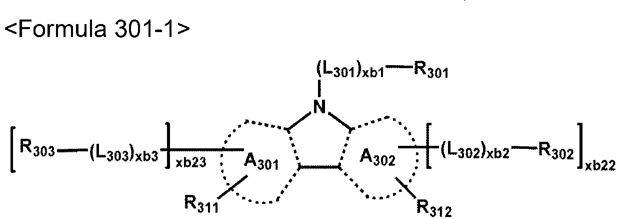

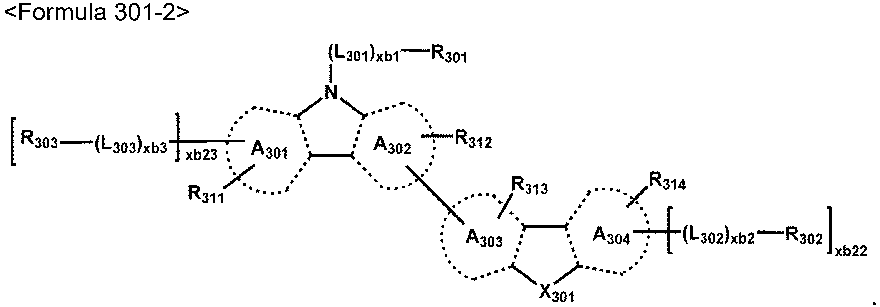

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be as described in the specification,
L₃₀₂ to L₃₀₄ may each independently be as described in connection with L₃₀₁,
xb2 to xb4 may each independently be as described in connection with xb1, and
R₃₀₂ to R₃₀₅ and R₃₁₁ to R₃₁₄ may each be as described in connection with R₃₀₁.

In another embodiment, the host may include an alkali earth metal complex, a post-transition metal complex, or any combinations thereof. In another embodiment, the hosts may include a Be complex (e.g., Compound H55), an Mg complex, a Zn complex, or any combinations thereof.

In another embodiment, the host may include: one of Compounds H1 to H128; 9,10-di(2-naphthyl)anthracene ("ADN"); 2-methyl-9,10-bis(naphthalen-2-yl)anthracene ("MADN"); 9,10-di(2-naphthyl)-2-t-butyl-anthracene ("TBADN"); 4,4'-bis(N-carbazolyl)-1,1'-biphenyl ("CBP"); 1,3-di-9-carbazolylbenzene ("mCP"); 1,3,5-tri(carbazol-9-yl)benzene ("TCP"); or any combinations thereof:

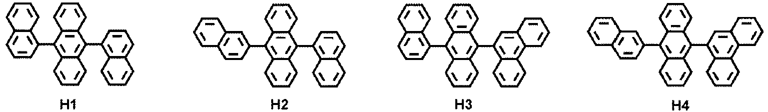

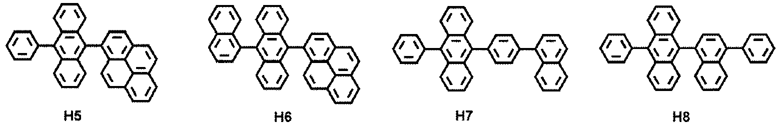

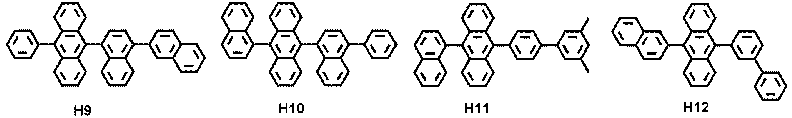

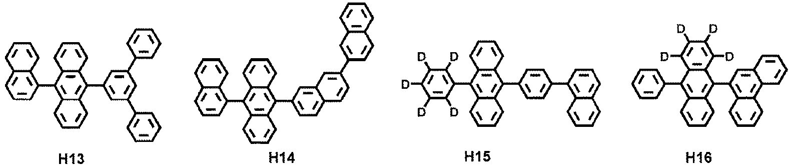

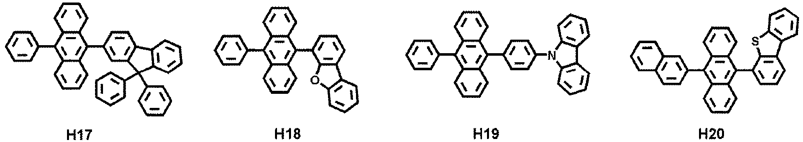

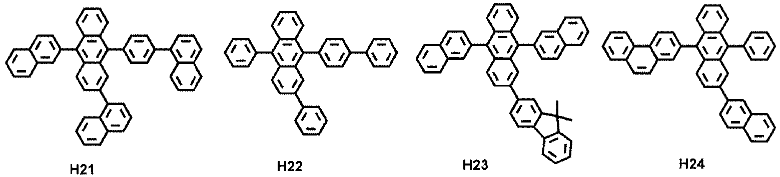

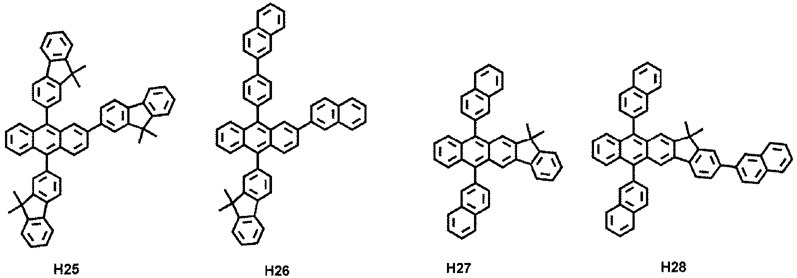

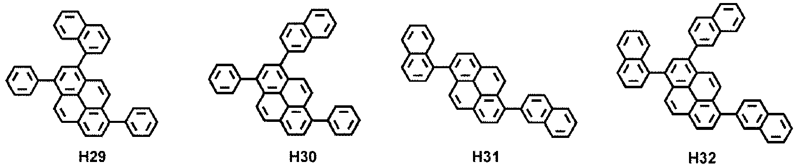

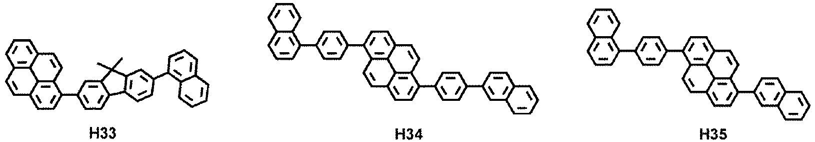

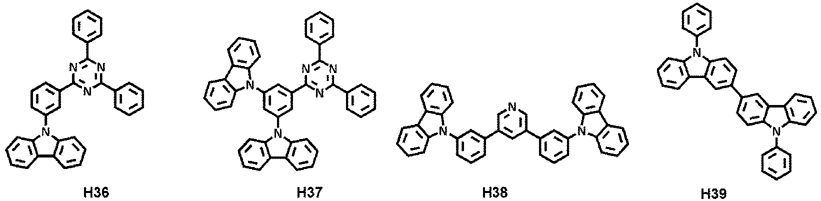

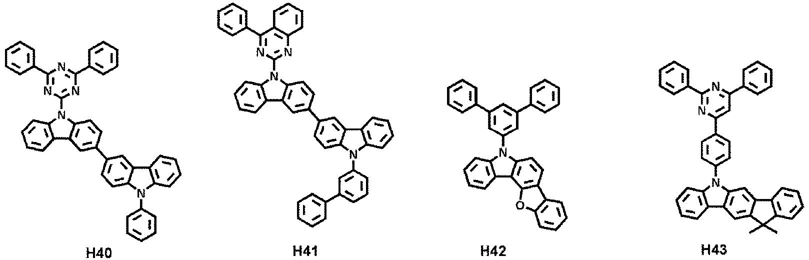

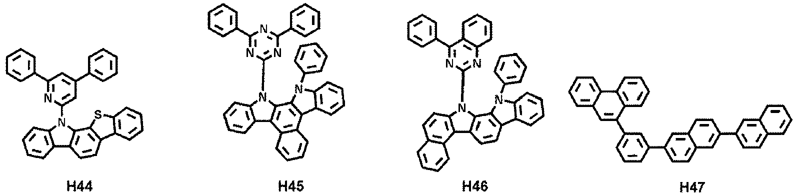

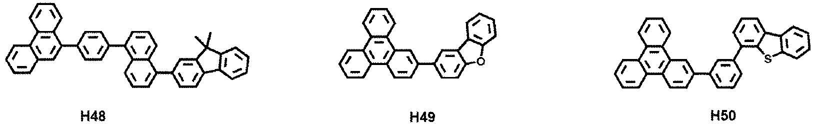

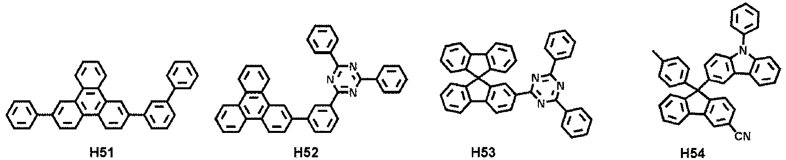

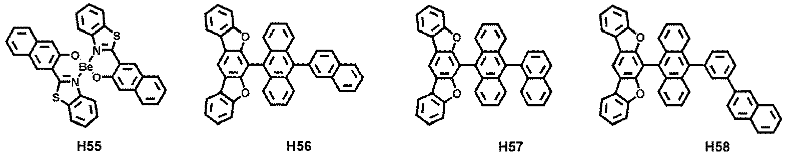

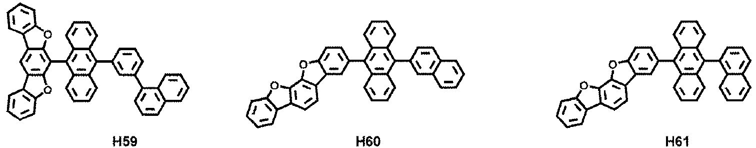

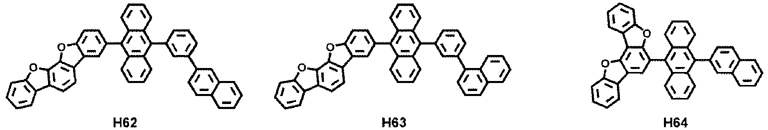

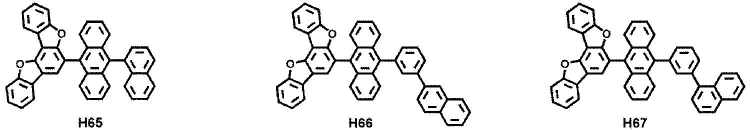

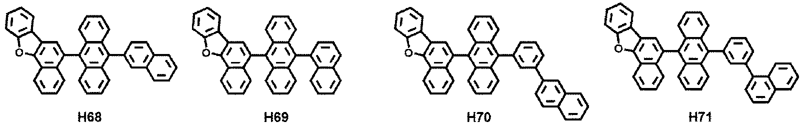

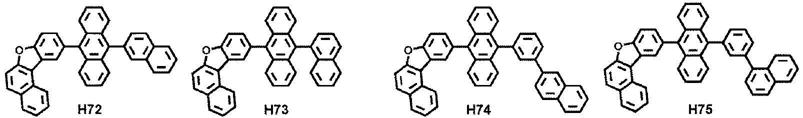

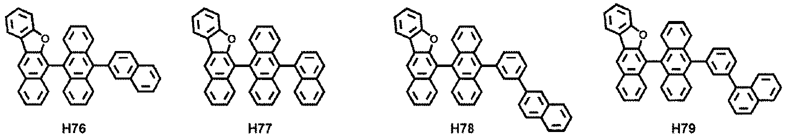

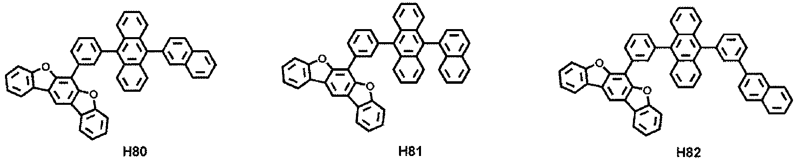

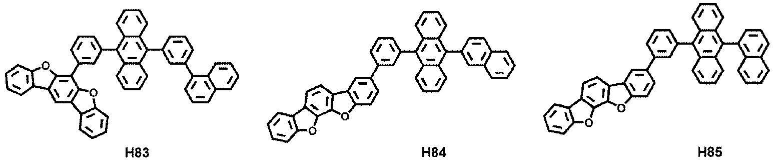

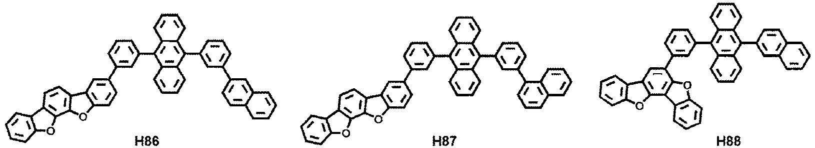

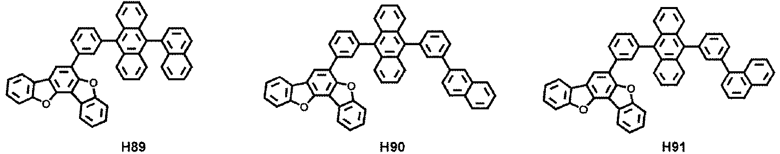

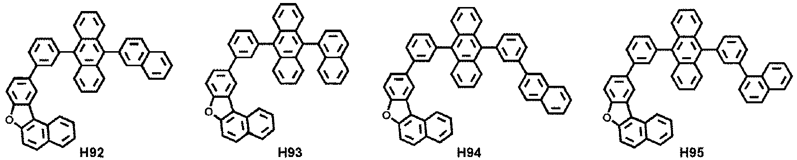

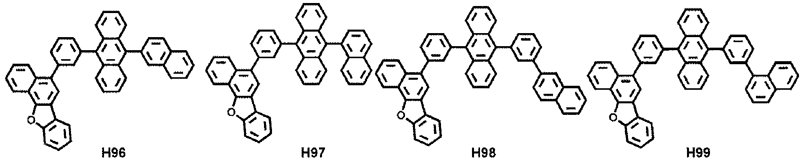

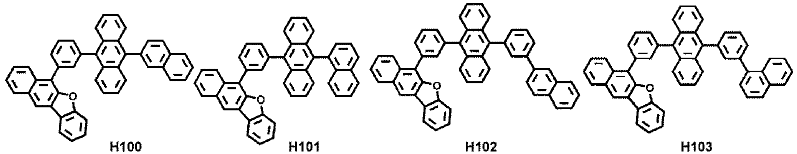

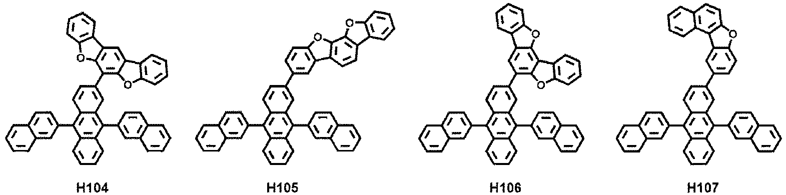

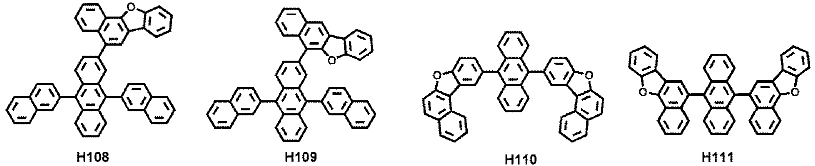

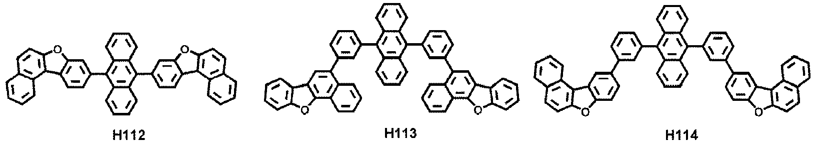

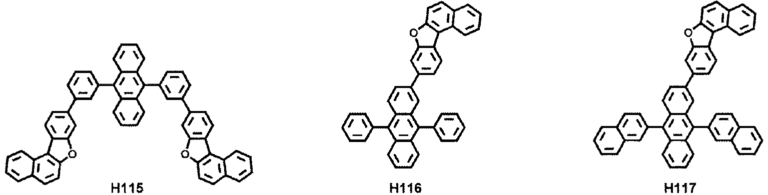

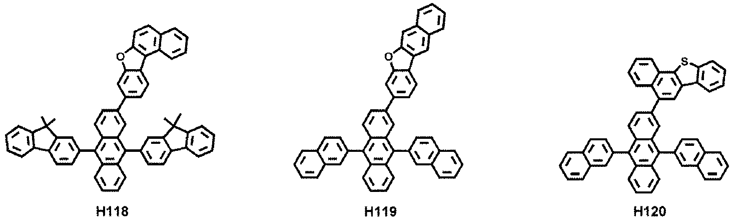

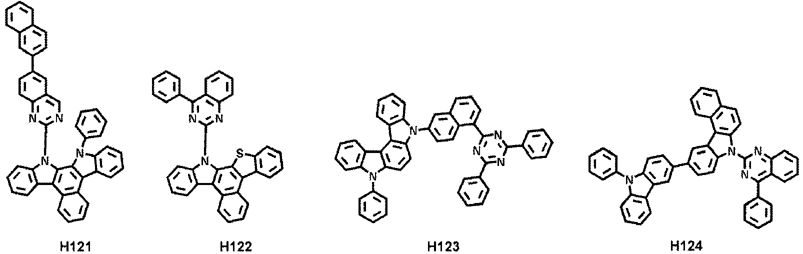

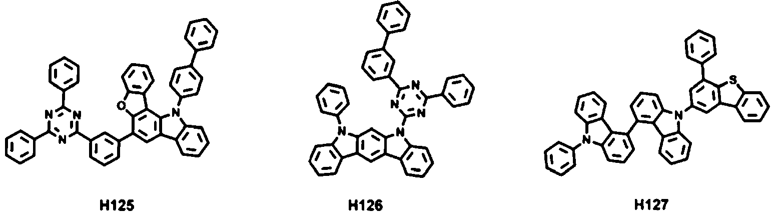

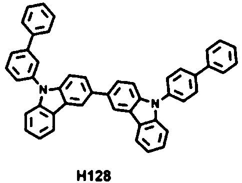

In an embodiment, the host may include a first host compound and a second host compound.

In an embodiment, the first host compound may be a hole transporting host.

In an embodiment, the second host compound may be an electron transporting host.

In an embodiment, the term "hole transporting host" as used herein refers to a compound including a hole transporting moiety.

In an embodiment, the term "electron transporting host" as used herein refers to not only a compound including an electron transporting moiety, but also a compound having bipolar properties.

The terms "hole-transporting host" and "electron-transporting host" may each be understood according to the relative difference between the hole mobility and electron mobility in the hole transporting host and the electron transporting host. In an embodiment, even when the electron transporting host does not include an electron transporting moiety, a bipolar compound exhibiting relatively higher electron mobility than the hole transporting host may be also understood as the electron transporting host, for example.

In an embodiment, the hole transporting host may be represented by one of Formulae 311-1 to 311-6, and the electron transporting host may be represented by one of Formulae 312-1 to 312-4 and 313:

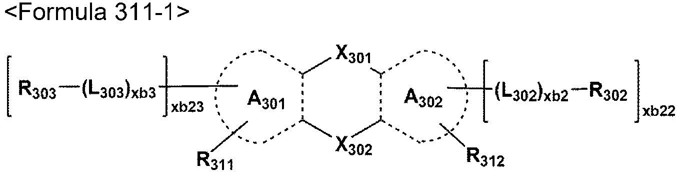

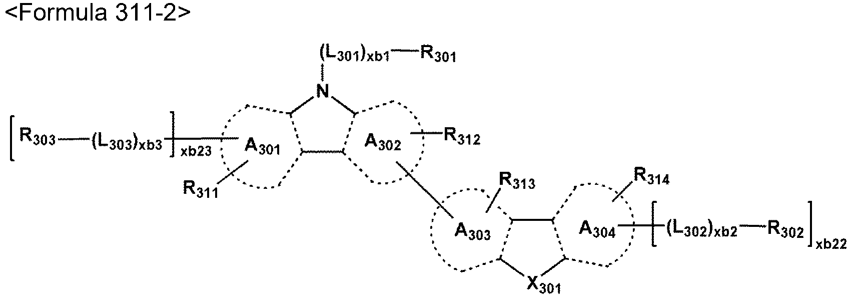

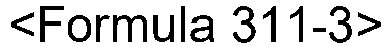

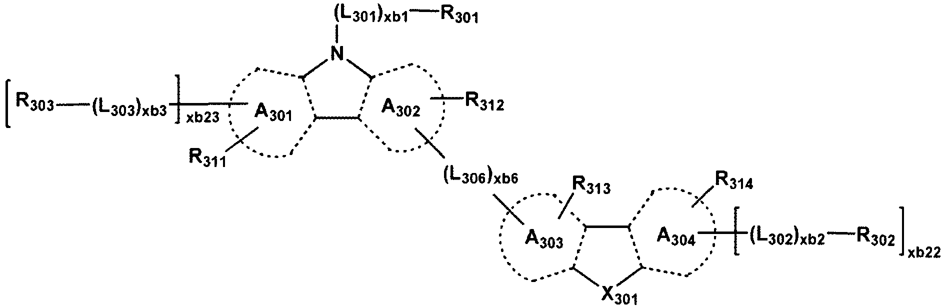

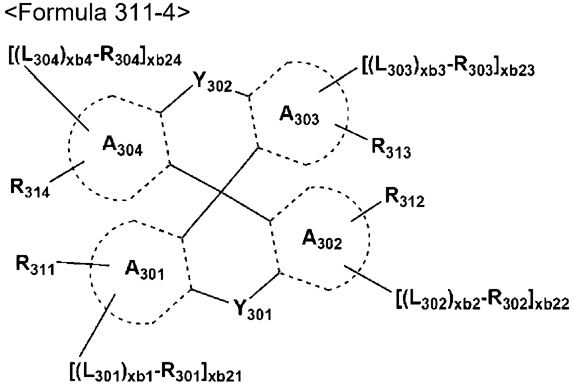

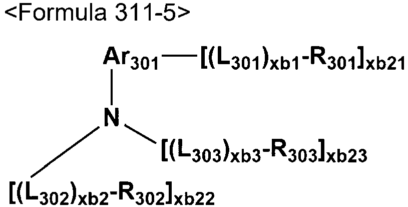

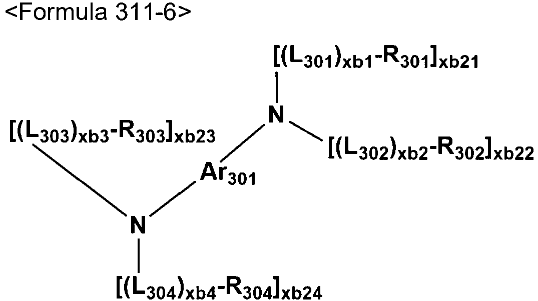

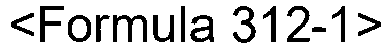

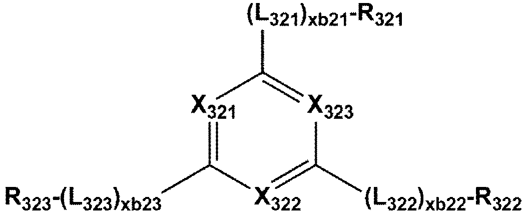

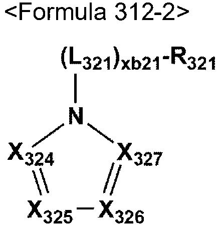

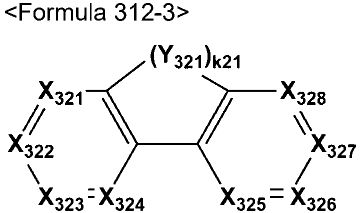

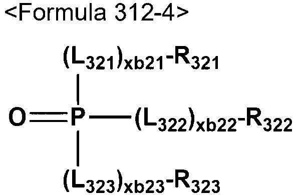

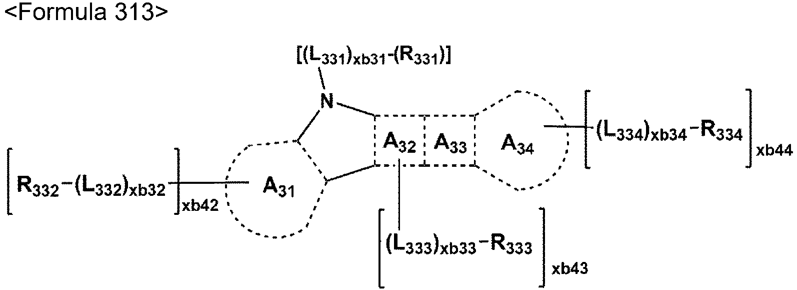

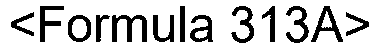

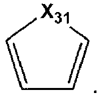

In Formulae 311-1 to 311-6, 312-1 to 312-4, 313, and 313A,
Ar₃₀₁ may be a C₃-C₆₀ carbocyclic group unsubstituted or substituted with at least one R₁₀ₐ or a C₁-C₆₀ heterocyclic group unsubstituted or substituted with at least one R₁₀ₐ,
A₃₀₁ to A₃₀₄ may each independently be a C₃-C₆₀ carbocyclic group or a C₁-C₆₀ heterocyclic group,
X₃₀₁ may be O, S, N[(L₃₀₄)_{xb4}-R₃₀₄], C[(L₃₀₄)_{xb4}-R₃₀₄][(L₃₀₅)_{xb5}-R₃₀₅], or Si[(L₃₀₄)_{xb4}-R₃₀₄][(L₃₀₅)_{xb5}-R₃₀₅],
X₃₀₂, Y₃₀₁, and Y₃₀₂ may each independently be a single bond, O, S, N[(L₃₀₅)_{xb5}-R₃₀₅], C[(L₃₀₄)_{xb4}-R₃₀₄][(L₃₀₅)_{xb5}-R₃₀₅], Si[(L₃₀₄)_{xb4}-R₃₀₄][(L₃₀₅)_{xb5}-R₃₀₅], or S(=O)₂,
xb1 to xb5 may each be 0, 1, 2, 3, 4, or 5,
xb6 may be 1, 2, 3, 4, or 5,
X₃₂₁ to X₃₂₈ may each independently be N or C[(L₃₂₄)_{xb24}-R₃₂₄],
Y₃₂₁ may be *-O-*', *-S-*', *-N[(L₃₂₅)_{xb25}-R₃₂₅]-*', *-C[(L₃₂₅)_{xb25}-R₃₂₅][(L₃₂₆)_{xb26}-R₃₂₆]-*', *-C[(L₃₂₅)_{xb25}-R₃₂₅]=C[(L₃₂₆)_{xb26}-R₃₂₆]-*', *-C[(L₃₂₅)_{xb25}-R₃₂₅]=N-*', or *-N=C[(L₃₂₆)_{xb26}-R₃₂₆]-*',
k21 may be 0, 1, or 2, where Y₃₂₁ is not present when k21 is 0,
xb21 to xb26 may each independently be 0, 1, 2, 3, 4, or 5,
A₃₁, A₃₂, and A₃₄ may each independently be a C₃-C₆₀ carbocyclic group or a C₁-C₃₀ heterocyclic group,
A₃₃ may be a group represented by Formula 313A,
X₃₁ may be N[(L₃₃₅)_{xb35}-(R₃₃₅)], O, S, Se, C[(L₃₃₅)_{xb35}-(R₃₃₅)][(L₃₃₆)_{xb36}-(R₃₃₆)], or Si[(L₃₃₅)_{xb35}-(R₃₃₅)][(L₃₃₆)_{xb36}-(R₃₃₆)],
xb31 to xb36 may each independently be 0, 1, 2, 3, 4, or 5,
xb42 to xb44 may each independently be 0, 1, 2, 3, 4, 5, 6, 7, 8, 9, or 10,
L₃₀₁ to L₃₀₆, L₃₂₁ to L₃₂₆, and L₃₃₁ to L₃₃₆ may each independently be a single bond, a C₁-C₂₀ alkylene group unsubstituted or substituted with at least one R₁₀ₐ, a C₂-C₂₀ alkenylene group unsubstituted or substituted with at least one R₁₀ₐ, a C₂-C₂₀ alkynylene group unsubstituted or substituted with at least one R₁₀ₐ, a C₃-C₁₀ cycloalkylene group unsubstituted or substituted with at least one R₁₀ₐ, a C₁-C₁₀ heterocycloalkylene group unsubstituted or substituted with at least one R₁₀ₐ, a C₃-C₁₀ cycloalkenylene group unsubstituted or substituted with at least one R₁₀ₐ, a C₁-C₁₀ heterocycloalkenylene group unsubstituted or substituted with at least one R₁₀ₐ, a C₆-C₆₀ arylene group unsubstituted or substituted with at least one R₁₀ₐ, a C₁-C₆₀ heteroarylene group unsubstituted or substituted with at least one R₁₀ₐ, a divalent non-aromatic condensed polycyclic group unsubstituted or substituted with at least one R₁₀ₐ, or a divalent non-aromatic condensed heteropolycyclic group unsubstituted or substituted with at least one R₁₀ₐ,
R₃₀₁ to R₃₀₅, R₃₁₁ to R₃₁₄, R₃₂₁ to R₃₂₆, and R₃₃₁ to R₃₃₆ may each independently be hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), or -P(=S)(Q₁)(Q₂),
neighboring two or more of R₃₂₁ to R₃₂₆ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
   a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
   Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof.

In an embodiment, the first host compound and the second host compound may form an exciplex.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combinations thereof.

The phosphorescent dopant may be electrically neutral.

In an embodiment, the phosphorescent dopant may include an organometallic compound represented by Formula 401:

<Formula 401> M(L₄₀₁)_{xc1}(L₄₀₂)_{xc2}

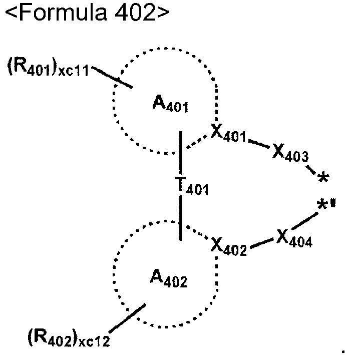

In Formulae 401 and 402,
M may be a transition metal (e.g., Ir, Pt, Pd, Os, Ti, Au, Hf, Eu, Tb, Rh, Re, or Tm),
L₄₀₁ may be a ligand represented by Formula 402, and xc1 is 1, 2, or 3, where, when xc1 is 2 or more, two or more of L₄₀₁ may be identical to or different from each other,
L₄₀₂ may be an organic ligand, and xc2 may be 0, 1, 2, 3, or 4, where, when xc2 is 2 or more, two or more of L₄₀₂ may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (e.g., a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described in connection with Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O )(Q₄₀₁)(Q₄₀₂),
Q₄₀₁ to Q₄₀₃ may each be the same each as described in connection with Q₁,
xc11 and xc12 may each independently be an integer from 0 to 10, and
* and *' in Formula 402 each indicate a binding site to M in Formula 401.

In an embodiment, in Formula 402, i) X₄₀₁ may be nitrogen, and X₄₀₂ may be carbon, or ii) each of X₄₀₁ and X₄₀₂ may be nitrogen.

In another embodiment, when xc1 in Formula 401 is 2 or more, two ring A₄₀₁(s) in two or more of L₄₀₁(s) may optionally be linked to each other via T₄₀₂, which is a linking group, or two ring A₄₀₂(s) may optionally be linked to each other via T₄₀₃, which is a linking group (refer to Compounds PD1 to PD4 and PD7). T₄₀₂ and T₄₀₃ may each be the same as described in connection with T₄₀₁.

In Formula 401, L₄₀₂ may be an organic ligand. In an embodiment, L₄₀₂ may include a halogen group, a diketone group (e.g., an acetylacetonate group), a carboxylic acid group (e.g., a picolinate group), -C(=O), an isonitrile group, a -CN group, a phosphorus containing group (e.g., a phosphine group, a phosphite group, etc.), or any combinations thereof.

The phosphorescent dopant may include one of compounds PD1 to PD39, or any combinations thereof, for example:

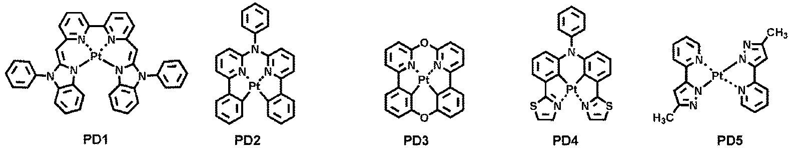

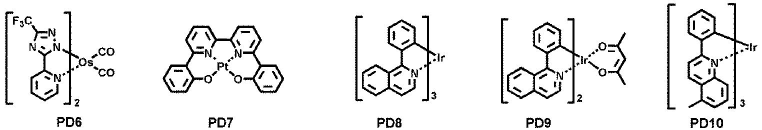

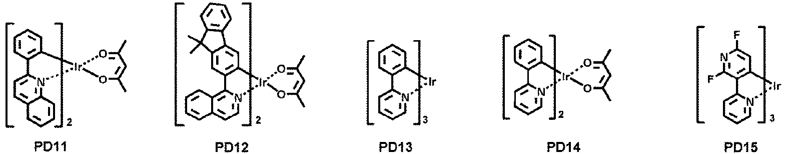

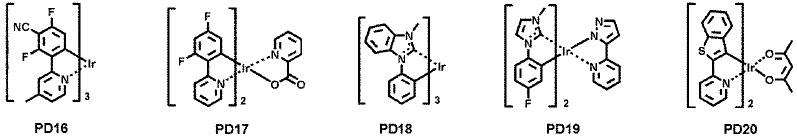

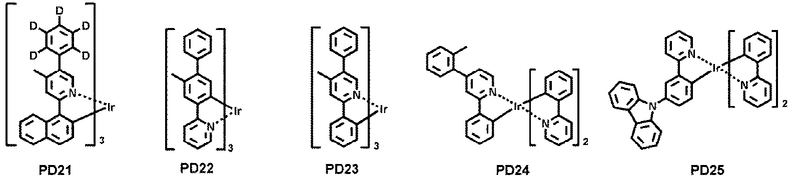

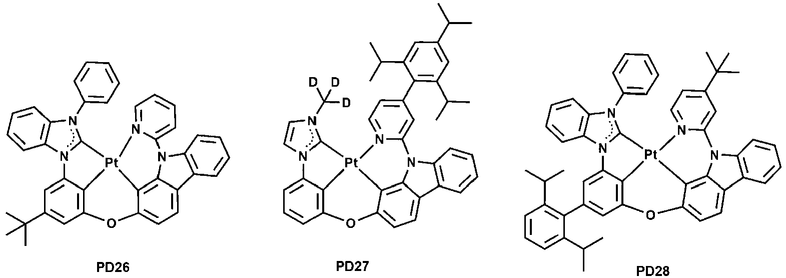

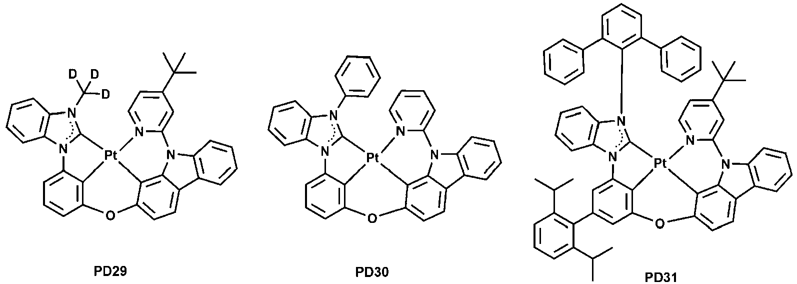

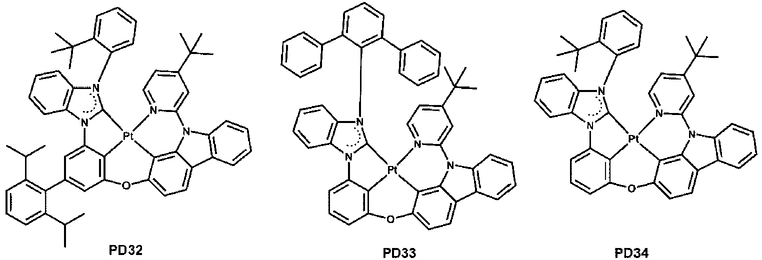

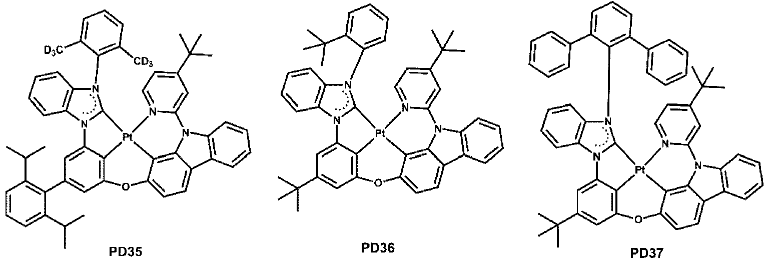

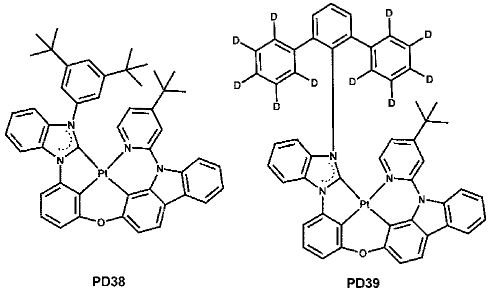

The fluorescent dopant may include an amine group-containing compound, a styryl group-containing compound, or any combinations thereof.

In an embodiment, the fluorescent dopant may include a compound represented by Formula 501:

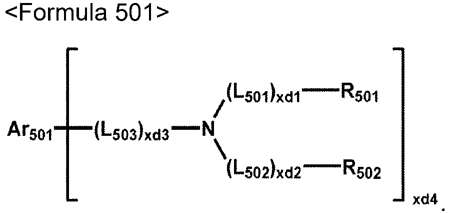

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, Ar₅₀₁ in Formula 501 may be a condensed cyclic group (e.g., an anthracene group, a chrysene group, a pyrene group, etc.) in which three or more monocyclic groups are condensed together.

In another embodiment, xd4 in Formula 501 may be 2.

In another embodiment, the fluorescent dopant may include: one of Compounds FD1 to FD36; DPVBi; DPAVBi; or any combinations thereof:

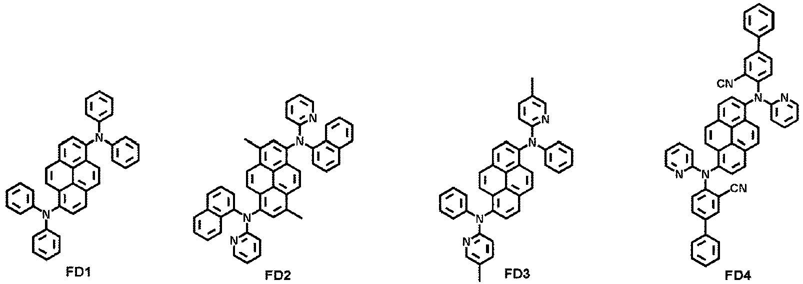

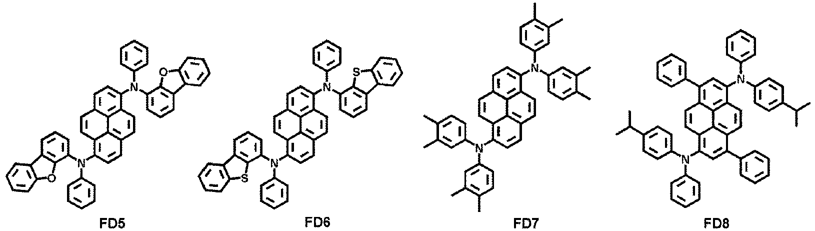

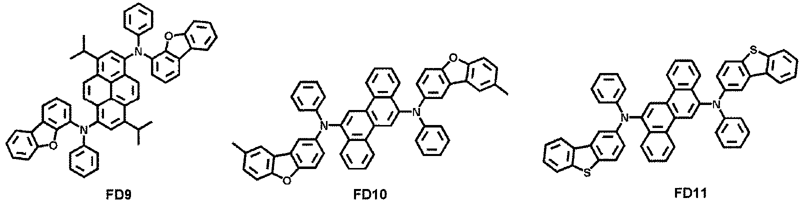

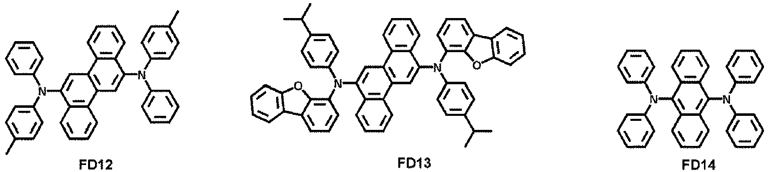

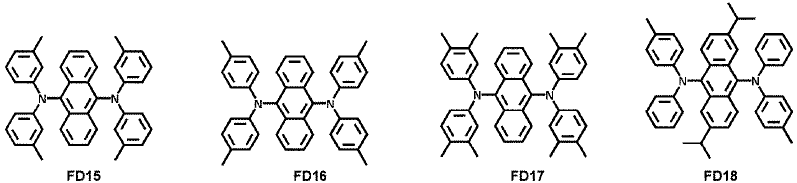

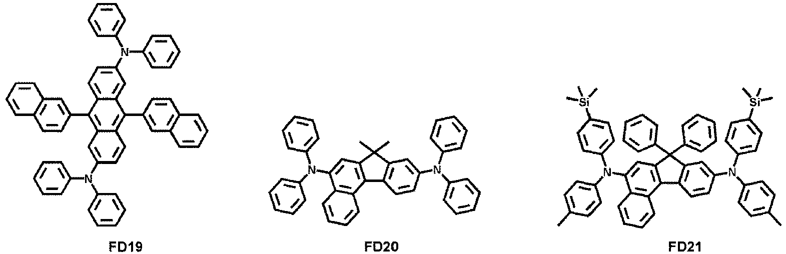

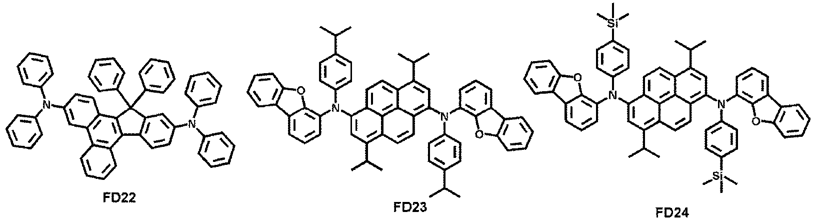

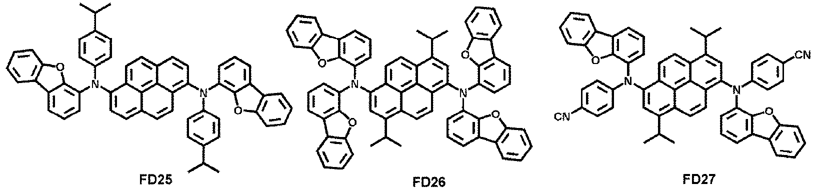

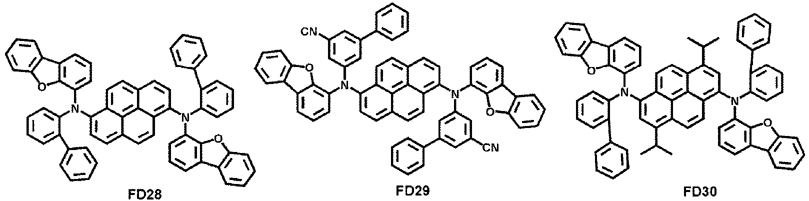

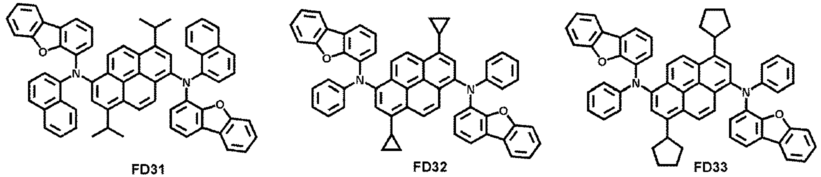

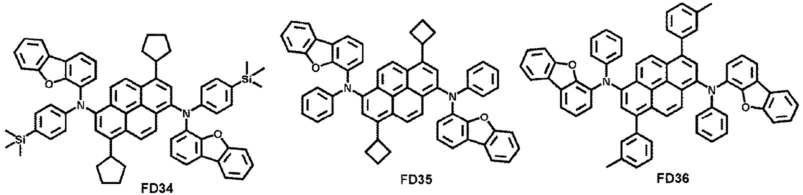

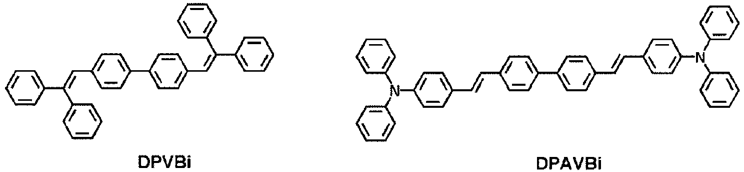

The emission layer may further include a delayed fluorescence material.

Herein, the delayed fluorescence material may be selected from compounds capable of emitting delayed fluorescence based on a delayed fluorescence emission mechanism.

The delayed fluorescence material included in the emission layer may act as a host or a dopant depending on the type of other materials included in the emission layer.

In an embodiment, a difference between a triplet energy level (eV) of the delayed fluorescence material and the singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material is within the range described above, up-conversion from a triplet state to a singlet state of the delayed fluorescence material may effectively occur, and thus, the organic light-emitting device 10 may have improved luminescence efficiency.

In an embodiment, the delayed fluorescence material may include: i) a material including at least one electron donor (e.g., a π electron-rich C₃-C₆₀ cyclic group such as a carbazole group) and at least one electron acceptor (e.g., a sulfoxide group, a cyano group, a π electron-deficient nitrogen-containing C₁-C₆₀ cyclic group, or the like), ii) a material including a C₃-C₆₀ polycyclic group including at least two cyclic groups that are condensed with each other while sharing boron (B).

In embodiments, the delayed fluorescence material may include at least one of Compounds DF1 to DF14:

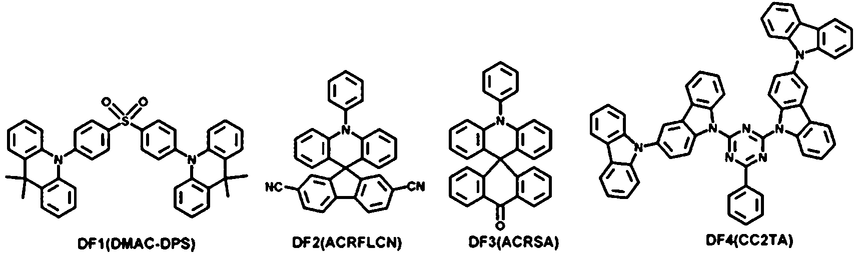

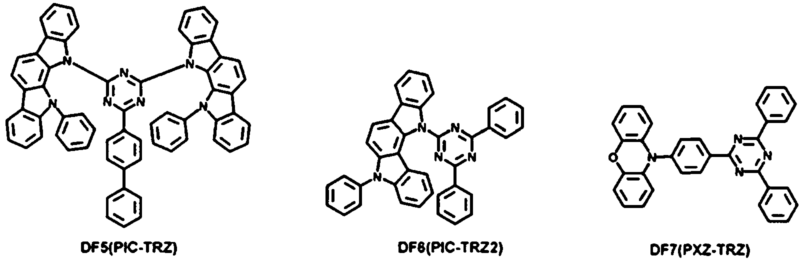

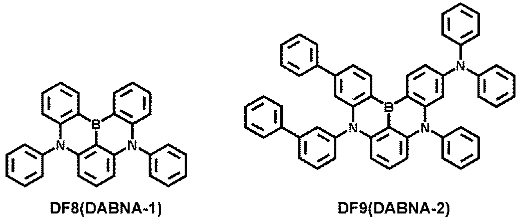

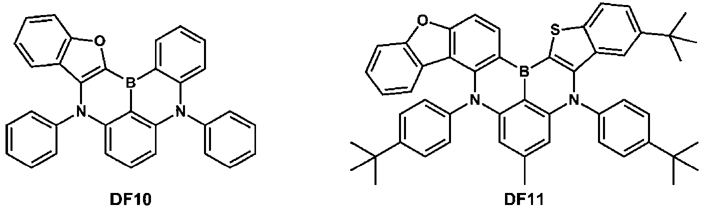

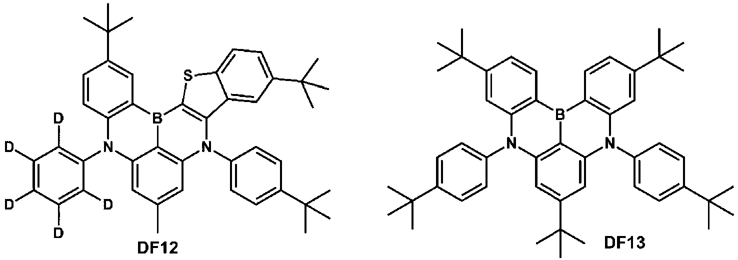

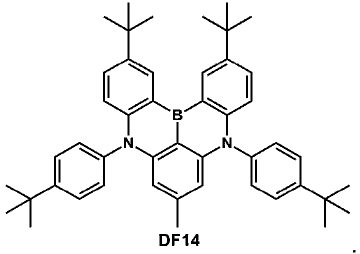

The emission layer may include quantum dots.

The term "quantum dot" as used herein refers to a crystal of a semiconductor compound. Quantum dots may emit light of various emission wavelengths according to the size of the crystal. Quantum dots may emit light of various emission wavelengths by adjusting the ratio of elements in the quantum dot compound.

A diameter of the quantum dot may be in a range of about 1 nanometer (nm) to about 10 nm, for example.

The quantum dots may be synthesized by a wet chemical process, a metal organic chemical vapor deposition ("MOCVD") process, a molecular beam epitaxy ("MBE") process, or any process similar thereto.

The wet chemical process is a method including mixing a precursor material with an organic solvent and then growing a quantum dot particle crystal. When the quantum dot particle crystals grow, the organic solvent may naturally act as a dispersant coordinated on the surface of the quantum dot particle crystals, and may control the growth of the quantum dot particle crystals. Accordingly, in the wet chemical process, the growth of quantum dot particle crystals may be controlled through a process which costs lower and is easier than a vapor deposition method, such as MOCVD or MBE.

The quantum dots may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combinations thereof.

In embodiments, the Group II-VI semiconductor compound may include a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or any combinations thereof.

In embodiments, the Group III-V semiconductor compound may include: a binary compound, such as GaN, GaP, GaAs, GaSb, AIN, AlP, AlAs, AlSb, InN, InP, InAs, InSb, or the like; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, or the like; a quaternary compound, such as GaAlNP, GaAINAs, GaAINSb, GaAlPAs, GaAlPSb, GalnNP, GalnNAs, GalnNSb, GalnPAs, GalnPSb, InAlNP, InAINAs, InAlNSb, InAlPAs, InAlPSb, or the like; or any combinations thereof. The Group III-V semiconductor compound may further include a Group II element. In embodiments, the Group III-V semiconductor compound further including a Group II element may include InZnP, InGaZnP, InAlZnP, etc.

In embodiments, the Group III-VI semiconductor compound may include: a binary compound, such as GaS, Ga₂S₃, GaSe, Ga₂Se₃, GaTe, InS, InSe, In₂Se₃, or InTe; a ternary compound, such as InGaS₃ or InGaSe₃; or any combinations thereof.

In embodiments, the Group I-III-VI semiconductor compound may include: a ternary compound, such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂, or the like; a quaternary compound, such as AgInGaS, AgInGaSe, CulnGaS, CuInGaS₂, AgInGaS₂, AgInGaSe₂, or the like; or any combinations thereof.

In embodiments, the Group IV-VI semiconductor compound may include: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or any combinations thereof.

The Group IV element or compound may include: a single element material, such as Si or Ge; a binary compound, such as SiC or SiGe; or any combinations thereof.

Each element included in a multi-element compound such as the binary compound, the ternary compound, and the quaternary compound may be at a uniform concentration or non-uniform concentration in a particle. The above formulae refer to the types of elements included in each compound, and the element ratios in these compounds may be different from each other. In an embodiment, AgInGaS₂ may indicate AgInₓGa₁₋ₓS₂ (where x is a real number satisfying 0<x<1), for example.

The quantum dot may have a single structure in which the concentration of each element in the quantum dot is uniform, or a core-shell dual structure. In an embodiment, the material included in the core and the material included in the shell may be different from each other, for example.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

In embodiments, the shell of the quantum dot may be an oxide of a metal or non-metal, a semiconductor compound, or any combinations thereof. In embodiments, the oxide of a metal or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; and any combinations thereof. In embodiments, the semiconductor compound may include: a Group III-VI semiconductor compound; a Group II-VI semiconductor compound; a Group III-V semiconductor compound; a Group III-VI semiconductor compound; a Group I-III-VI semiconductor compound; a Group IV-VI semiconductor compound; or any combinations thereof, as described herein. In an embodiment, the semiconductor compound may include CdS, CdSe, CdTe, ZnS, ZnSe, ZnTe, ZnSeS, ZnTeS, GaAs, GaP, GaS, GaSe, AgGaS, AgGaS2, GaSb, HgS, HgSe, HgTe, InAs, InP, InGaP, InSb, AlAs, AlP, AlSb, or any combinations thereof, for example.

Each element included in a multi-element compound, such as the binary compound and the ternary compound, may be at a uniform concentration or non-uniform concentration in a particle. The above formulae refer to the types of elements included in each compound, and the element ratios in these compounds may be different from each other.

A full width at half maximum ("FWHM") of the emission wavelength spectrum of the quantum dot may be about 45 nm or less, e.g., about 40 nm or less, e.g., about 30 nm or less, and within these ranges, color purity or color reproducibility may be increased. In addition, since the light emitted through the quantum dot is emitted in all directions, the wide viewing angle may be improved.

In addition, the quantum dot may be in the form of a spherical nanoparticle, a pyramidal nanoparticle, a multi-arm nanoparticle, a cubic nanoparticle, a nanotube, a nanowire, a nanofiber, or a nanoplate.

By adjusting the size of the quantum dots, the energy band gap may be adjusted, and thus, light of various wavelengths may be obtained in a quantum dot emission layer. Thus, by quantum dots as described above (by using quantum dots of different sizes or by varying the ratio of elements in a quantum dot compound), a light-emitting device that emits light of various wavelengths may be realized. Specifically, the size of the quantum dots or the ratio of elements in the quantum dot compound may be selected so that red light, green light, and/or blue light may be emitted. In addition, the quantum dots may emit white light by combination of light of various colors.

The electron transport region may have: i) a single-layered structure consisting of a single layer consisting of a single material, ii) a single-layered structure consisting of a single layer including multiple different materials, or iii) a multilayer structure including multiple layers including multiple different materials from each other.

The electron transport region may include a buffer layer, a hole blocking layer, an electron control layer, an electron transport layer, an electron injection layer, or any combinations thereof.

In an embodiment, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, where layers in each structure are sequentially stacked from the emission layer, for example.

The electron transport region (e.g., the buffer layer, the hole blocking layer, the electron control layer, or the electron transport layer in the electron transport region) may include a metal-free compound including at least one π electron-deficient nitrogen-containing C₁-C₆₀ cyclic group.

In an embodiment, the electron transport region may include a compound represented by Formula 601.

<Formula 601> [Ar₆₀₁]ₓₑ₁₁-[(L₆₀₁)ₓₑ₁-R₆₀₁]ₓₑ₂₁.

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, when xe11 in Formula 601 is 2 or more, two or more of Ar₆₀₁ may be linked together via a single bond.

In another embodiment, Ar₆₀₁ in Formula 601 may be an anthracene group that is unsubstituted or substituted with at least one R₁₀ₐ.

In another embodiment, the electron transport region may include a compound represented by Formula 601-1: 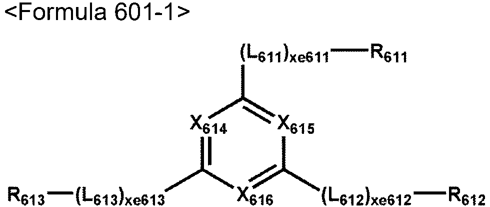 where, in Formula 601-1,
X₆₁₄ may be N or C(R₆₁₄), X₆₁₆ may be N or C(R₆₁₅), X₆₁₆ may be N or C(R₆₁₆), and at least one of X₆₁₄, X₆₁₅, or X₆₁₆ may be N,
L₆₁₁ to L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In an embodiment, xe1 and xe611 to xe613 in Formulae 601 and 601-1 may each independently be 0, 1, or 2.

In embodiments, the electron transport region may include: one of Compounds ET1 to ET45; 2,9-dimethyl-4,7-diphenyl-1,10-phenanthroline ("BCP"); 4,7-diphenyl-1,10-phenanthroline ("Bphen"); Alq₃; BAlq; TAZ; NTAZ; TSPO1, TPBI, BeBq₂; or any combinations thereof:

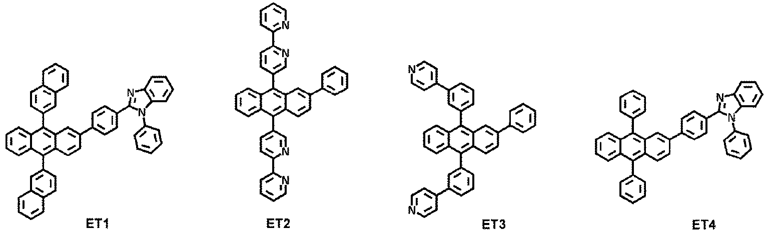

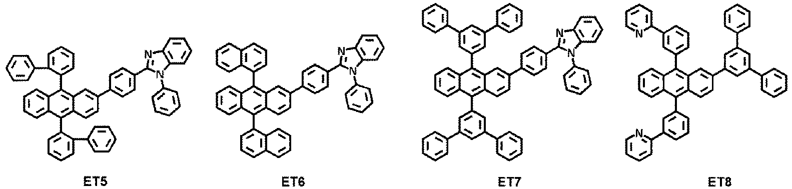

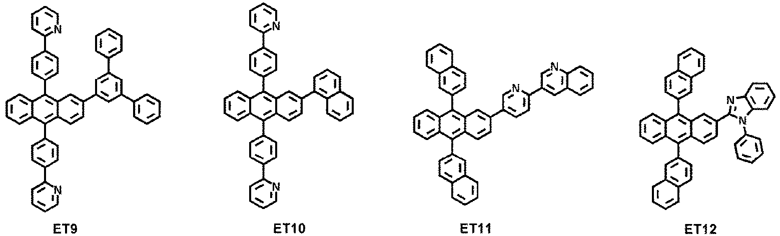

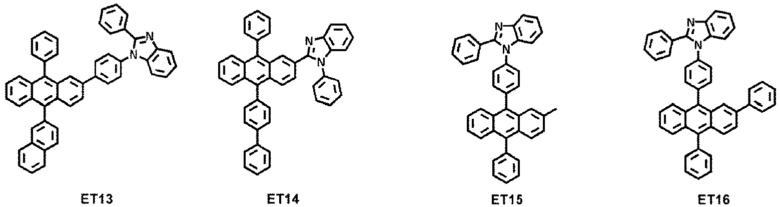

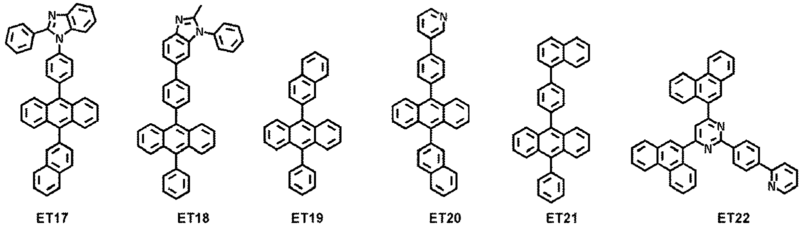

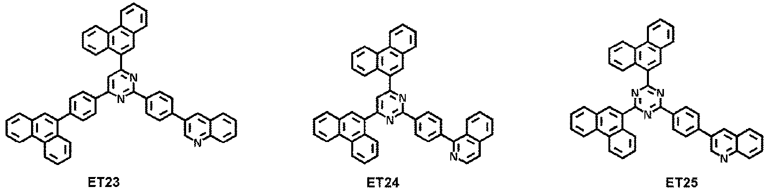

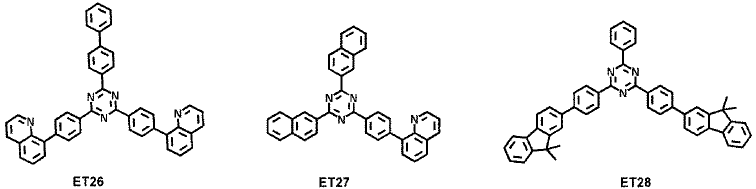

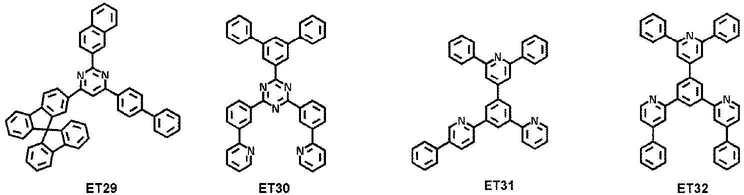

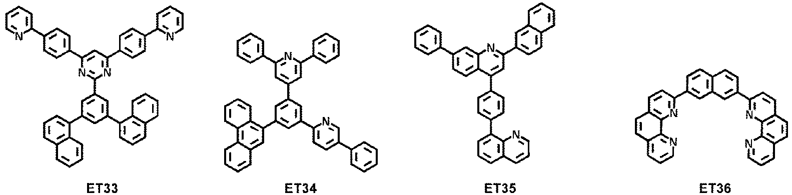

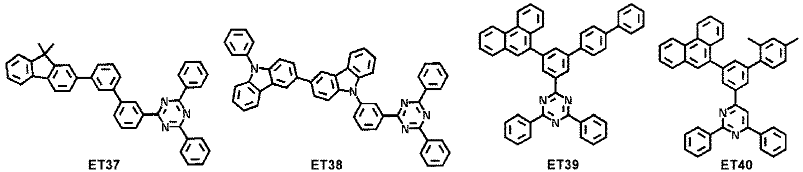

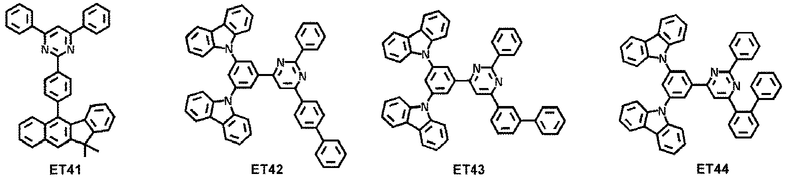

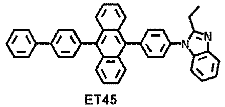

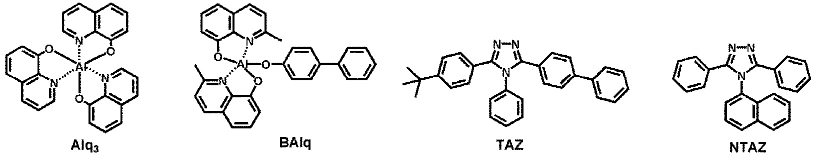

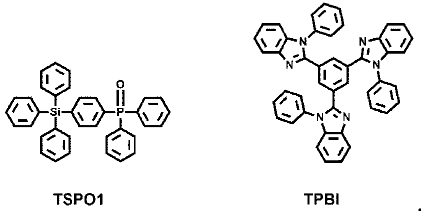

A thickness of the electron transport region may be about 100 Å to about 5,000 Å, e.g., about 160 Å to about 4,000 Å. When the electron transport region includes a buffer layer, a hole blocking layer, an electron control layer, an electron transport layer, or any combinations thereof, a thickness of the buffer layer, the hole blocking layer, or the electron control layer may each independently be in a range of about 20 Å to about 1,000 Å, e.g., about 30 Å to about 300 Å, and a thickness of the electron transport layer may be in a range of about 100 Å to about 1,000 Å, e.g., about 150 Å to about 500 Å. When the thickness of the buffer layer, the hole blocking layer, the electron control layer, the electron transport layer, and/or the electron transport region are within these ranges, satisfactory electron transporting characteristics may be obtained without a substantial increase in driving voltage.

The electron transport region (e.g., the electron transport layer in the electron transport region) may further include, in addition to the materials described above, a metal-containing material.

The metal-containing material may include an alkali metal complex, an alkaline earth metal complex, or any combinations thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combinations thereof.

In an embodiment, the metal-containing material may include a Li complex. The Li complex may include Compound ET-D1 (LiQ) or ET-D2, for example:

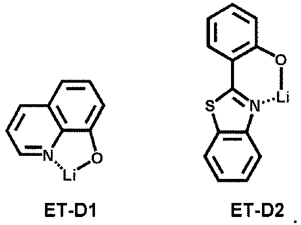

The electron transport region may include an electron injection layer that facilitates the injection of electrons from the second electrode 150. The electron injection layer may directly contact the second electrode 150.

The electron injection layer may have: i) a single-layered structure consisting of a single layer consisting of a single material, ii) a single-layered structure consisting of a single layer including multiple different materials, or iii) a multilayer structure including multiple layers including multiple different materials from each other.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combinations thereof.

The alkali metal may include Li, Na, K, Rb, Cs, or any combinations thereof. The alkaline earth metal may include Mg, Ca, Sr, Ba, or any combinations thereof. The rare earth metal may include Sc, Y, Ce, Tb, Yb, Gd, or any combinations thereof.

The alkali metal-containing compound, the alkaline earth metal-containing compound, and the rare earth metal-containing compound may include oxides, halides (e.g., fluorides, chlorides, bromides, iodides, etc.), or tellurides of the alkali metal, the alkaline earth metal, and the rare earth metal, or any combinations thereof.

The alkali metal-containing compound may include: alkali metal oxides, such as Li₂O, Cs₂O, or K₂O; alkali metal halides, such as LiF, NaF, CsF, KF, Lil, Nal, Csl, or KI; or any combinations thereof. The alkaline earth metal-containing compound may include an alkaline earth metal oxide, such as BaO, SrO, CaO, BaₓSr₁₋ₓO (x is a real number satisfying 0<x<1), or BaₓCa₁₋ₓO (x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combinations thereof. In an embodiment, the rare earth metal-containing compound may include lanthanide metal telluride. In embodiments, the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, or Lu₂Te₃.

The alkali metal complex, the alkaline earth-metal complex, and the rare earth metal complex may include i) one of ions of the alkali metal, the alkaline earth metal, and the rare earth metal and ii) a ligand bonded to the metal ion, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combinations thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combinations thereof, as described above. In an embodiment, the electron injection layer may further include an organic material (e.g., a compound represented by Formula 601).

In an embodiment, the electron injection layer may consist of i) an alkali metal-containing compound (e.g., alkali metal halide), ii) a) an alkali metal-containing compound (e.g., alkali metal halide); and b) an alkali metal, an alkaline earth metal, a rare earth metal, or any combinations thereof. In an embodiment, the electron injection layer may be a KI:Yb co-deposited layer, an Rbl:Yb co-deposited layer, or the like, for example.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combinations thereof may be uniformly or non-uniformly dispersed in a matrix including the organic material.

The thickness of the electron injection layer may be about 1 Å to about 100 Å, e.g., about 3 Å to about 90 Å. When the thickness of the electron injection layer is within the range as described above, satisfactory electron injection characteristics may be obtained without a substantial increase in driving voltage.

The second electrode 150 is disposed on the interlayer 130. The second electrode 150 may be a cathode, which is an electron injection electrode, and as a material for forming the second electrode 150, a metal, an alloy, an electrically conductive compound, or any combinations thereof, each having a low-work function, may be used.

The second electrode 150 may include lithium (Li), sodium (Na), silver (Ag), magnesium (Mg), aluminium (Al), silver-lithium (Ag-Li), silver-sodium (Ag-Na), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combinations thereof. The second electrode 150 may be a transmissive electrode, a transflective electrode, or a reflective electrode.

The second electrode 150 may have a single-layer structure or a multilayer structure including a plurality of layers.

A first capping layer may be disposed outside the first electrode 110, and/or a second capping layer may be disposed outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a transflective electrode or a transmissive electrode, and the first capping layer. Light generated in the emission layer of the interlayer 130 of the light-emitting device 10 may be extracted toward the outside through the second electrode 150 which is a transflective electrode or a transmissive electrode, and the second capping layer.

The first capping layer and the second capping layer may increase external luminescence efficiency according to the principle of constructive interference. Accordingly, the light extraction efficiency of the light-emitting device 10 is increased, such that the luminescence efficiency of the light-emitting device 10 may be increased.

Each of the first capping layer and the second capping layer may include a material having a refractive index of 1.6 or more (at wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combinations thereof. The carbocyclic compound, the heterocyclic compound, and the amine group-containing compound may optionally be substituted with a substituent including O, N, S, Se, Si, F, CI, Br, I, or any combinations thereof. In an embodiment, at least one of the first capping layer and the second capping layer may each independently include an amine group-containing compound.

In an embodiment, at least one of the first capping layer and the second capping layer may each independently include a compound represented by Formula 201, a compound represented by Formula 202, or any combinations thereof.

In an embodiment, at least one of the first capping layer and the second capping layer may each independently include one of Compounds HT28 to HT33, one of Compounds CP1 to CP6, β-NPB, or any combinations thereof:

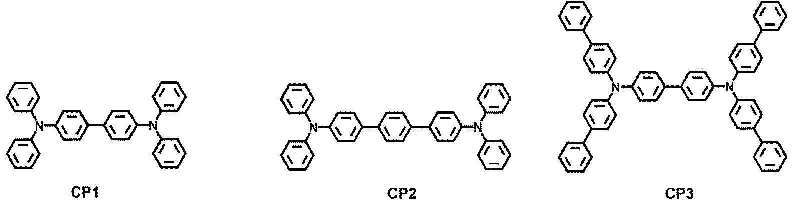

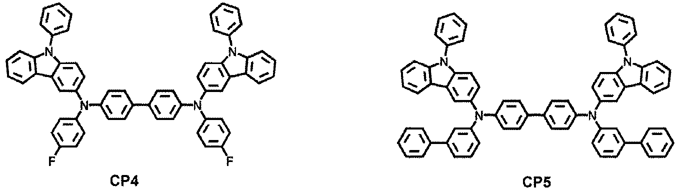

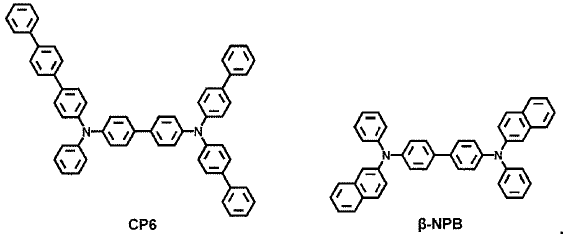

The first compound represented by Formula 1 may be included in various films. The second compound represented by Formula 2 may be included in various films.

Thus, another feature of the disclosure provides a film including the first compound represented by Formula 1 and/or the second compound represented by Formula 2. The film may be an optical member (or a light control means) (e.g., a color filter, a color conversion member, a capping layer, a light extraction efficiency enhancement layer, a selective light absorbing layer, a polarizing layer, a quantum dot-containing layer, etc.), a light blocking member (e.g., a light reflective layer, a light absorbing layer, etc.), a protective member (e.g., an insulating layer, a dielectric layer, etc.), or the like, for example.

The light-emitting device may be included in various electronic apparatuses. In an embodiment, the electronic apparatus including the light-emitting device may be a light-emitting apparatus, an authentication apparatus, or the like, for example.

The electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be disposed in at least one traveling direction of light emitted from the light-emitting device. In an embodiment, the light emitted from the light-emitting device may be blue light or white light, for example. A detailed description of the light-emitting device is provided above. In an embodiment, the color conversion layer may include quantum dots. The quantum dot may be a quantum dot as described herein, for example.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be disposed among the subpixel areas to define each of the subpixel areas.

The color filter may further include a plurality of color filter areas and light-shielding patterns disposed among the color filter areas, and the color conversion layer may further include a plurality of color conversion areas and light-shielding patterns disposed among the color conversion areas.

The plurality of color filter areas (or the plurality of color conversion areas) may include a first area emitting first color light, a second area emitting second color light, and/or a third area emitting third color light, where the first color light, the second color light, and/or the third color light may have different maximum emission wavelengths. In an embodiment, the first color light may be red light, the second color light may be green light, and the third color light may be blue light. In an embodiment, the plurality of color filter areas (or the plurality of color conversion areas) may include quantum dots. In detail, the first area may include red quantum dots, the second area may include green quantum dots, and the third area may not include quantum dots. A detailed description of the quantum dots is provided herein. The first area, the second area, and/or the third area may each further include a scatterer.

In an embodiment, the light-emitting device may emit first light, the first area may absorb the first light to emit first-1 color light, the second area may absorb the first light to emit second-1 color light, and the third area may absorb the first light to emit third-1 color light. In this case, the first-1 color light, the second-1 color light, and the third-1 color light may have different maximum emission wavelengths. In detail, the first light may be blue light, the first-1 color light may be red light, the second-1 color light may be green light, and the third-1 color light may be blue light.

The electronic apparatus may further include a thin-film transistor, in addition to the light-emitting device as described above. The thin-film transistor may include a source electrode, a drain electrode, and an active layer, where any one of the source electrode and the drain electrode may be electrically connected to any one of the first electrode and the second electrode of the light-emitting device.

The thin-film transistor may further include a gate electrode, a gate insulating film, or the like.

The active layer may include crystalline silicon, amorphous silicon, an organic semiconductor, an oxide semiconductor, or the like.

The electronic apparatus may further include a sealing portion for sealing the light-emitting device. The sealing portion may be disposed between the color filter and/or the color conversion layer and the light-emitting device. The sealing portion allows light from the light-emitting device to be extracted to the outside, and simultaneously prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally arranged on the sealing portion, in addition to the color filter and/or the color conversion layer, according to the use of the electronic apparatus. In embodiments, the functional layers may include a touch screen layer and a polarizing layer. The touch screen layer may be a pressure-sensitive touch screen layer, a capacitive touch screen layer, or an infrared touch screen layer. The authentication apparatus may be a biometric authentication apparatus that authenticates an individual by biometric information of a living body (e.g., fingertips, pupils, etc.), for example.

The authentication apparatus may further include, in addition to the light-emitting device as described above, a biometric information collector.

The electronic apparatus (e.g., a light-emitting apparatus) may be applied to various types of electronic equipment. In an embodiment, the electronic apparatus may be applied to various displays, light sources, lighting, personal computers (e.g., a mobile personal computer), mobile phones, digital cameras, electronic organizers, electronic dictionaries, electronic game machines, medical instruments (e.g., electronic thermometers, sphygmomanometers, blood glucose meters, pulse measurement apparatuses, pulse wave measurement apparatuses, electrocardiogram displays, ultrasonic diagnostic apparatuses, or endoscope apparatuses), fish finders, various measuring instruments, meters (e.g., meters for a vehicle, an aircraft, and a vessel), projectors, or the like.

The electronic apparatus may be applied to various types of electronic equipment. Accordingly, the light-emitting device may be included in various types of electronic equipment.

In an embodiment, the light-emitting apparatus may be applied to various types of electronic equipment. The electronic equipment in an embodiment may include the light-emitting apparatus described above and may further include, in addition to the light-emitting apparatus, a module or an apparatus which has an additional function.

In an embodiment, the electronic equipment including the light-emitting device may be one of a flat panel display, a curved display, a computer monitor, a medical monitor, a television, a billboard, an indoor light, an outdoor light, a signal light, a head-up display, a fully or partially transparent display, a flexible display, a rollable display, a foldable display, a stretchable display, a laser printer, a telephone, a mobile phone, a tablet, a phablet, a PDA, a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, and a signboard.

Since the light-emitting device has excellent effects in terms of luminescence efficiency long lifespan, the electronic equipment including the light-emitting device may have characteristics with relatively high luminance, relatively high resolution, and relatively low power consumption.

FIG. 2 is a cross-sectional view showing an embodiment of a light-emitting apparatus; and
The light-emitting apparatus of FIG. 2 includes a substrate 100, a thin-film transistor ("TFT"), a light-emitting device, and a sealing portion 300 that seals the light-emitting device.

The substrate 100 may be a flexible substrate, a glass substrate, or a metal substrate. A buffer layer 210 may be disposed on the substrate 100. The buffer layer 210 may prevent penetration of impurities through the substrate 100 and may provide a flat surface on the substrate 100.

A TFT may be disposed on the buffer layer 210. The TFT may include an active layer 220, a gate electrode 240, a source electrode 260, and a drain electrode 270.

The active layer 220 may include an inorganic semiconductor, such as silicon or polysilicon, an organic semiconductor, or an oxide semiconductor, and may include a source region, a drain region, and a channel region.

A gate insulating film 230 for insulating the active layer 220 from the gate electrode 240 may be disposed on the active layer 220, and the gate electrode 240 may be disposed on the gate insulating film 230.

An inter-insulating film 250 may be disposed on the gate electrode 240. The inter-insulating film 250 may be disposed between the gate electrode 240 and the source electrode 260 and between the gate electrode 240 and the drain electrode 270, to insulate these electrodes from one another.

The source electrode 260 and the drain electrode 270 may be arranged on the inter-insulating film 250. The inter-insulating film 250 and the gate insulating film 230 may be formed to expose the source region and the drain region of the active layer 220, and the source electrode 260 and the drain electrode 270 may be arranged in contact with the exposed portions of the source region and the drain region of the active layer 220.

The TFT may be electrically connected to a light-emitting device to drive the light-emitting device, and may be covered and protected by a passivation layer 280. The passivation layer 280 may include an inorganic insulating film, an organic insulating film, or any combinations thereof. A light-emitting device may be provided on the passivation layer 280. The light-emitting device includes the first electrode 110, the interlayer 130, and the second electrode 150.

The first electrode 110 may be disposed on the passivation layer 280. The passivation layer 280 may be disposed to expose a portion of the drain electrode 270, not fully covering the drain electrode 270, and the first electrode 110 may be disposed to be connected to the exposed portion of the drain electrode 270.

A pixel-defining film 290 including an insulating material may be disposed on the first electrode 110. The pixel-defining film 290 may expose a predetermined region of the first electrode 110, and the interlayer 130 may be formed in the exposed region of the first electrode 110. The pixel-defining film 290 may be a polyimide-based organic film or a polyacrylic-based organic film. Although not shown in FIG. 2, at least some layers of the interlayer 130 may extend beyond the upper portion of the pixel-defining film 290 to be disposed in the form of a common layer.

The second electrode 150 may be disposed on the interlayer 130, and a capping layer 170 may be additionally formed on the second electrode 150. The capping layer 170 may be formed to cover the second electrode 150.

The sealing portion 300 may be disposed on the capping layer 170. The sealing portion 300 may be disposed on a light-emitting device to protect the light-emitting device from moisture or oxygen. The sealing portion 300 may include: an inorganic film including silicon nitride (SiNx), silicon oxide (SiOx), ITO, IZO, or any combinations thereof; an organic film including PET, polyethylene naphthalate, polycarbonate, polyimide, polyethylene sulfonate, polyoxymethylene, PAR, hexamethyldisiloxane, an acrylic resin (e.g., polymethyl methacrylate, polyacrylic acid, or the like), an epoxy-based resin (e.g., aliphatic glycidyl ether ("AGE"), or the like), or any combinations thereof; or a combination of the inorganic film and the organic film.

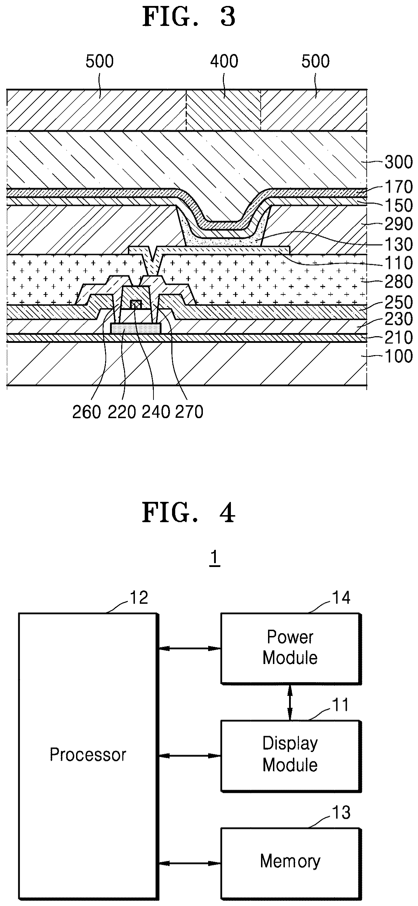

FIG. 3 shows a cross-sectional view showing an embodiment of a light-emitting apparatus.

The light-emitting apparatus of FIG. 3 is the same as the light-emitting apparatus of FIG. 2, except that a light-shielding pattern 500 and a functional region 400 are additionally arranged on the sealing portion 300. The functional region 400 may be i) a color filter area, ii) a color conversion area, or iii) a combination of the color filter area and the color conversion area. In an embodiment, a light-emitting device included in the light-emitting apparatus of FIG. 4 may be a tandem light-emitting device.

FIG. 4 is a block diagram of an embodiment of electronic equipment 1. Referring to FIG. 4, the electronic equipment 1 in an embodiment may include a display module 11, a processor 12, a memory 13, and a power module 14.

The processor 12 may include at least one of a central processing unit ("CPU"), an application processor ("AP"), a graphic processing unit ("GPU"), a communication processor ("CP"), an image signal processor ("ISP"), and a controller.

The memory 13 may store data information desired for operations of the processor 12 or the display module 11. When the processor 12 executes an application stored in the memory 13, an image data signal and/or an input control signal may be transmitted to the display module 11, and the display module 11 may process the provided signal and output image information on a display.

The power module 14 may include a power supply module such as a power adapter, a battery device, etc., and a power conversion module configured to convert power supplied by the power supply module and generate power desired for operations of the electronic equipment 1.

At least one of the components of the electronic equipment 1 may be included in the light-emitting apparatus in embodiments described above. In addition, some of individual modules included in a single module on a functional basis may be included in a light-emitting apparatus, and remaining (the other) individual modules may be provided separately from the light-emitting apparatus. In an embodiment, the light-emitting apparatus may include the display module 11, and the processor 12, the memory 13, and the power module 14 may be provided as an apparatus other than the light-emitting apparatus in the electronic equipment 1, for example.

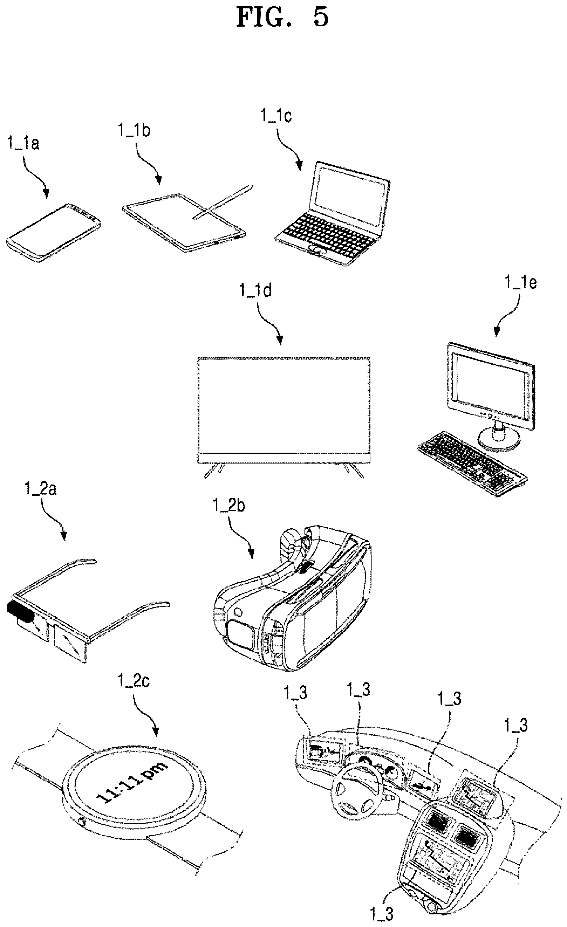

FIG. 5 depicts schematic views of embodiments of electronic equipment.

Referring to FIG. 5, various types of electronic equipment to which the electronic apparatus (e.g., the light-emitting apparatus) is applied may include not only electronic equipment for image display, such as a smartphone 1_1a, a tablet personal computer ("PC") 1_1b, a laptop 1_1c, a television ("TV") 1_1d, a desk monitor 1_1e, etc., but also wearable electronic equipment including an emitting module, such as smart glasses 1_2a, a head mount display 1_2b, a smart watch 1_2c, etc., electronic equipment for vehicles 1_3 including an emitting module, such as a dashboard of a vehicle, a center fascia, a center information display ("CID") disposed on a center fascia, a room mirror display, etc.

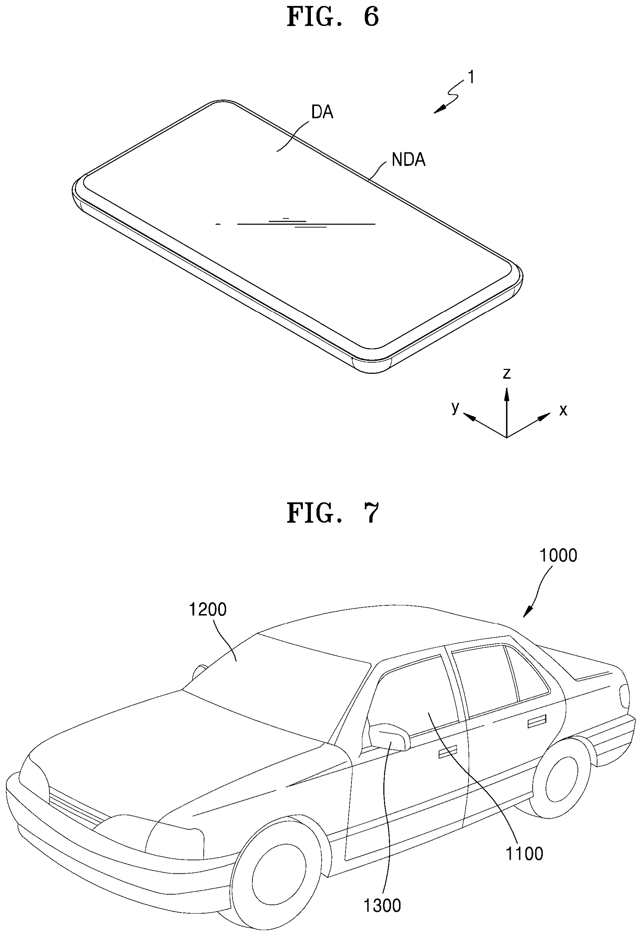

FIG. 6 is a schematic perspective view of an embodiment of the electronic equipment 1 including the light-emitting device. The electronic equipment 1 may be, as an apparatus that displays a moving image or a still image, portable electronic equipment, such as a mobile phone, a smartphone, a tablet personal computer ("PC"), a mobile communication terminal, an electronic notebook, an electronic book, a portable multimedia player ("PMP"), a navigation, or an ultra-mobile PC ("UMPC"), as well as various products, such as a television, a laptop, a monitor, a billboard, or an Internet of things ("loT") device. The electronic equipment 1 may be such a product above or a part thereof. In addition, the electronic equipment 1 may be a wearable device, such as a smart watch, a watch phone, a glasses-type display, or a head disposed (e.g., mounted) display ("HMD"), or a part of the wearable device. However, the disclosure is not limited thereto. In an embodiment, the electronic equipment 1 may be a dashboard of a vehicle, a center information display ("CID") disposed on a center fascia or dashboard of a vehicle, a room mirror display instead of a side-view mirror of a vehicle, an entertainment for the back seat of a vehicle, or a display disposed on the back of the front seat of a vehicle, a head up display ("HUD") installed on the front of a vehicle or projected on a front window glass, or a computer generated hologram augmented reality HUD ("CGH AR HUD"). FIG. 6 illustrates an embodiment in which the electronic equipment 1 is a smartphone for convenience of explanation.

The electronic equipment 1 may include a display area DA and a non-display area NDA outside the display area DA. A display apparatus may implement an image through an array of a plurality of pixels that are two-dimensionally disposed in the display area DA.

The non-display area NDA is an area that does not display an image, and may surround an entirety of the display area DA. On the non-display area NDA, a driver for providing electrical signals or power to display devices disposed on the display area DA may be disposed. On the non-display area NDA, a pad, which is an area to which an electronic element or a printed circuit board, may be electrically connected may be disposed.

In the electronic equipment 1, the length in an x-axis direction and the length in a y-axis direction may be different from each other. In an embodiment, as shown in FIG. 6, the length in the x-axis direction may be shorter than the length in the y-axis direction, for example. In an embodiment, the length in the x-axis direction may be the same as the length in the y-axis direction. In an embodiment, the length in the x-axis direction may be greater than the length in the y-axis direction.

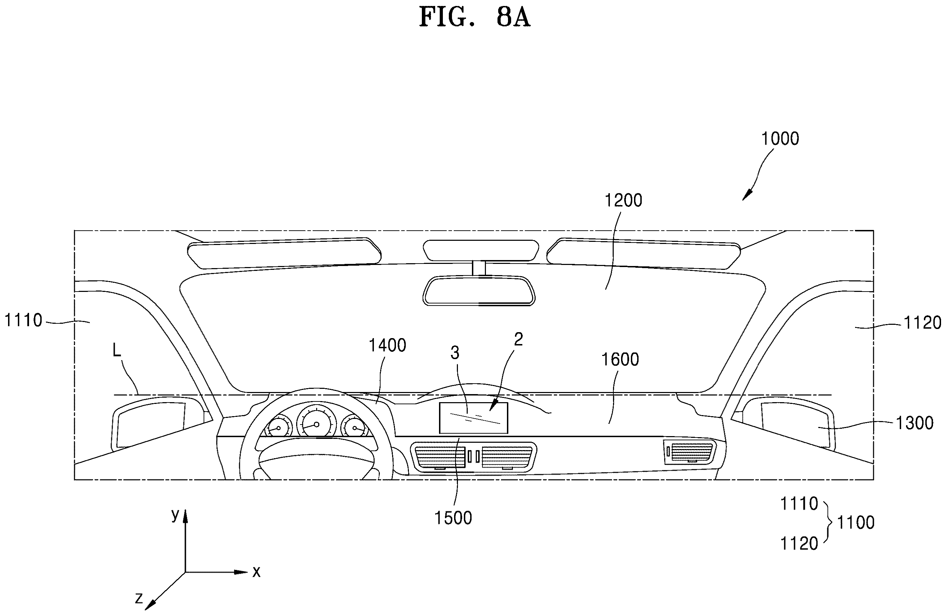

FIG. 7 is a diagram illustrating an embodiment of the exterior of a vehicle 1000 as electronic equipment including a light-emitting device. FIGS. 8A to 8C are each a schematic view of embodiments of the interior of the vehicle 1000.

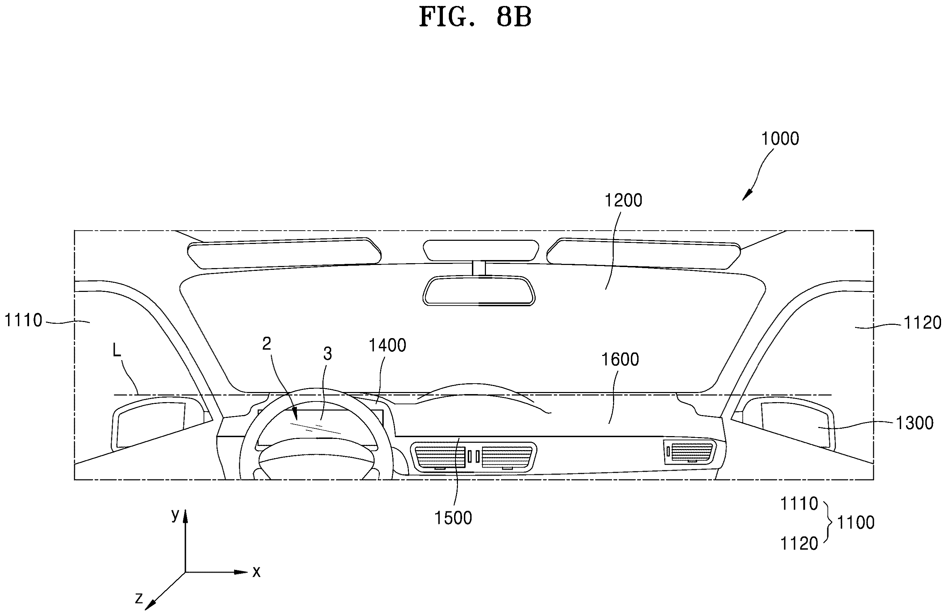

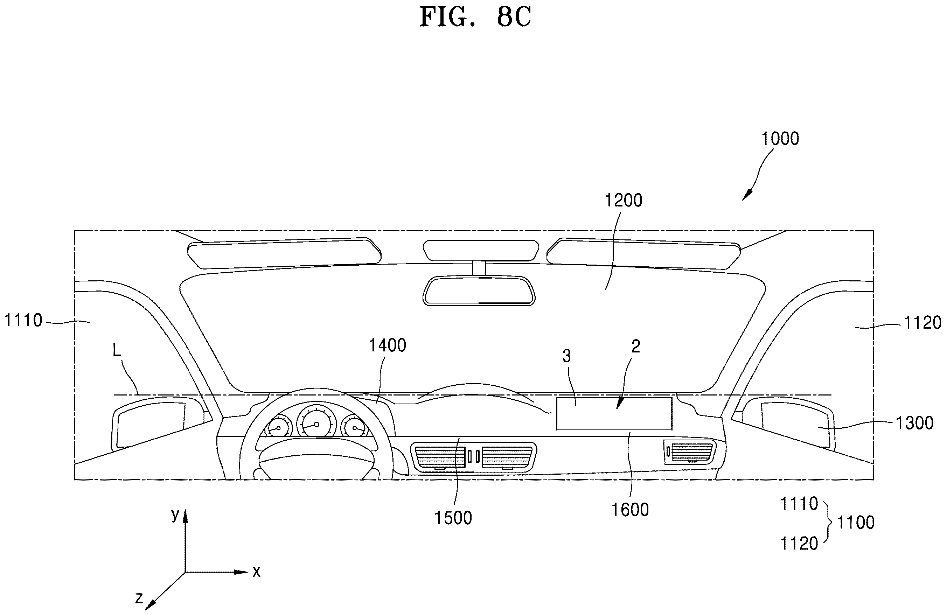

Referring to FIGS. 7, 8A, 8B, and 8C, the vehicle 1000 may refer to various apparatuses for moving a subject object to be transported, such as a human, an object, or an animal, from a departure point to a destination. The vehicle 1000 may include a vehicle traveling on a road or track, a vessel moving over the sea or river, an airplane flying in the sky using the action of air, or the like.

The vehicle 1000 may travel on a road or a track. The vehicle 1000 may move in a predetermined direction according to rotation of at least one wheel. In an embodiment, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses desired for driving are installed as other parts except for the body of the vehicle 1000. The exterior of the body of the vehicle may include a front panel, a bonnet, a roof panel, a rear panel, a trunk, a pillar provided at a boundary between doors, or the like. The chassis of the vehicle 1000 may include a power generating device, a power transmitting device, a driving device, a steering device, a braking device, a suspension device, a transmission device, a fuel device, front and rear wheels, left and right wheels, or the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar disposed between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be disposed next (adjacent) to the cluster 1400. The second side window glass 1120 may be disposed next (adjacent) to the passenger seat dashboard 1600.

In an embodiment, the side window glasses 1100 may be spaced apart from each other in an x direction or a -x direction. In an embodiment, the first side window glass 1110 and the second side window glass 1120 may be spaced apart from each other in the x direction or the -x direction. In other words, an imaginary straight line L connecting the side window glasses 1100 may extend in the x direction or the -x direction. In an embodiment, an imaginary straight line L connecting the first side window glass 1110 and the second side window glass 1120 to each other may extend in the x direction or the -x direction.

The front window glass 1200 may be installed in front of the vehicle 1000. The front window glass 1200 may be disposed between the side window glasses 1100 facing each other.

The side-view mirror 1300 may provide a rear view of the vehicle 1000. The side-view mirror 1300 may be installed on the exterior of the body of the vehicle. In an embodiment, a plurality of side-view mirrors 1300 may be provided. Any one of the plurality of side-view mirrors 1300 may be disposed outside the first side window glass 1110. Another of the plurality of side mirrors 1300 may be disposed outside the second side window glass 1120.

The cluster 1400 may be disposed in front of a steering wheel. The cluster 1400 may include a tachometer, a speedometer, a coolant thermometer, a fuel gauge, a turn signal indicator, a relatively high beam indicator, a warning light, a seat belt warning light, an odometer, a tachograph, an automatic shift selector indicator, a door open warning light, an engine oil warning light, and/or a relatively low fuel warning light.

The center fascia 1500 may include a control panel on which a plurality of buttons for adjusting an audio device, an air conditioning device, and a seat heater are disposed. The center fascia 1500 may be disposed on one side of the cluster 1400.

The passenger seat dashboard 1600 may be spaced apart from the cluster 1400, and the center fascia 1500 may be disposed between the cluster 1400 and the passenger seat dashboard 1600. In an embodiment, the cluster 1400 may be disposed to correspond to a driver seat (not shown), and the passenger seat dashboard 1600 may be disposed to correspond to a passenger seat (not shown). In an embodiment, the cluster 1400 may be next (adjacent) to the first side window glass 1110, and the passenger seat dashboard 1600 may be next (adjacent) to the second side window glass 1120.

In an embodiment, the display apparatus 2 may include a display panel 3, and the display panel 3 may display an image. The display apparatus 2 may be disposed inside the vehicle 1000. In an embodiment, the display apparatus 2 may be disposed between the side window glasses 1100 facing each other. The display apparatus 2 may be disposed on at least one of the cluster 1400, the center fascia 1500, and the passenger seat dashboard 1600.

The display apparatus 2 may include an organic light-emitting display apparatus, an inorganic electroluminescent display apparatus, a quantum dot display apparatus, or the like. Hereinafter, as the display apparatus 2 in an embodiment, an organic light-emitting display apparatus including the light-emitting device will be described in an embodiment, but various types of display apparatuses as described above may be used in embodiments.

Referring to FIG. 8A, the display apparatus 2 may be disposed on the center fascia 1500. In an embodiment, the display apparatus 2 may display navigation information. In an embodiment, the display apparatus 2 may display information regarding audio settings, video setting, or vehicle settings.

Referring to FIG. 8B, the display apparatus 2 may be disposed on the cluster 1400. In this case, the cluster 1400 may display driving information or the like through the display apparatus 2. That is, the cluster 1400 may digitally implement driving information or the like. The cluster 1400 may digitally display vehicle information and driving information as images. In an embodiment, a needle and a gauge of a tachometer and various warning light icons may be displayed by a digital signal.

Referring to FIG. 8C, the display apparatus 2 may be disposed on the passenger seat dashboard 1600 of the passenger seat. The display apparatus 2 may be embedded in the passenger seat dashboard 1600 or disposed on the passenger seat dashboard 1600. In an embodiment, the display apparatus 2 disposed on the passenger seat dashboard 1600 may display an image related to information displayed on the cluster 1400 and/or information displayed on the center fascia 1500. In an embodiment, the display apparatus 2 disposed on the passenger seat dashboard 1600 may display information different from information displayed on the cluster 1400 and/or information displayed on the center fascia 1500.

Layers constituting the hole transport region, the emission layer, and the layers constituting the electron transport region may be formed in a predetermined region by various methods such as vacuum deposition, spin coating, casting, Langmuir-Blodgett ("LB") deposition, ink-jet printing, laser-printing, laser-induced thermal imaging, or the like.

When the layers constituting the hole transport region, the emission layer, and the layers constituting the electron transport region are formed by vacuum deposition, the deposition may be performed at a deposition temperature in a range of about 100 degrees Celsius (°C) to about 500 °C, at a vacuum degree in a range of about 10⁻⁸ torr to about 10⁻³ torr, and at a deposition speed in a range of about 0.01 angstrom per second (Å/sec) to about 100 Å/sec, depending on a material to be included in a layer to be formed and the structure of a layer to be formed.

The term "C₃-C₆₀ carbocyclic group" as used herein refers to a cyclic group consisting of carbon atoms and hydrogen atoms as the only ring-forming atoms and having three to sixty carbon atoms, and the term "C₁-C₆₀ heterocyclic group" as used herein refers to a cyclic group that has one to sixty carbon atoms and further includes, in addition to a carbon atom and a hydrogen atom, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In an embodiment, the number of ring-forming atoms of the C₁-C₆₀ heterocyclic group may be 3 to 61.

The "cyclic group" as used herein may include both the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

In an embodiment,
the C₃-C₆₀ carbocyclic group may be i) Group T1 or ii) a condensed cyclic group in which two or more of Group T1 are condensed with each other (e.g., a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an **imidazopyrazine** group, an imidazopyridazine group, an azacarbazole group, an azafluorene group, an azadibenzosilole group, an azadibenzothiophene group, an azadibenzofuran group, etc.),

the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),

the π electron-deficient nitrogen-containing C₁-C₆₀ cyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, or the like),

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

Group T3 may be a furan group, a thiophene group, a 1H-pyrrole group, a silole group, or a borole group, and

Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as used herein may refer to a group condensed to any cyclic group, a monovalent group, or a polyvalent group (e.g., a divalent group, a trivalent group, a tetravalent group, etc.) according to the structure of a formula for which the corresponding term is used. In an embodiment, the "benzene group" may be a benzo group, a phenyl group, a phenylene group, or the like, which may be easily understood by those of ordinary skill in the art according to the structure of a formula including the "benzene group."

In embodiments, the monovalent C₃-C₆₀ carbocyclic group and monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, or a monovalent non-aromatic condensed heteropolycyclic group, and embodiments of the divalent C₃-C₆₀ carbocyclic group and the divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, or a divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as that of the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as that of the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as that of the C₂-C₆₀ alkynyl group.

The term "C₁-C₆₀ alkoxy group" as used herein refers to a monovalent group represented by -OA₁₀₁ (where A₁₀₁ is the C₁-C₆₀ alkyl group), and examples thereof include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, or the like. The term "C₃-C₁₀ cycloalkylene group" as used herein refers to a divalent group having the same structure as that of the C₃-C₁₀ cycloalkyl group.

The term "C₁-C₁₀ heterocycloalkyl group" as used herein refers to a monovalent cyclic group that has one to ten carbon atoms and further includes, in addition to the carbon atoms, at least one heteroatom as a ring-forming atom, and examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as that of the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as that of the C₃-C₁₀ cycloalkenyl group.

The term "C₁-C₁₀ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. In embodiments, the C₁-C₁₀ heterocycloalkenyl group may include a 4,5-dihydro-1,2,3,4-oxatriazolyl group, a 2,3-dihydrofuranyl group, or a 2,3-dihydrothiophenyl group. The term "C₁-C₁₀ heterocycloalkenylene group" as used herein refers to a divalent group having the same structure as that of the C₁-C₁₀ heterocycloalkenyl group.

The term "C₆-C₆₀ aryl group" as used herein refers to a monovalent group having a carbocyclic aromatic system of six to sixty carbon atoms, and the term "C₆-C₆₀ arylene group" as used herein refers to a divalent group having a carbocyclic aromatic system of six to sixty carbon atoms. In embodiments, the C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, or an ovalenyl group. When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system that has one to sixty carbon atoms and further includes, in addition to the carbon atoms, at least one heteroatom as a ring-forming atom. The term "C₁-C₆₀ heteroarylene group" as used herein refers to a divalent group having a heterocyclic aromatic system that has one to sixty carbon atoms and further includes, in addition to the carbon atoms, at least one heteroatom as a ring-forming atom. In embodiments, the C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, or a naphthyridinyl group. When the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group having two or more rings condensed with each other, only carbon atoms (e.g., eight to sixty carbon atoms) as ring-forming atoms, and no aromaticity in its molecular structure when considered as a whole. In embodiments, the monovalent non-aromatic condensed polycyclic group may include an indenyl group, a fluorenyl group, a spiro-bifluorenyl group, a benzofluorenyl group, an indenophenanthrenyl group, or an indeno anthracenyl group. The term "divalent non-aromatic condensed polycyclic group" as used herein refers to a divalent group having the same structure as that of the monovalent non-aromatic condensed polycyclic group.

The term "monovalent non-aromatic condensed heteropolycyclic group" as used herein refers to a monovalent group that has two or more rings condensed with each other, further includes, in addition to carbon atoms (e.g., one to sixty carbon atoms), at least one heteroatom as a ring-forming atom, and has no aromaticity in its molecular structure when considered as a whole. In embodiments, the monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, or a benzothienodibenzothiophenyl group. The term "divalent non-aromatic condensed heteropolycyclic group" as used herein refers to a divalent group having the same structure as that of the monovalent non-aromatic condensed heteropolycyclic group.

The term "C₆-C₆₀ aryloxy group" as used herein refers to -OA₁₀₂ (where A₁₀₂ is the C₆-C₆₀ aryl group), and the term "C₆-C₆₀ arylthio group" as used herein refers to -SA₁₀₃ (where A₁₀₃ is the C₆-C₆₀ aryl group).

The term "C₇-C₆₀ arylalkyl group" as used herein refers to -A₁₀₄A₁₀₅ (where A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (where A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group,-Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof.

The term "heteroatom" as used herein refers to any atom other than a carbon atom and a hydrogen atom. In embodiments, the heteroatom may include O, S, N, P, Si, B, Ge, Se, or any combinations thereof.

The term "transition metal" used herein includes hafnium (Hf), tantalum (Ta), tungsten (W), rhenium (Re), osmium (Os), iridium (Ir), platinum (Pt), gold (Au), or the like.

"Ph" as used herein refers to a phenyl group, "Me" as used herein refers to a methyl group, "Et" as used herein refers to an ethyl group, "tert-Bu" or "Bu^{t}" as used herein refers to a tert-butyl group, and "OMe" as used herein refers to a methoxy group.

The term "biphenyl group" as used herein refers to "a phenyl group that is substituted with a phenyl group." In other words, the "biphenyl group" may be a substituted phenyl group having a C₆-C₆₀ aryl group as a substituent.

The term "terphenyl group" as used herein refers to "a phenyl group substituted with a biphenyl group." The "terphenyl group" is a substituted phenyl group having, as a substituent, a C₆-C₆₀ aryl group substituted with a C₆-C₆₀ aryl group.

* and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. In an embodiment, the x-axis, y-axis, and z-axis may describe axes that are orthogonal to each other, or may describe axes that are in different directions that are not orthogonal to each other, for example.

### <Synthesis Embodiment 1: Synthesis of Compound P1-1>

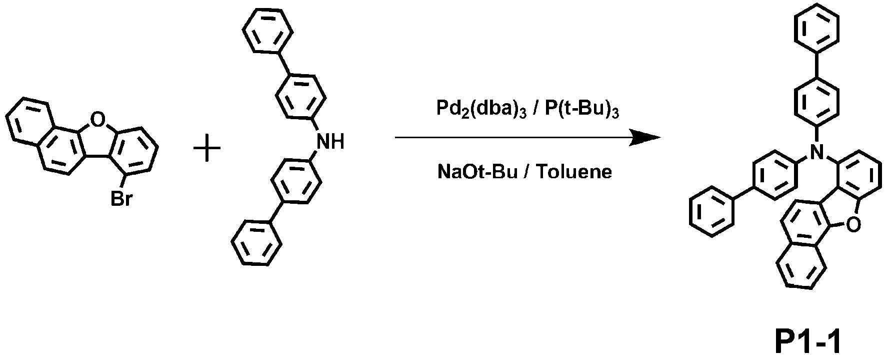

In a round-bottom flask, 7-bromonaphtho[1,2-b]benzofuran (5.0 g, 16.8 millimoles (mmol)), di([1,1'-biphenyl]-4-yl)amine (5.4 g, 16.8 mmol), Pd₂(dba)₃ (0.46 g, 0.50 mmol), P(t-Bu)₃ (0.20 g, 1.01 mmol), NaOt-Bu (3.2 g, 33.7 mmol), and toluene (84 milliliters (mL)) were added, and the reaction was carried out at 60 °C. After completion of the reaction, an extraction process was performed using CH₂Cl₂ and water, and an organic layer thus extracted was dried with MgSO₄ and concentrated. Afterwards, the concentrate was separated by silica gel column, and recrystallized to obtain 6.8 grams (g) of Compound P1-1 (Yield: 75 %).

### FD-MS value of Compound P1-1: m/z=537.21 (C₄₀H₂₇NO=537.66)

### <Synthesis Embodiment 2: Synthesis of Compound P1-8>

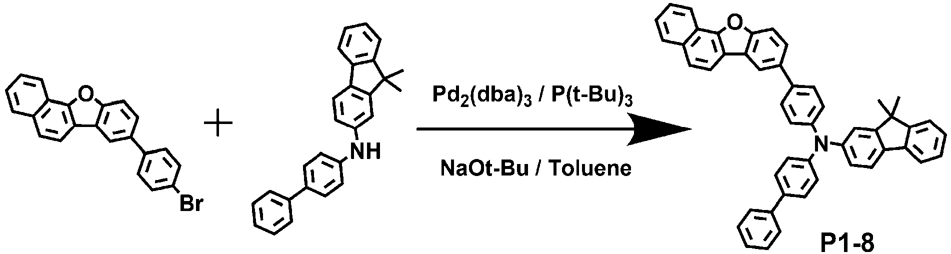

In a round-bottom flask, 8-(4-bromophenyl)naphtho[1,2-b]benzofuran (5.0 g, 13.4 mmol), N-([1,1'-biphenyl]-4-yl)-9,9-dimethyl-9H-fluoren-2-amine (4.8 g, 13.4 mmol), Pd₂(dba)₃ (0.37 g, 0.40 mmol), P(t-Bu)₃ (0.16 g, 0.80 mmol), NaOt-Bu (2.6 g, 26.8 mmol), and toluene (67 mL) were added, and the same procedure as in the synthesis of Compound P1-1 was carried out to obtain 6.8 g of Compound P1-8 (Yield: 78 %).

### FD-MS value of Compound P1-8: m/z=653.27 (C₄₉H₃₅NO=653.83)

### <Synthesis Embodiment 3: Synthesis of Compound P1-12>

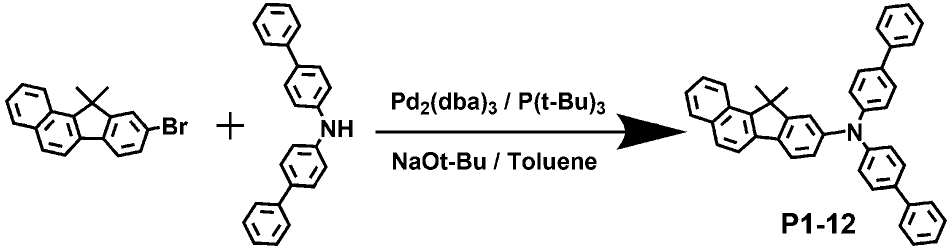

In a round-bottom flask, 9-bromo-11,11-dimethyl-11H-benzo[a]fluorene (5.0 g, 15.5 mmol), di([1,1'-biphenyl]-4-yl)amine (5.0 g, 15.5 mmol), Pd₂(dba)₃ (0.42 g, 0.46 mmol), P(t-Bu)₃ (0.19 g, 0.93 mmol), NaOt-Bu (3.0 g, 30.9 mmol), and toluene (77 mL) were added, and the same procedure as in the synthesis of Compound P1-1 was carried out to obtain 6.5 g of Compound P1-12 (Yield: 74 %).

### FD-MS value of Compound P1-12: m/z=563.26 (C₄₃H₃₃N=563.74)

### <Synthesis Embodiment 4: Synthesis of Compound P1-22>

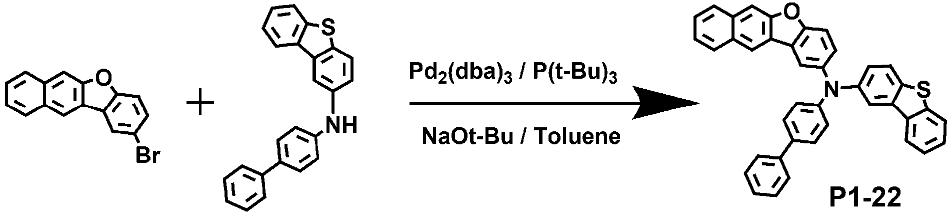

In a round-bottom flask, 2-bromonaphtho[2,3-b]benzofuran (5.0 g, 16.8 mmol), N-([1,1'-biphenyl]-4-yl)dibenzo[b,d]thiophen-2-amine (5.9 g, 16.8 mmol), Pd₂(dba)₃ (0.46 g, 0.50 mmol), P(t-Bu)₃ (0.20 g, 1.01 mmol), NaOt-Bu (3.2 g, 33.7 mmol), and toluene (84 mL) were added, and the same procedure as in the synthesis of Compound P1-1 was carried out to obtain 7.5 g of Compound P1-22 (Yield: 79 %).

### FD-MS value of Compound P1-22: m/z=567.17 (C₄₀H₂₅NOS=567.71)

### <Synthesis Embodiment 5: Synthesis of Compound P1-24>

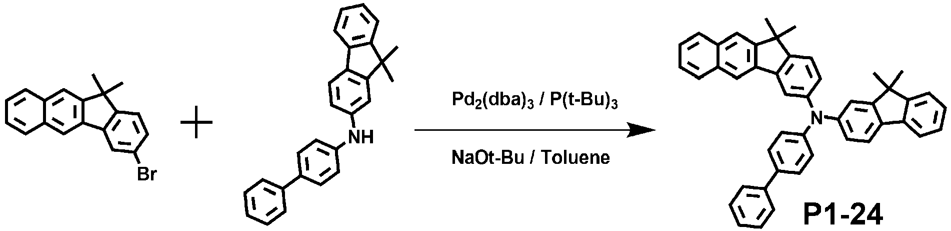

In a round-bottom flask, 3-bromo-11,11-dimethyl-11H-benzo[b]fluorene (5.0 g, 15.5 mmol), N-([1,1'-biphenyl]-4-yl)-9,9-dimethyl-9H-fluoren-2-amine (5.6 g, 15.5 mmol), Pd₂(dba)₃ (0.42 g, 0.46 mmol), P(t-Bu)₃ (0.19 g, 0.93 mmol), NaOt-Bu (3.0 g, 30.9 mmol), and toluene (77 mL) were added, and the same procedure as in the synthesis of Compound P1-1 was carried out to obtain 7.2 g of Compound P1-24 (Yield: 77 %).

### FD-MS value of Compound P1-24: m/z=603.29 (C₄₆H₃₇N=603.81)

### <Synthesis Embodiment 6: Synthesis of Compound P1-56>

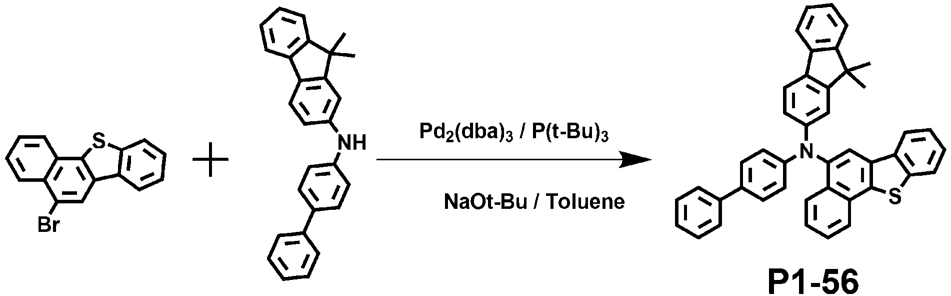

In a round-bottom flask, 5-bromobenzo[b]naphtho[2,1-d]thiophene (5.0 g, 16.0 mmol), N-([1,1'-biphenyl]-4-yl)-9,9-dimethyl-9H-fluoren-2-amine (5.8 g, 16.0 mmol), Pd₂(dba)₃ (0.44 g, 0.48 mmol), P(t-Bu)₃ (0.19 g, 0.96 mmol), NaOt-Bu (3.1 g, 31.9 mmol), and toluene (80 mL) were added, and the same procedure as in the synthesis of Compound P1-1 was carried out to obtain 6.4 g of Compound P1-56 (Yield: 68 %).

### FD-MS value of Compound P1-56: m/z=593.22 (C₄₃H₃₁NS=593.79)

### <Synthesis Embodiment 7: Synthesis of Compound P1-90>

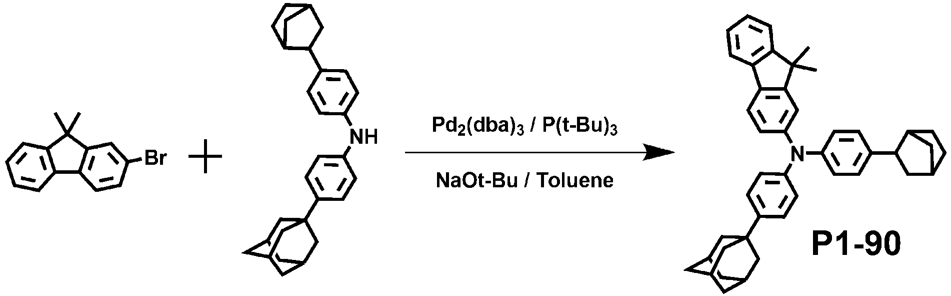

In a round-bottom flask, 2-bromo-9,9-dimethyl-9H-fluorene (5.0 g, 18.3 mmol), 4-((3r,5r,7r)-adamantan-1-yl)-N-(4-(bicyclo[2.2.1]heptan-2-)phenyl)aniline (6.7 g, 18.3 mmol), Pd₂(dba)₃ (0.50 g, 0.55 mmol), P(t-Bu)₃ (0.22 g, 1.10 mmol), NaOt-Bu (3.5 g, 36.6 mmol), and toluene (92 mL) were added, and the same procedure as in the synthesis of Compound P1-1 was carried out to obtain 7.3 g of Compound P1-90 (Yield: 68 %).

### FD-MS value of Compound P1-90: m/z=589.37 (C₄₄H₄₇N=589.87)

### <Synthesis Embodiment 8: Synthesis of Compound P2-1>

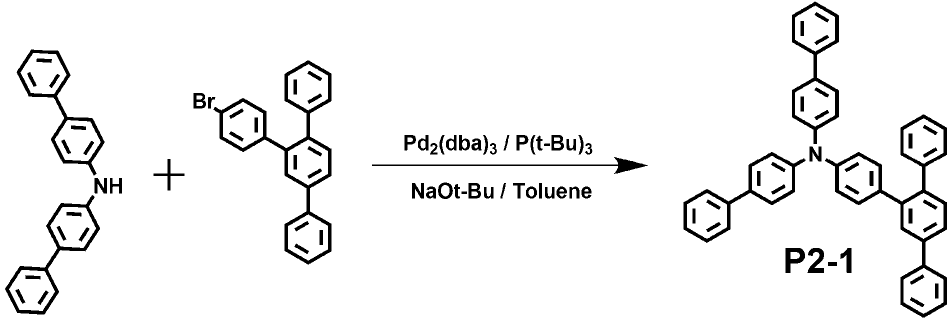

In a reaction vessel, 5.00 g of di([1,1'-biphenyl]-4-yl)amine, 6.59 g of 4-bromo-5'-phenyl-1,1':2',1'-terphenyl, 50 ml of toluene, 1.79 g of NaOt-Bu, 0.13 g of P(t-Bu)₃ (50 wt% toluene solution), and 0.07 g of palladium acetate(II) were added, and the mixed solution was stirred for 3 hours under heating reflux. Silica gel and activated clay were added to the reaction solution at 10 g each, and the resulting mixture was stirred for 10 minutes and filtered through Celite at 80 °C. 180 ml of acetone was added to the concentrated filtrate, and recrystallization was performed thereon to obtain a solid. The obtained solid was purified by column chromatography using a mixed solvent of n-heptane/dichloromethane. The concentrated solid was dissolved in 20 ml of dichloromethane, followed by addition of 200 ml of n-heptane and recrystallization, to obtain 5.4 g (Yield: 56 %) of white solid, Compound P2-1.

The structure of the obtained white powder was identified by detecting 35 hydrogen signals measured by ¹H-NMR (DMSO-d₆)).

δ (ppm) = 7.80-7.72 (4H), 7.67-7.62 (8H), 7.53-7.40 (8H), 7.36-7.28 (5H), 7.21-7.09 (8H), 6.98 (2H).

### <Synthesis Embodiment 9: Synthesis of Compound P2-2>

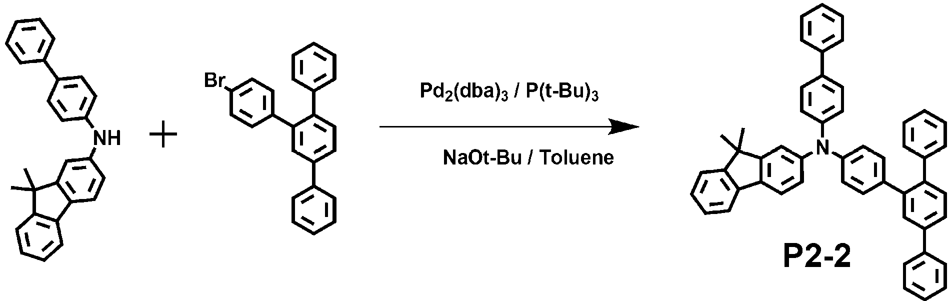

In a reaction flask, 6.10 g of N-([1,1'-biphenyl]-4-yl)-9,9-dimethyl-9H-fluoren-2-amine, 7.15 g of 4-bromo-5'-phenyl-1,1':2',1'-terphenyl, 61 ml of toluene, 1.95 g of NaOt-Bu, 0.14 g of P(t-Bu)₃ (50 wt% toluene solution), and 0.08 g of palladium acetate(II) were added, and the mixed solution was stirred for 3 hours under heating reflux. Silica gel and activated clay were added to the reaction solution at 10 g each, and the resulting mixture was stirred for 10 minutes and filtered through Celite at 80 °C. 220 ml of acetone was added to the concentrated filtrate, and a crystallization process was performed thereon to obtain a solid. The obtained solid was purified by column chromatography using a mixed solvent of n-heptane/dichloromethane. The concentrated solid was dissolved in 22 ml of dichloromethane, followed by addition of 220 ml of n-heptane and recrystallization, to obtain 2.2 g (Yield: 19 %) of white solid, Compound P2-2.

The structure of the obtained white powder was identified by detecting 39 hydrogen signals measured by ¹H-NMR (DMSO-d₆).

δ (ppm) = 7.73-7.56 (10H), 7.49-7.42 (10H), 7.35-7.22 (6H), 7.11-7.07 (4H), 6.98-6.96 (3H).

### <Synthesis Embodiment 10: Synthesis of Compound P2-3>

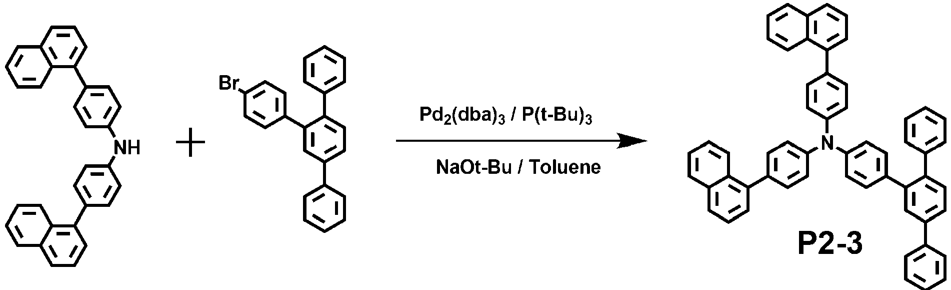

In a reaction vessel, 9.00 g of N,N-bis[4-(naphthalen-1-yl)phenyl]amine, 9.87 g of 4-bromo-5'-phenyl-1,1':2',1'-terphenyl, 90 ml of toluene, 2.46 g of NaOt-Bu, 0.17 g of P(t-Bu)₃ (50 wt% toluene solution), and 0.10 g of palladium acetate(II) were added, and the mixed solution was stirred for 3 hours under heating reflux. Silica gel and activated clay were added to the reaction solution at 15 g each, and the resulting mixture was stirred for 10 minutes and filtered through Celite at 80 °C. The filtrate was concentrated and purified by column chromatography using a mixed solvent of n-heptane/dichloromethane. The concentrated solid was dissolved in 30 ml of dichloromethane, followed by addition of 300 ml of methanol dropwise, to obtain a solid. The obtained solid was purified as described above to obtain 13.0 g (Yield: 83.9 %) of a white solid, Compound P2-3.

The structure of the obtained white powder was identified by detecting 39 hydrogen signals measured by ¹H-NMR (DMSO-d₆).

δ (ppm) = 8.02-7.94 (6H), 7.82-7.75 (4H), 7.64-7.47 (15H), 7.43-7.21 (12H), 7.16-7.10 (2H).

### <Synthesis Embodiment 11: Synthesis of Compound P2-4>

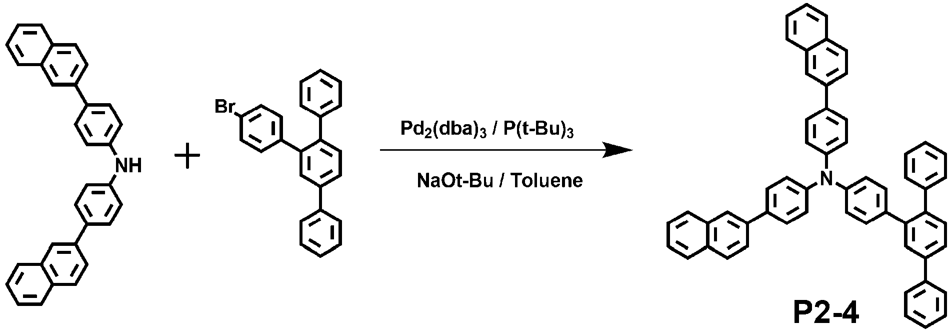

In a reaction vessel, 10.00 g of N,N-bis[4-(naphthalen-2-yl)phenyl]amine, 10.97 g of 4-bromo-5'-phenyl-1,1':2',1'-terphenyl, 100 ml of toluene, 2.74 g of NaOt-Bu, 0.19 g of P(t-Bu)₃ (50 wt% toluene solution), and 0.11 g of palladium acetate(ll) were added, and the mixed solution was stirred for 3 hours under heating reflux. Silica gel and activated clay were added to the reaction solution at 17 g each, and the resulting mixture was stirred for 10 minutes and filtered through Celite at 80 °C. 340 ml of acetone was added to the concentrated filtrate, and recrystallization was performed thereon to obtain a solid. The obtained solid was dissolved in 34 ml of toluene, followed by addition of 340 ml of acetone and recrystallization, to obtain 8.3 g(Yield: 48 %) of white solid, Compound P2-4 .

The structure of the obtained white powder was identified by detecting 39 hydrogen signals measured by ¹H-NMR (DMSO-d₆).

δ (ppm) = 8.21 (2H), 8.01-7.92 (6H), 7.88-7.74 (10H), 7.57-7.48 (7H), 7.43-7.30 (4H), 7.28-7.17 (8H), 7.03 (2H).

### <Synthesis Embodiment 12: Synthesis of Compound P2-5>

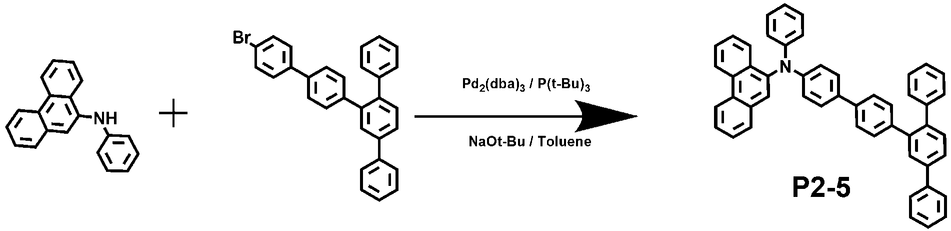

In a reaction vessel, 5.0 g of N-phenyl-phenanthren-9-amine, 9.4 g of 4"'-bromo-4'-phenyl-[1,1':2',1":4",1"'-quaterphenyl], 50 ml of toluene, 2.1 g of NaOt-Bu, 0.15 g of P(t-Bu)₃(50wt% toluene solution), and 0.08 g of palladium acetate(II) were added, and the mixed solution was stirred all day under heating reflux. The resulting solution was cooled to 80 °C, and then filtered through Celite to remove impurities. The filtrate was concentrated, and the residues were purified by column chromatography to obtain 3.8 g (Yield: 32 %) of white solid, Compound P2-5.

The structure of the obtained white powder was identified by detecting 35 hydrogen signals measured by ¹H-NMR (DMSO-d₆).

δ (ppm) = 8.73-8.82 (2H), 8.12-8.16 (1H), 7.40-7.82 (18H), 7.18-7.32 (13H), 7.02-7.08 (1H).

### <Synthesis Embodiment 13: Synthesis of Compound P2-11>

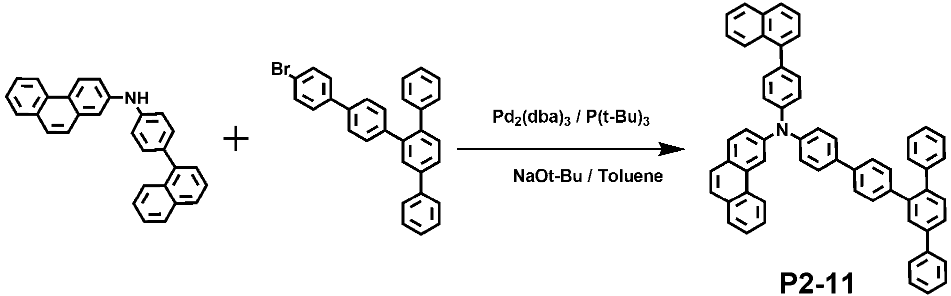

In a reaction vessel, 6.0 g of N-(4-(naphthalen-1-yl)phenyl)-phenanthren-2-amine, 7.3 g of 4‴-bromo-4'-phenyl-[1,1':2',1":4",1"'-quaterphenyl], 60 ml of toluene, 1.7 g of NaOt-Bu, 0.12 g of P(t-Bu)₃ (50 wt% toluene solution), and 0.07 g of palladium acetate(II) were added, and the mixed solution was stirred all day under heating reflux. The resulting solution was cooled to 80 °C, and then filtered through Celite to remove impurities. The filtrate was concentrated, and the residues were purified by column chromatography to obtain 8.0 g (Yield: 68 %) of yellow-white solid, Compound P2-11.

The structure of the obtained white powder was identified by detecting 41 hydrogen signals measured by ¹H-NMR (CDCl₃).

δ (ppm) = 8.62-8.67 (2H), 8.11-8.16 (1H), 7.88-7.99 (3H), 7.27-7.79 (35H).

### <Synthesis Embodiment 14: Synthesis of Compound P2-34>

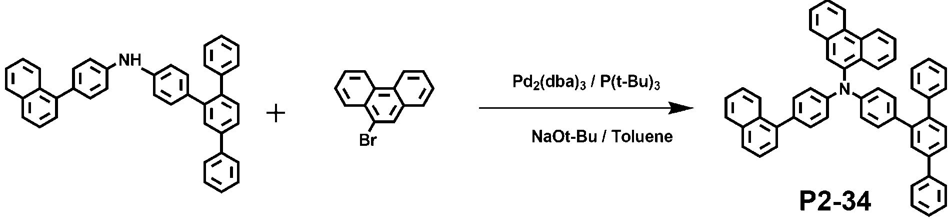

In a reaction vessel, 8.5 g of N-(4-(naphthalen-1-yl)phenyl)-5'-phenyl-[1,1':2',1"-terphenyl]-4-amine, 4.8 g of 9-bromophenanthrene, 85 ml of toluene, 2.3 g of NaOt-Bu, 0.3 g of P(t-Bu)₃ (50 wt% toluene solution), and 0.1 g of palladium acetate(II) were added, and the mixed solution was stirred for 3 hours under heating reflux. The resulting solution was filtered through Celite at 80 °C. Active clay and silica gel were added to the filtrate, and then adsorption purification was performed thereon. The filtrate was concentrated, and the residues were crystallized with acetone to obtain 8.3 g (Yield: 73 %) of white solid, Compound P2-34.

The structure of the obtained white powder was identified by detecting 37 hydrogen signals measured by ¹H-NMR (DMSO-d₆).

δ (ppm) = 8.75-8.84 (2H), 8.16-8.20 (1H), 8.05-8.09 (1H), 7.91-7.95 (3H), 7.12-7.78 (30H).

### <Synthesis Embodiment 15: Synthesis of Compound P2-35>

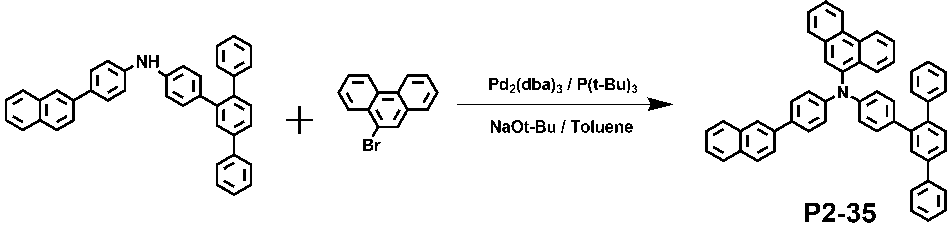

In a reaction vessel, 8.0 g of N-(4-(naphthalen-2-yl)phenyl)-5'-phenyl-[1,1':2',1"-terphenyl]-4-amine, 4.5 g of 9-bromophenanthrene, 80 ml of toluene, 2.2 g of NaOt-Bu, 0.2 g of P(t-Bu)₃ (50 wt% toluene solution), and 0.1 g of palladium acetate(II) were added, and the mixed solution was stirred for 3 hours under heating reflux. The resulting solution was filtered through Celite at 80 °C. Active clay and silica gel were added to the filtrate, and then adsorption purification was performed thereon. The filtrate was concentrated, and the residues were crystallized with toluene-acetone to obtain 6.6 g (Yield: 62 %) of white solid, Compound P2-35.

The structure of the obtained white powder was identified by detecting 37 hydrogen signals measured by ¹H-NMR (DMSO-d₆).

δ (ppm) = 8.74-8.83 (2H), 8.12-8.17 (1H), 8.30 (1H), 7.21-7.94 (29H), 7.08-7.14 (4H).

### <Synthesis Embodiment 16: Synthesis of Compound P2-45>

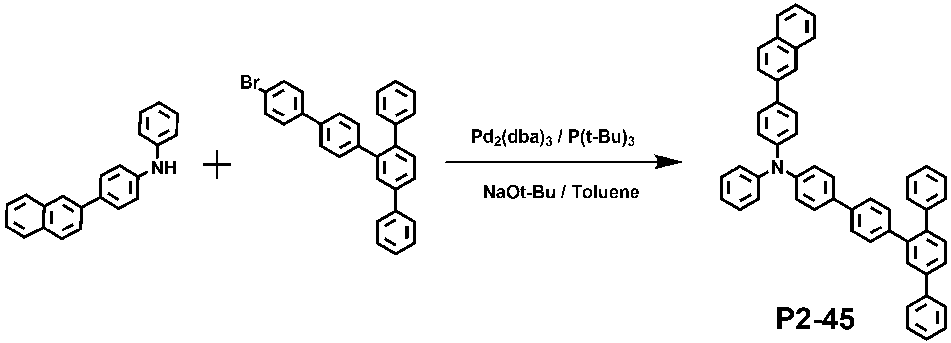

In a reaction vessel, 6.0 g of 4-(naphthalen-2-yl)-N-phenylaniline, 10.3 g of 4‴-bromo-4'-phenyl-[1,1':2',1":4",1‴-quaterphenyl], 100 ml of toluene, 2.3 g of NaOt-Bu, 0.2 g of P(t-Bu)₃ (50 wt% toluene solution), and 0.1 g of palladium acetate(II) were added, and the mixed solution was stirred overnight under heating reflux. The resulting mixture was cooled and filtered, and the filtrate was then concentrated to obtain a crude product. The obtained crude product was purified by column chromatography to obtain 7.1 g (Yield: 51.7 %) of white solid, Compound P2-45.

The structure of the obtained white powder was identified by detecting 37 hydrogen signals measured by ¹H-NMR (CDCl₃).

δ (ppm) = 8.04 (1H), 7.91 (3H), 7.73 (5H), 7.56 (2H), 7.51 (7H), 7.42 (1H), 7.39-7.18 (15H), 7.10 (1H).

### <Synthesis Embodiment 17: Synthesis of Compound P2-47>

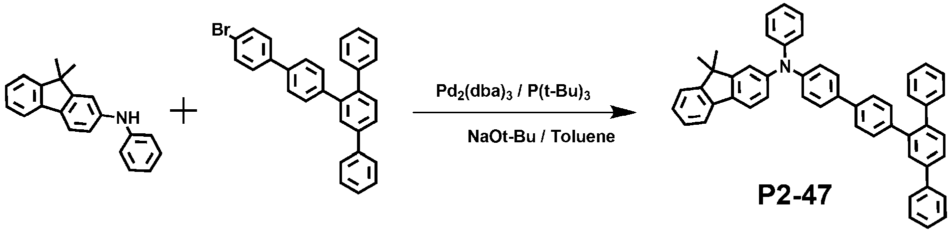

In a reaction vessel, 4.5 g of 9,9-dimethyl-N-phenyl-9H-fluoren-2-amine, 7.6 g of 4‴-bromo-4'-phenyl-[1, 1':2', 1":4",1‴-quaterphenyl], 45 ml of toluene, 1.8 g of NaOt-Bu, 0.13 g of P(t-Bu)₃ (50 wt% toluene solution), and 0.07 g of palladium acetate(II) were added, and the mixed solution was stirred all day under heating reflux. The resulting mixture was cooled to room temperature, washed with water, and dried with anhydrous magnesium sulphate. Such a desiccant was removed by filtration, and the filtrate was concentrated. The residues were purified by column chromatography to obtain 6.5 g (Yield: 62 %) of white solid, Compound P2-47.

The structure of the obtained white powder was identified by detecting 39 hydrogen signals measured by 1H-NMR (DMSO-d₆).

δ (ppm) = 7.51-7.80 (13H), 7.22-7.48 (18H), 7.08-7.16(2H), 7.50 (6H).

### <Synthesis Embodiment 18: Synthesis of Compound P2-48>

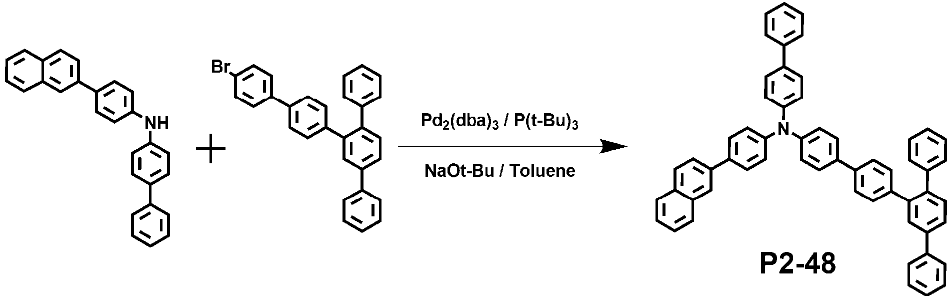

In a reaction vessel, 5.1 g of N-(4-(naphthalen-2-yl)phenyl)-[1,1'-biphenyl]-4-amine, 6.7 g of 4‴-bromo-4'-phenyl-[1,1':2',1":4",1‴-quaterphenyl], 51 ml of toluene, 1.6 g of NaOt-Bu, 0.11 g of P(t-Bu)₃ (50 wt% toluene solution), and 0.06 g of palladium acetate(II) were added, and the mixed solution was stirred all day under heating reflux. The resulting solution was cooled to room temperature, and then filtered through Celite to remove impurities. Activated carbon was added to the filtrate, and adsorption purification was performed thereon. The filtrate was concentrated, and the residues were crystallized with toluene-acetone to obtain 7.6 g (Yield: 74 %) of white solid, Compound P2-48.

The structure of the obtained white powder was identified by detecting 41 hydrogen signals measured by ¹H-NMR (DMSO-d₆).

δ (ppm) = 8.11(1H), 7.91-7.98 (3H), 7.65-7.83 (9H), 7.28-7.62 (28H)

### <Evaluation Embodiment 1: Evaluation of hole mobility of first compound>

The hole mobility of the first compounds synthesized according to Synthesis Embodiments above could be confirmed using a hole only device (HOD), and the HOD could be identified by the following device configuration.

HAT-CN was vacuum-deposited to a thickness of 5 nm on an ITO layer (anode) formed on a glass substrate to form a hole injection layer, the first compound was vacuum-deposited to a thickness of 300 nm on the hole injection layer to form a hole transport layer, HAT-CN was vacuum-deposited to a thickness of 1 nm on the hole transport layer to form a hole blocking layer, and Al was deposited to a thickness of 100 nm on the hole blocking layer, thereby forming a cathode.

The HOD of the device manufactured as described above could measure the current density-voltage (J-V) curve using the I-V-L measuring device. Here, the hole mobility could be identified by calculation based on the space charge limited current (SCLC) on the J-V curve. The SCLC refers to the interval where the main emission begins and the charge is trapped in a space charge state.

The hole mobility (µ) could be calculated by the Child's Law and the Poole-Frenkel Emission Equation. Equation 1 is the Child's Law, and Equation 2 is the Poole-Frenkel Emission Equation: <Equation 1> $J = \frac{9}{8} εμ \frac{{v}^{2}}{{d}^{3}}$
J: current density (A/cm²)
ε: dielectric constant of organic material (2.655 X 10⁻¹³ A•s/V•cm)
d: thickness of thin film (cm)
V: applied voltage (V) <Equation 2> $μ \left(E\right) = {μ}_{0} exp \left(β\sqrt{E}\right)$
E: electric field (V/cm)
µ₀: Poole-frenkel mobility (cm²/V•s)
β: Poole-frenkel constant
Equation 1 and Equation 2 may be combined and summarized as shown in Equation 3: <Equation 3> $ln \frac{J}{{E}^{2}} = β \sqrt{E} + ln \left(\frac{9}{8}ε\frac{{μ}_{0}}{d}\right)$

Here, β and µ₀ vary depending on the material and configuration of the device, and thus may be calculated by referring to the J-V curve. Therefore, by introducing calculated β and µ₀ into Equation 2, the hole mobility (µ), that is µ(E) in Equation 2, may be calculated. Here, the range of hole mobility may be calculated for the SCLC interval, or the hole mobility (µ₀) at zero field (i.e., when E=0) may be calculated, to determine the hole mobility of materials. In the specification, the hole mobility of the compounds refers to the hole mobility at zero field.

**<Table 1>**

| First compound | Hole mobility (cm/V•S) |
|---|---|
| P1-1 | 1.1x10⁻³ |
| P1-8 | 8.2x10⁻⁴ |
| P1-12 | 6.0x10⁻⁴ |
| P1-22 | 9.7x10⁻⁴ |
| P1-24 | 1.5x10⁻³ |
| P1-56 | 5.5x10⁻⁴ |
| P1-90 | 7.9x10⁻⁴ |
| P1-A | 4.6x10⁻⁴ |

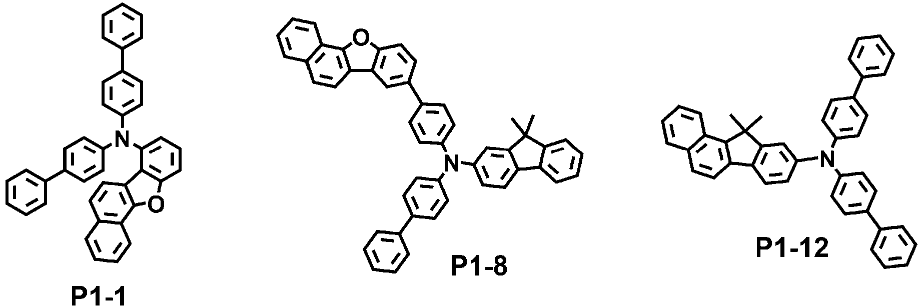

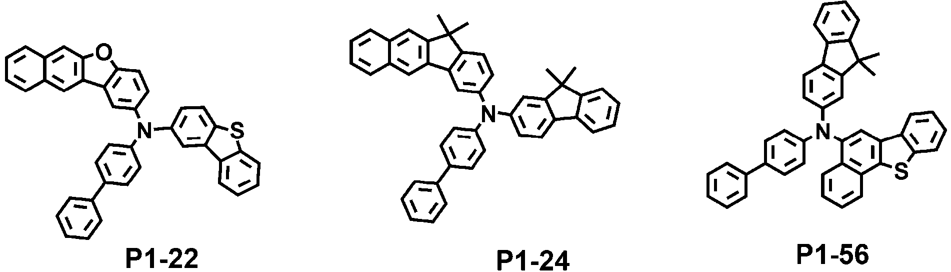

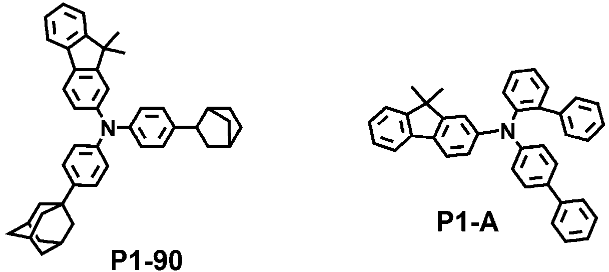

### <Evaluation Embodiment 2: Evaluation of energy level characteristics of second compound>

Using the DFT method (B3LYP/6-31g(D)) of the Gaussian program, the HOMO energy level, LUMO energy level and T1 energy level of the second compounds synthesized according to Synthesis Embodiments above were measured, and the results are shown in Table 2.

**<Table 2>**

| Compound | HOMO energy level [eV] | LUMO energy level [eV] | T1 energy level [eV] |
|---|---|---|---|
| P2-1 | -5.12 | -1.29 | 2.63 |
| P2-2 | -5.04 | -1.29 | 2.59 |
| P2-3 | -5.15 | -1.40 | 2.41 |
| P2-4 | -5.11 | -1.50 | 2.45 |
| P2-5 | -5.20 | -1.46 | 2.39 |
| P2-11 | -5.12 | -1.42 | 2.53 |
| P2-34 | -5.16 | -1.41 | 2.41 |
| P2-35 | -5.17 | -1.51 | 2.38 |
| P2-45 | -5.13 | -1.45 | 2.45 |
| P2-47 | -5.06 | -1.37 | 2.60 |
| P2-48 | -5.11 | -1.47 | 2.44 |
| P2-A | -5.13 | -1.35 | 2.58 |
| P2-B | -5.06 | -1.49 | 2.42 |

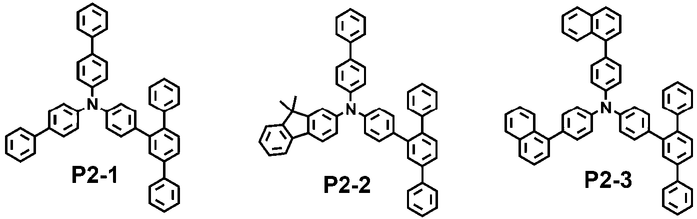

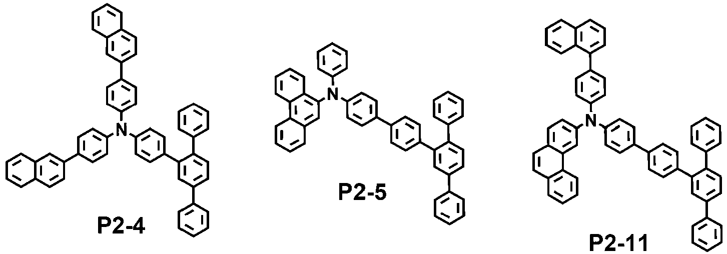

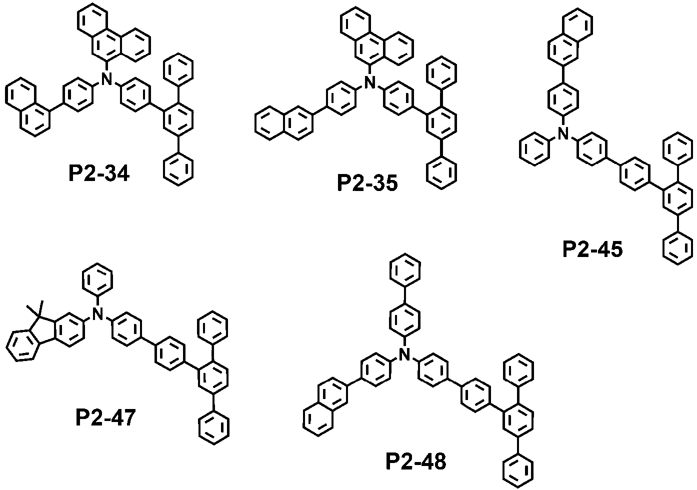

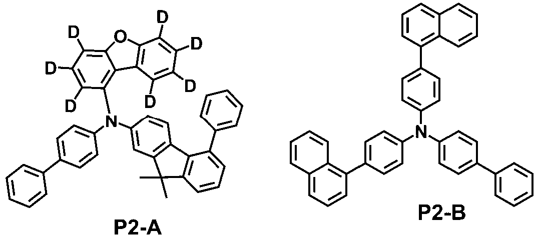

### <Embodiment 1: Manufacture of red light-emitting device>

2-TNATA was vacuum-deposited on an ITO layer (anode) formed on a glass substrate to form a hole injection layer having a thickness of 70 nm, and NPB was vacuum-deposited on the hole injection layer to form a hole transport layer having a thickness of 70 nm. Compound P1-1 was vacuum-deposited on the hole transport layer to form a first emission auxiliary layer having a thickness of 70 nm, and Compound P2-1 was vacuum-deposited on the first emission auxiliary layer to form a second emission auxiliary layer having a thickness of 5 nm.

Next, CBP as a host material and PD9 as a dopant material were used at a weight ratio of 95:5 and applied on the second emission auxiliary layer to form an emission layer having a thickness of 40 nm.

Next, BAlq was vacuum-deposited on the emission layer to form a hole blocking layer having a thickness of 5 nm, and BeBq₂ was vacuum-deposited on the hole blocking layer to form an electron transport layer having a thickness of 30 nm. Afterwards, LiF was deposited on the electron transport layer to form an electron injection layer having a thickness of 0.2 nm, and Al was deposited to a thickness of 150 nm on the electron injection layer, thereby forming a cathode.

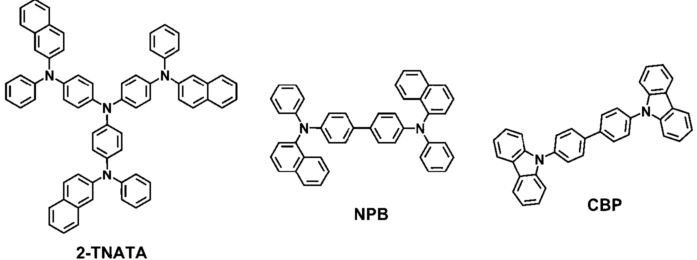

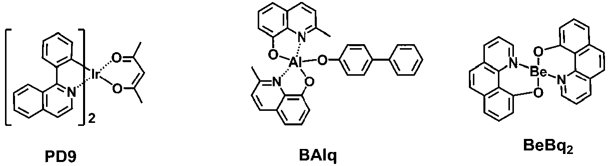

### <Embodiments 2 to 41 and Comparative Examples 19 and 20>

Except for the use of the compounds listed in Table 3 as the first emission auxiliary layer and the second emission auxiliary layer, light-emitting devices were manufactured in the same manner as in Embodiment 1.

### <Comparative Examples 1 to 18>

Except that the compounds listed in Table 3 were used alone to form a single emission auxiliary layer, light-emitting devices were manufactured in the same manner as in Embodiment 1.

### <Evaluation Embodiment 3: Evaluation of characteristics of light-emitting device>

For the light-emitting devices manufactured in Embodiments 1 to 41 and Comparative Examples 1 and 20, the electric luminescence ("EL") characteristics were measured by applying forward bias direct current and using Photoresearch's PR-650, and the lifespan (T₉₅) was measured using McScience's lifespan measuring device at a reference luminance of 2500 candela per square meter (cd/m²). The lifespan (T₉₅) is a measure of the time (hr) taken for the luminance to reach 95% of the initial luminance. The results of the measurement are shown in Table 3. In Table 3, EAL1 and EAL2 denote the first emission auxiliary layer and the second emission auxiliary layer, respectively, CE1 to CE20 denote Comparative Examples 1 to 20, respectively, E1 to E41 denote Embodiments 1 to 41, respectively, DV denotes driving voltage, CD denotes current density, LM denotes luminance, LME denotes luminescence efficiency, and LS denotes Lifespan.

**<Table 3>**

| | EAL1 | EAL2 | DV (V) | CD | LM | LME | LS |
|---|---|---|---|---|---|---|---|
| | | | | (mA/cm²) | (cd/m²) | (cd/A) | (T₉₅, hr) |
| CE1 | P1-1 | | 5.3 | 12.6 | 2500 | 19.8 | 93 |
| CE2 | P1-8 | | 5.4 | 12.9 | 2500 | 19.4 | 89 |
| CE3 | P1-12 | | 5.5 | 13.2 | 2500 | 18.9 | 80 |
| CE4 | P1-22 | | 5.4 | 13.0 | 2500 | 19.2 | 80 |
| CE5 | P1-24 | | 5.3 | 12.8 | 2500 | 19.5 | 91 |
| CE6 | P1-56 | | 5.6 | 13.5 | 2500 | 18.5 | 83 |
| CE7 | P1-90 | | 5.4 | 12.7 | 2500 | 19.7 | 87 |
| CE8 | P2-1 | | 5.5 | 13.3 | 2500 | 18.8 | 101 |
| CE9 | P2-2 | | 5.4 | 13.0 | 2500 | 19.2 | 103 |
| CE10 | P2-3 | | 5.5 | 13.2 | 2500 | 18.9 | 95 |
| CE11 | P2-4 | | 5.5 | 13.4 | 2500 | 18.7 | 81 |
| CE12 | P2-5 | | 5.6 | 13.6 | 2500 | 18.4 | 84 |
| CE13 | P2-11 | | 5.5 | 13.1 | 2500 | 19.1 | 90 |
| CE14 | P2-34 | | 5.6 | 13.5 | 2500 | 18.5 | 89 |
| CE15 | P2-35 | | 5.6 | 13.5 | 2500 | 18.5 | 78 |
| CE16 | P2-45 | | 5.5 | 13.0 | 2500 | 19.2 | 82 |
| CE17 | P2-47 | | 5.4 | 12.8 | 2500 | 19.5 | 90 |
| CE18 | P2-48 | | 5.5 | 12.9 | 2500 | 19.4 | 85 |
| CE19 | P1-A | P2-A | 5.7 | 14.0 | 2500 | 17.8 | 67 |
| CE20 | P1-1 | P2-B | 5.0 | 11.3 | 2500 | 22.2 | 84 |
| E1 | P1-1 | P2-1 | 4.8 | 9.4 | 2500 | 26.6 | 132 |
| E2 | | P2-2 | 4.7 | 9.9 | 2500 | 25.3 | 121 |
| E3 | | P2-3 | 4.8 | 9.3 | 2500 | 26.9 | 115 |
| E4 | | P2-4 | 4.8 | 9.6 | 2500 | 26.0 | 103 |
| E5 | | P2-5 | 4.9 | 9 | 2500 | 27.8 | 108 |
| E6 | P1-12 | P2-11 | 4.9 | 9.5 | 2500 | 26.3 | 113 |
| E7 | | P2-34 | 4.9 | 9.4 | 2500 | 26.6 | 120 |
| E8 | | P2-35 | 4.9 | 9.4 | 2500 | 26.6 | 98 |
| E9 | | P2-45 | 4.8 | 9.3 | 2500 | 26.9 | 118 |
| E10 | | P2-47 | 4.7 | 9.8 | 2500 | 25.5 | 127 |
| E11 | | P2-48 | 4.8 | 9.5 | 2500 | 26.3 | 114 |
| E12 | P1-22 | P2-1 | 4.9 | 10.1 | 2500 | 24.8 | 120 |
| E13 | | P2-2 | 4.8 | 9.5 | 2500 | 26.3 | 132 |
| E14 | | P2-11 | 4.9 | 9.7 | 2500 | 25.8 | 108 |
| E15 | | P2-34 | 5 | 9.8 | 2500 | 25.5 | 106 |
| E16 | | P2-48 | 4.9 | 9.9 | 2500 | 25.3 | 101 |
| E17 | P1-22 | P2-3 | 4.8 | 9 | 2500 | 27.8 | 128 |
| E18 | | P2-4 | 4.7 | 9.2 | 2500 | 27.2 | 102 |
| E19 | | P2-45 | 4.8 | 9.4 | 2500 | 26.6 | 100 |
| E20 | | P2-47 | 4.6 | 9.5 | 2500 | 26.3 | 98 |
| E21 | P1-24 | P2-1 | 4.6 | 9.3 | 2500 | 26.9 | 126 |
| E22 | | P2-2 | 4.5 | 9.5 | 2500 | 26.3 | 119 |
| E23 | | P2-3 | 4.6 | 8.9 | 2500 | 28.1 | 104 |
| E24 | | P2-4 | 4.6 | 9.0 | 2500 | 27.8 | 99 |
| E25 | | P2-5 | 4.7 | 8.9 | 2500 | 28.1 | 109 |
| E26 | P1-56 | P2-34 | 5 | 9.7 | 2500 | 25.8 | 107 |
| E27 | | P2-35 | 5 | 9.8 | 2500 | 25.5 | 101 |
| E28 | | P2-45 | 5 | 10.1 | 2500 | 24.8 | 104 |
| E29 | | P2-47 | 4.9 | 10.5 | 2500 | 23.8 | 105 |
| E30 | | P2-48 | 4.9 | 9.9 | 2500 | 25.3 | 111 |
| E31 | P1-90 | P2-1 | 4.8 | 8.8 | 2500 | 28.4 | 143 |
| E32 | | P2-2 | 4.7 | 9.1 | 2500 | 27.5 | 132 |
| E33 | | P2-3 | 4.8 | 8.9 | 2500 | 28.1 | 138 |
| E34 | | P2-4 | 4.7 | 9 | 2500 | 27.8 | 120 |
| E35 | | P2-5 | 4.8 | 8.8 | 2500 | 28.4 | 122 |
| E36 | | P2-11 | 4.8 | 9.3 | 2500 | 26.9 | 120 |
| E37 | | P2-34 | 4.8 | 8.9 | 2500 | 28.1 | 124 |
| E38 | | P2-35 | 4.8 | 9 | 2500 | 27.8 | 118 |
| E39 | | P2-45 | 4.8 | 9.1 | 2500 | 27.5 | 127 |
| E40 | | P2-47 | 4.7 | 9.2 | 2500 | 27.2 | 125 |
| E41 | | P2-48 | 4.7 | 9.1 | 2500 | 27.5 | 121 |

Referring to Table 3, it was confirmed that, compared to the light-emitting devices of Comparative Examples 1 and 20, the light-emitting devices of Embodiments 1 to 41 exhibited equivalent or longer lifespan characteristics as well as relatively low driving voltage and relatively high luminescence efficiency characteristics.

According to the embodiments, by including a plurality of emission auxiliary layers, a light-emitting device having relatively low driving voltage, relatively high luminescence efficiency, and long lifespan characteristics may be manufactured. Accordingly, a high-quality electronic apparatus and high-quality electronic equipment may be manufactured by the light-emitting device.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A light-emitting device (10) comprising:
a first electrode (110);
a second electrode (150) facing the first electrode (110); and
an interlayer (130) disposed between the first electrode (110) and the second electrode (150) and including an emission layer, the interlayer including:
a first compound represented by Formula 1 and a second compound represented by Formula 2: 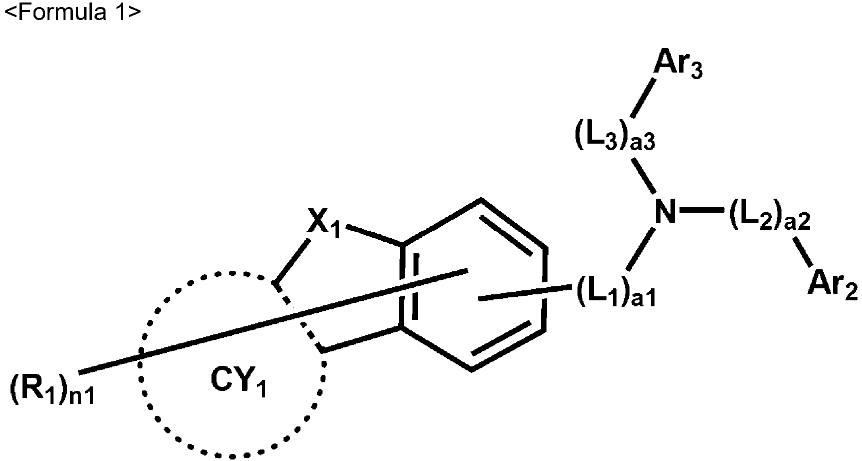 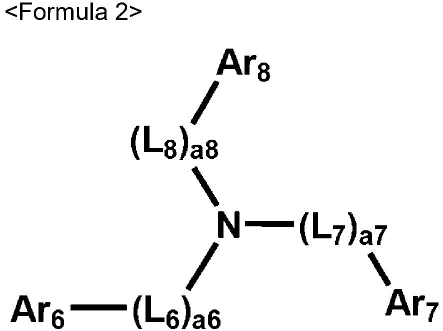 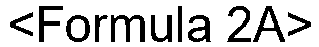 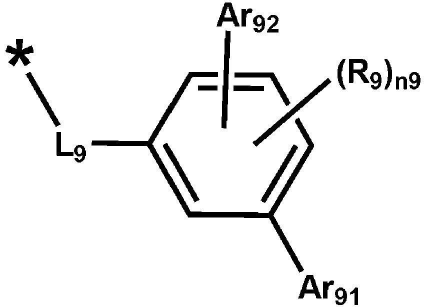
wherein, in the Formulae 1 and 2 and Formula 2A,
CY₁ is a C₃-C₆₀ carbocyclic group or a C₁-C₆₀ heterocyclic group,
X₁ is O, S, C(R₄)(R₅), Si(R₄)(R₅), N(R₄), or P(R₄),
Ar₂, Ar₃, Ar₉₁, and Ar₉₂ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
Ar₆ to Ar₈ are each independently a group represented by the Formula 2A, a C₃-C₆₀ carbocyclic group unsubstituted or substituted with at least one R₁₀ₐ, or a C₁-C₆₀ heterocyclic group unsubstituted or substituted with at least one R₁₀ₐ, provided that at least one of Ar₆ to Ar₈ is the group represented by the Formula 2A,
L₁ to L₃ and L₆ to L₉ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
a1 to a3 and a6 to a8 are each independently an integer from 0 to 3,
when a1 is 0, *-(L₁)ₐ₁-*' is a single bond, when a2 is 0, *-(L₂)ₐ₂-*' is a single bond, when a3 is 0, *-(L₃)ₐ₃-*' is a single bond, when a6 is 0, *-(L₆)ₐ₆-*' is a single bond, when a7 is 0, *-(L₇)ₐ₇-*' is a single bond, and when a8 is 0, *-(L₈)ₐ₈-*' is a single bond,
L₁(s) in a number of a1 are identical to or different from each other, L₂(s) in a number of a2 are identical to or different from each other, L₃(s) in a number of a3 are identical to or different from each other, L₆(s) in a number of a6 are identical to or different from each other, L₇(s) in a number of a7 are identical to or different from each other, and L₈(s) in a number of a8 are identical to or different from each other,
R₁, R₄, R₅, and R₉ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
n1 is an integer from 0 to 10,
n9 is an integer from 0 to 3,
R₁(s) in a number of n1 are identical to or different from each other, and R₉(s) in a number of n9 are identical to or different from each other,
two or more of R₁(s) in the number of n1 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₄ and R₅ are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
two or more of R₉(s) in the number of n9 are optionally bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combinations thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combinations thereof, and
* and *' each indicate a binding site to a neighboring atom.

2. The light-emitting device of claim 1, wherein
the first electrode is an anode,
the second electrode is a cathode,
the interlayer further includes a hole transport region disposed between the first electrode and the emission layer, and
the hole transport region includes the first compound and the second compound, optionally wherein
the hole transport region includes: a hole transport layer; and a plurality of emission auxiliary layers formed between the hole transport layer and the emission layer,
the plurality of emission auxiliary layers include a first emission auxiliary layer next to the hole transport layer and a second emission auxiliary layer next to the emission layer,
the first emission auxiliary layer includes the first compound, and
the second emission auxiliary layer includes the second compound.

3. The light-emitting device of claim 1 or claim 2, wherein the emission layer emits red light.

4. The light-emitting device of any one of claims 1 to 3, wherein:
(i) the first compound has a hole mobility in a range of about 5.1 X 10⁻⁵ centimeter per volt-second to about 1.5 X 10⁻³ centimeter per volt-second; and/or
(ii) the second compound has a T1 energy level in a range of about 2.3 electronvolts to about 3.0 electronvolts.

5. The light-emitting device of any one of claims 1 to 4, wherein the first compound satisfies one of Conditions 1 to 3:
<Condition 1>
at least two of R₁(s) in the number of n1 are bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ;
<Condition 2>
at least one of R₁(s) in the number of n1 is not hydrogen; and
<Condition 3>
X₁ is C(R₄)(R₅) or Si(R₄)(R₅), and
at least one of Ar₂ and Ar₃ is a C₃-C₆₀ cycloalkyl group unsubstituted or substituted with at least one R₁₀ₐ.

6. The light-emitting device of any one of claims 1 to 5, wherein the first compound is represented by Formula 1-1: 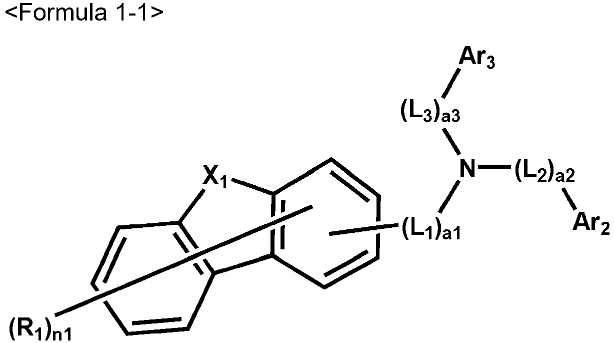 wherein, in the Formula 1-1,
X₁, Ar₂, Ar₃, L₁ to L₃, a1 to a3, R₁, and n1 are as defined in claim 1.

7. The light-emitting device of claim 6, wherein at least two of R₁(s) in the number of n1 in the Formula 1-1 are bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

8. The light-emitting device of claim 6, wherein the first compound is represented by one of Formulae 1-11A to 1-11F, 1-12A to 1-12E, 1-13A to 1-13E, and 1-14A to 1-14F: 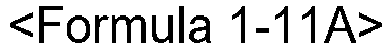 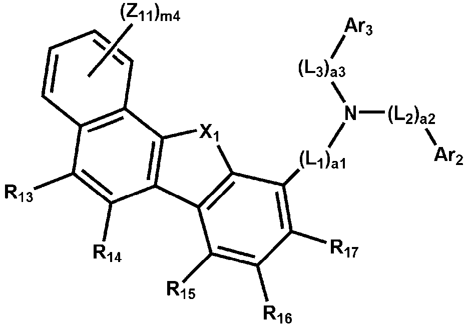 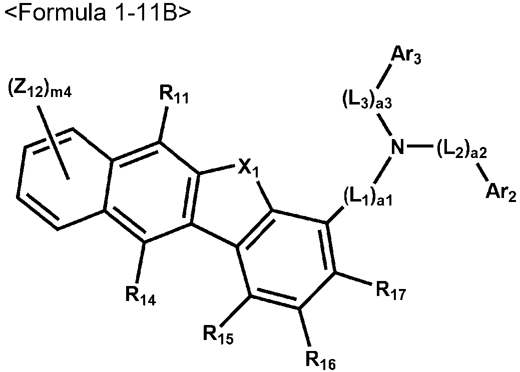 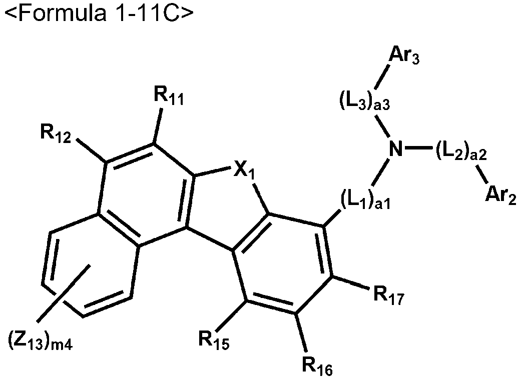 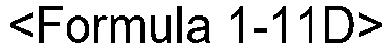 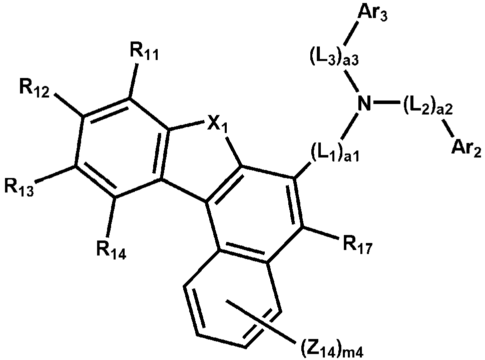 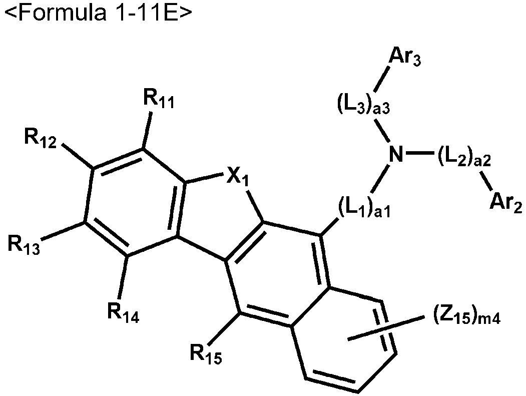 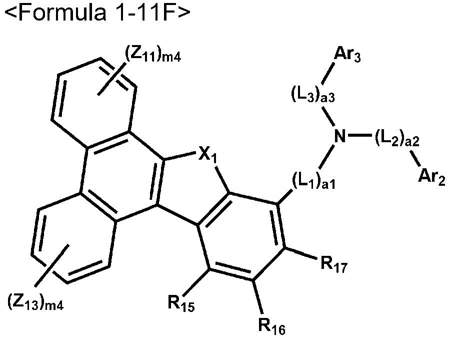 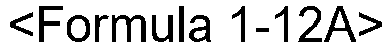 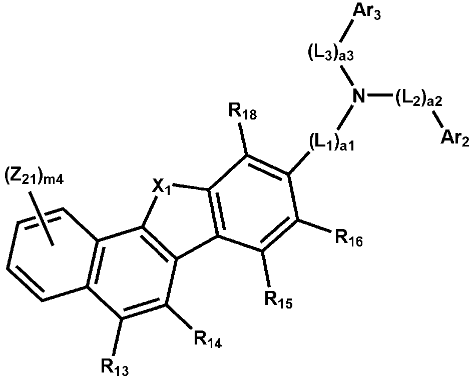 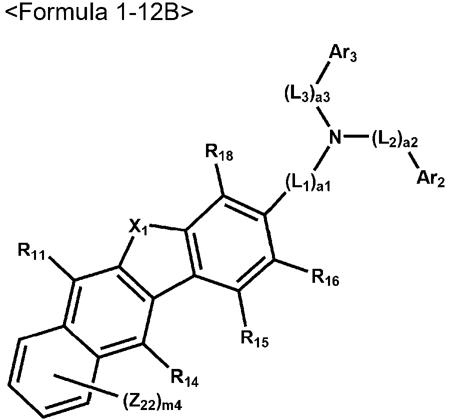 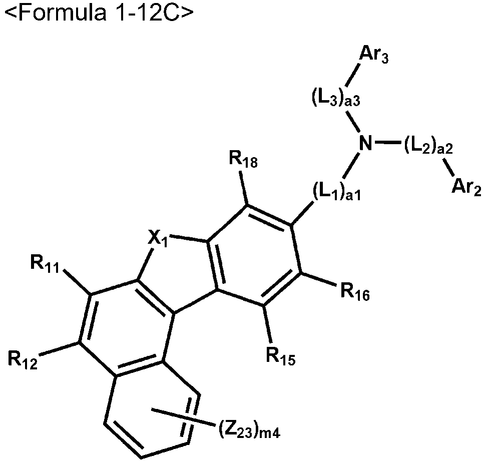 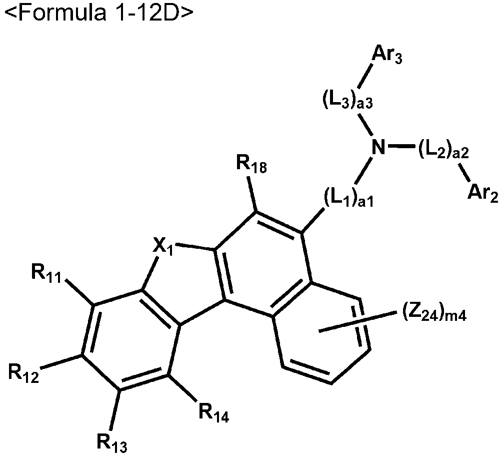 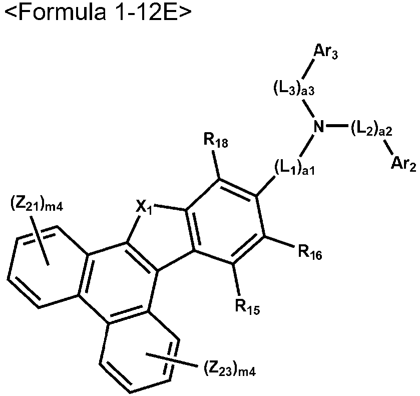 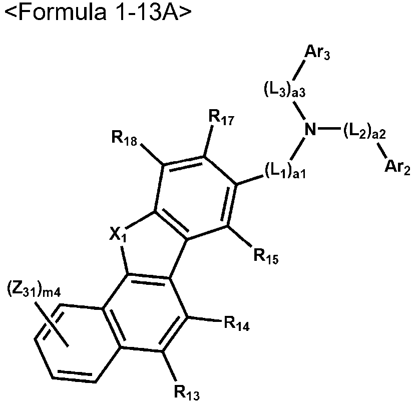 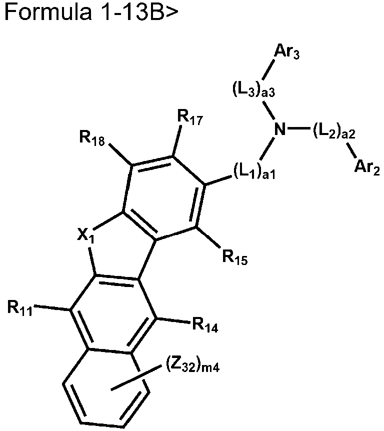 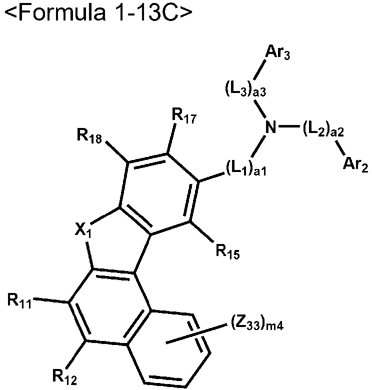 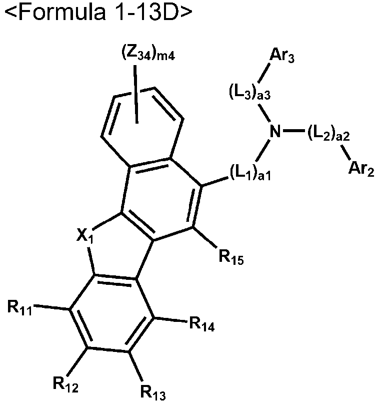 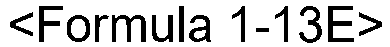 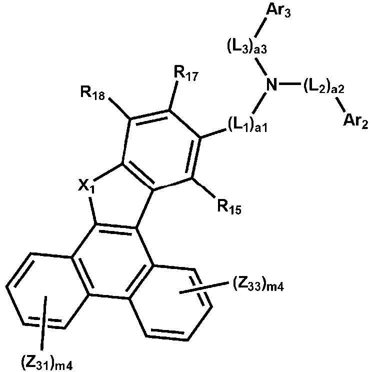 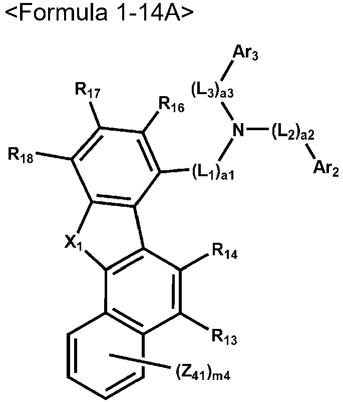 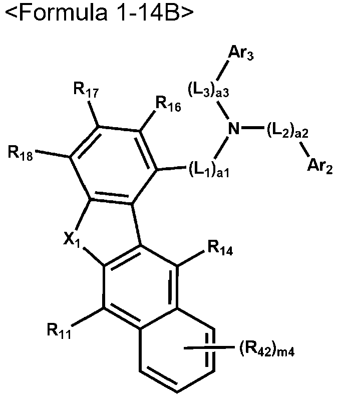 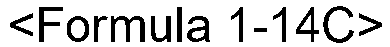 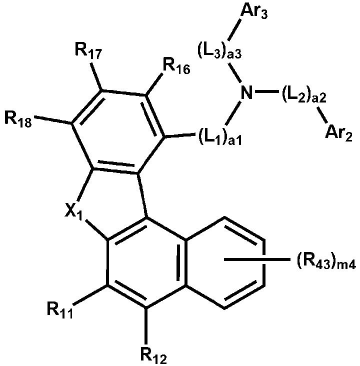 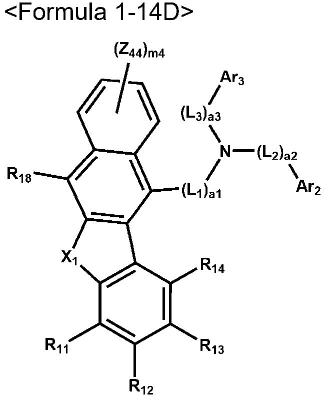 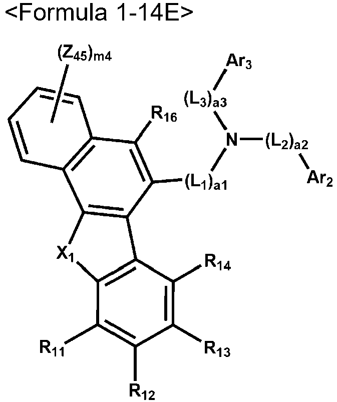 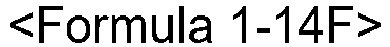 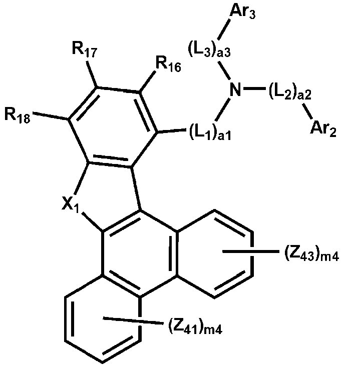
wherein, in the Formulae 1-11A to 1-11F, 1-12A to 1-12E, 1-13A to 1-13E, and 1-14A to 1-14F,
X₁, Ar₂, Ar₃, L₁ to L₃, and a1 to a3 are as defined in claim 1,
R₁₁ to R₁₈ are each defined as for R₁ in claim 1,
Z₁₁ to Z₁₅, Z₂₁ to Z₂₄, Z₃₁ to Z₃₄, and Z₄₁ to Z₄₅ are defined as for R₁₀ₐ in claim 1, and
m4 is an integer from 0 to 4.

9. The light-emitting device of any one of claims 1 to 5, wherein the first compound is represented by one of Formulae 1-31 to 1-34: 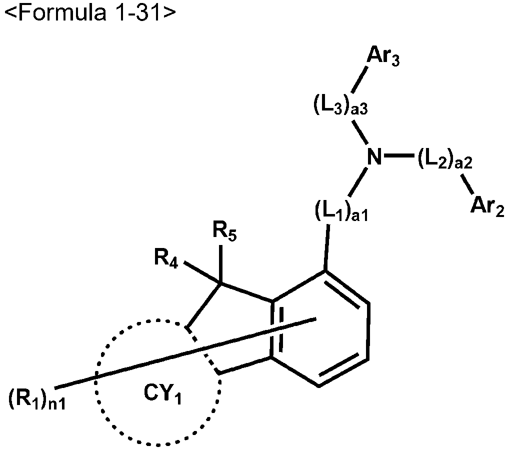 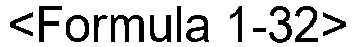 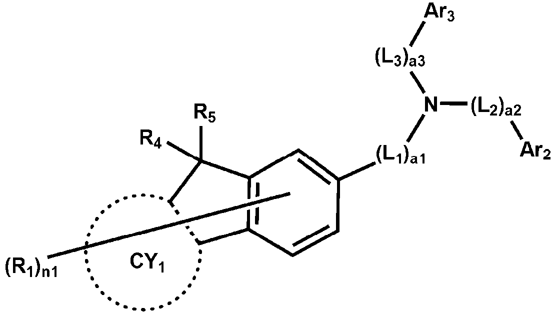 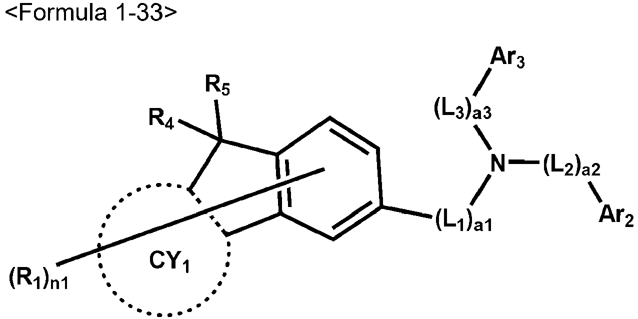 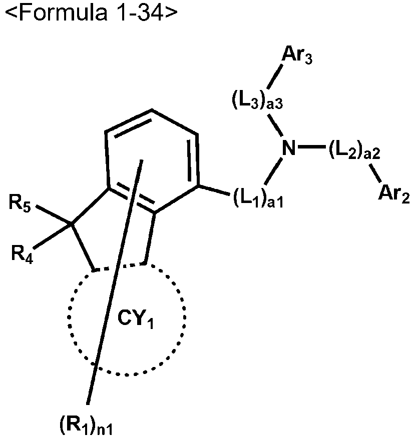 wherein, in the Formulae 1-31 to 1-34,
CY₁, Ar₂, Ar₃, L₁ to L₃, a1 to a3, R₁, R₄, R₅, and n1 are as defined in claim 1, and at least one of Ar₂ and Ar₃ is a C₃-C₃₀ cycloalkyl group unsubstituted or substituted with at least one R₁₀ₐ, optionally wherein,
in the Formulae 1-31 to 1-34,
at least one of Ar₂ and Ar₃ is a group represented by one of Formulae Ar-1 to Ar-7: 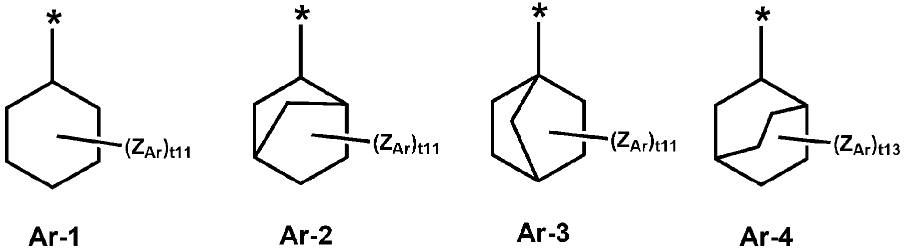 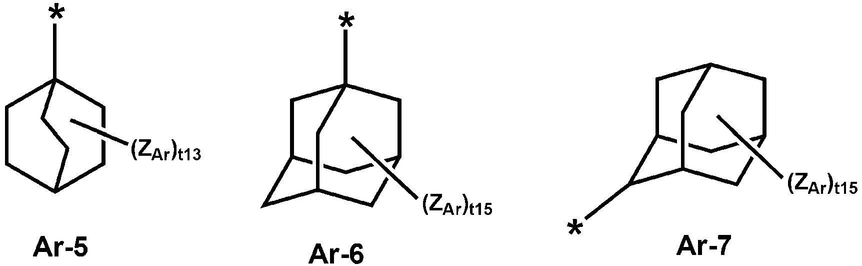 wherein, in the Formulae Ar-1 to Ar-7,
Z_{Ar} is defined in a same manner as R₁₀ₐ in claim 1,
t11 is an integer from 0 to 11,
t13 is an integer from 0 to 13,
t15 is an integer from 0 to 15, and
* indicates a binding site to a neighboring atom.

10. The light-emitting device of claim 1, wherein the first compound is selected from Compounds P1-1 to P1-92:

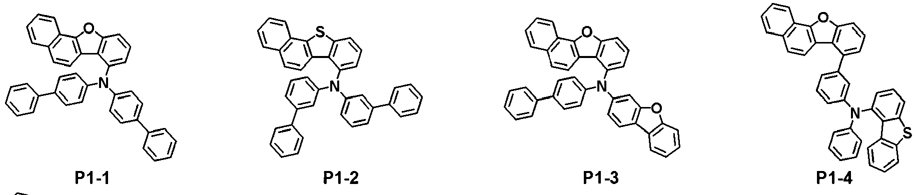

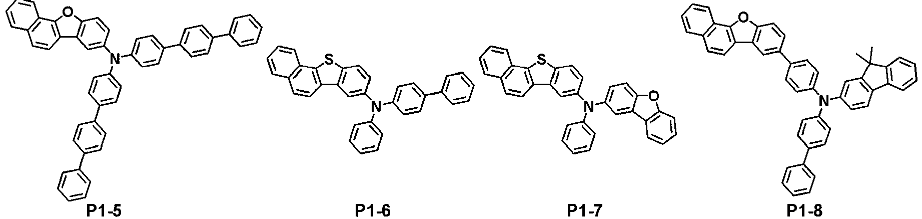

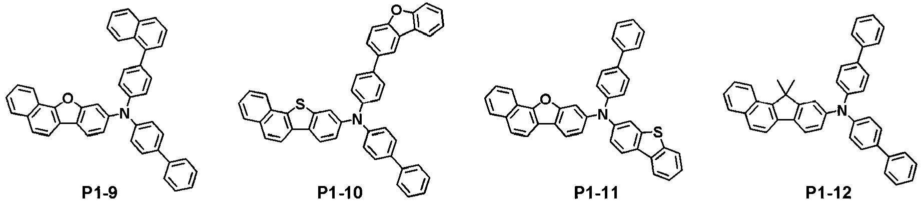

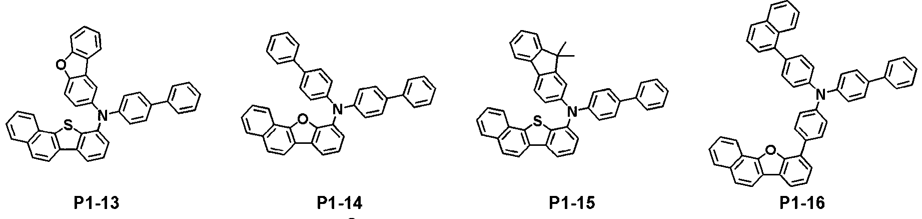

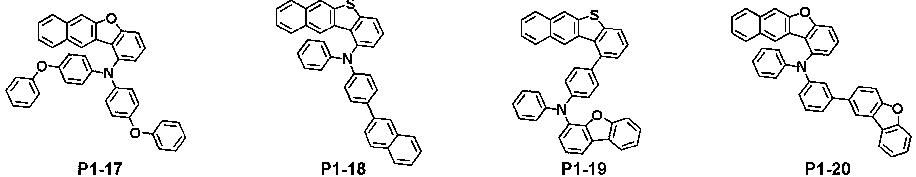

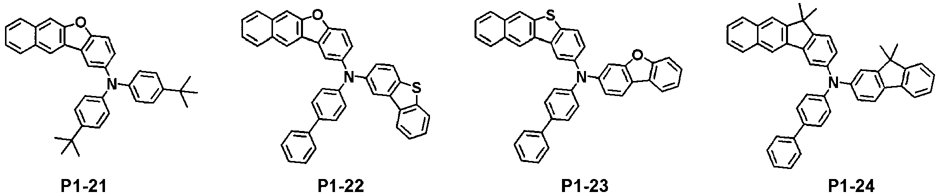

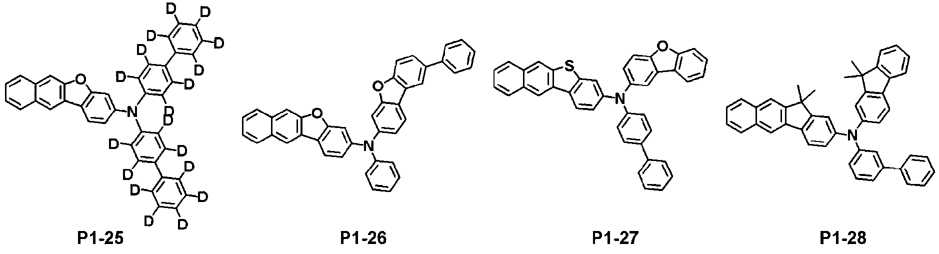

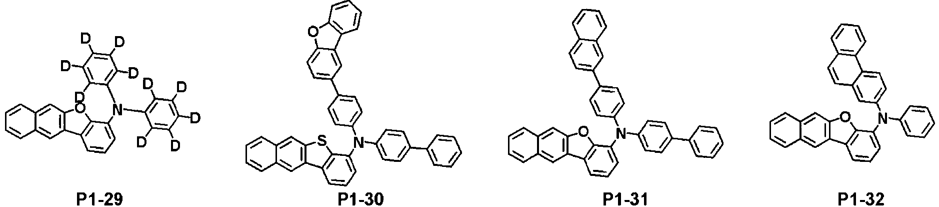

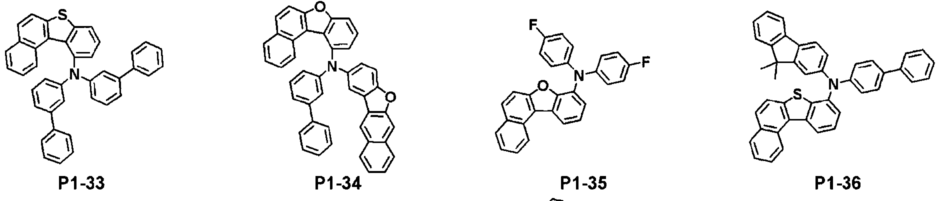

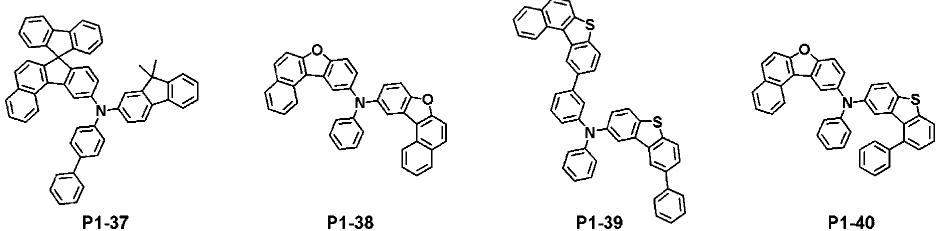

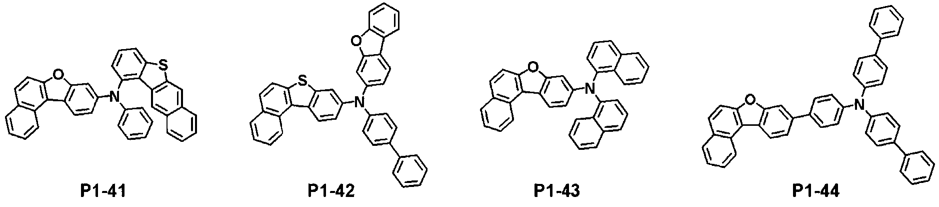

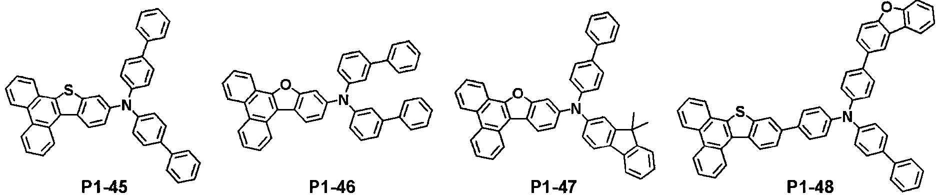

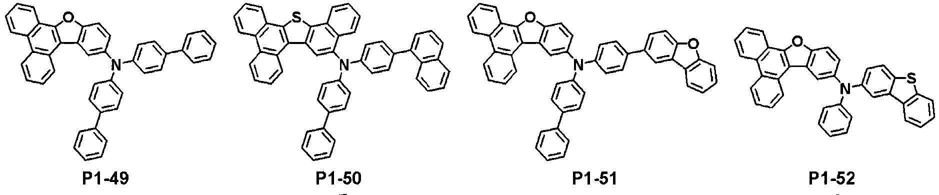

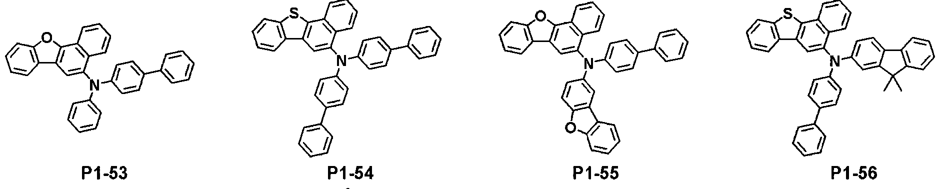

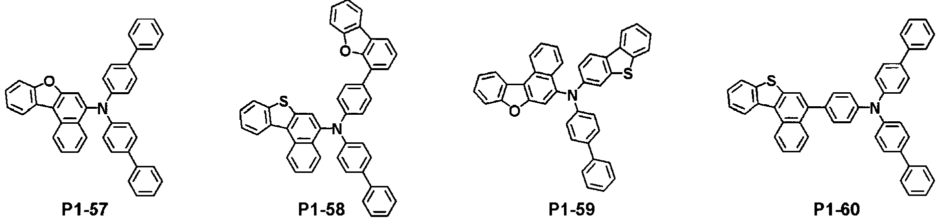

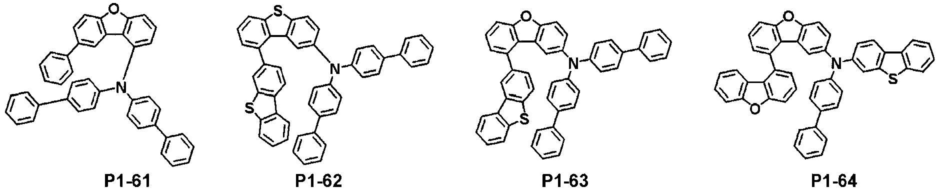

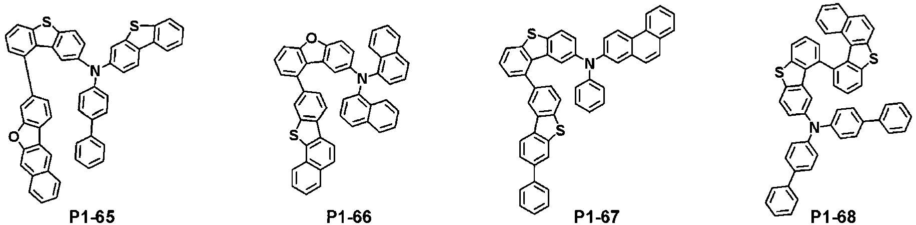

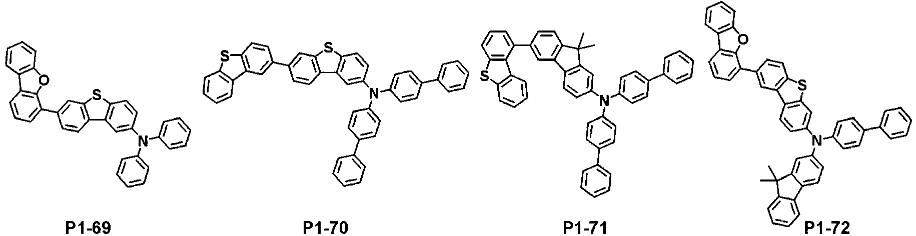

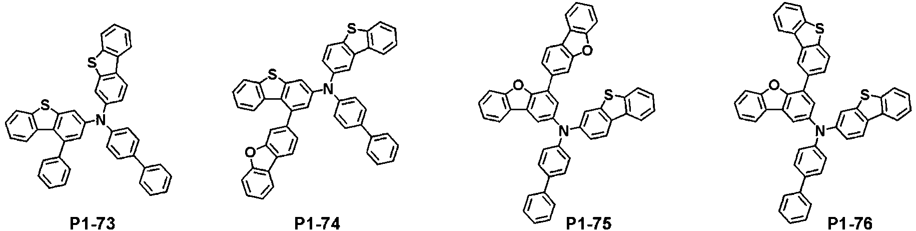

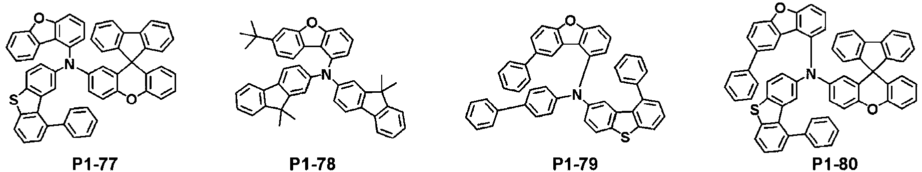

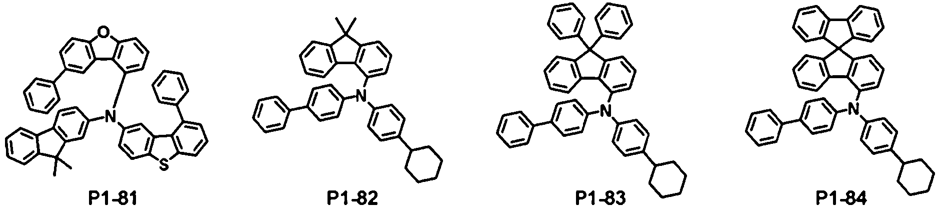

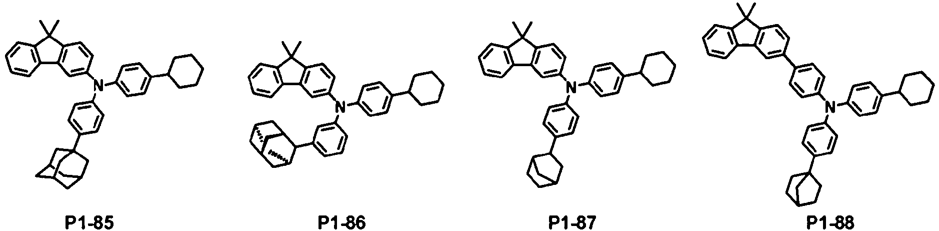

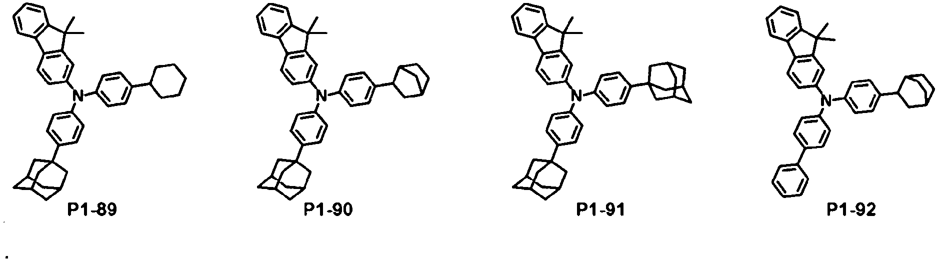

11. The light-emitting device of any one of claims 1 to 10, wherein, in the Formulae 2 and 2A, L₆ to L₉ are each independently a group represented by one of Formulae L-1 to L-13: 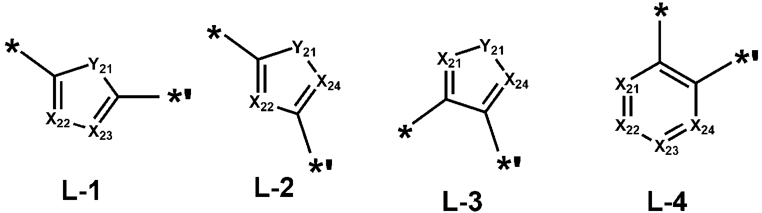 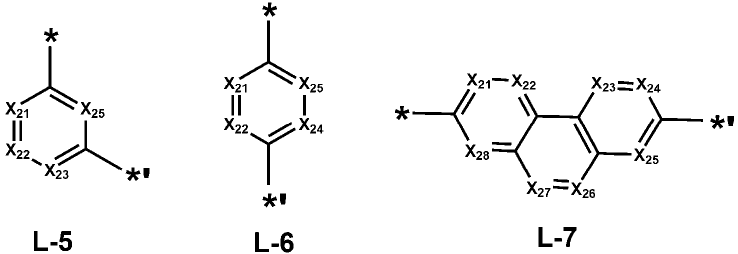 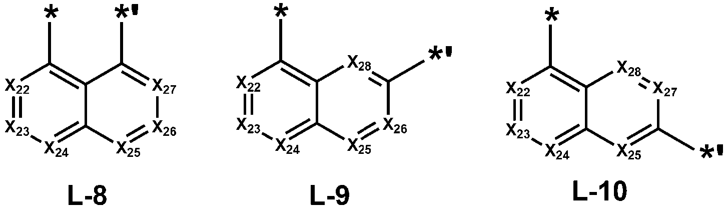 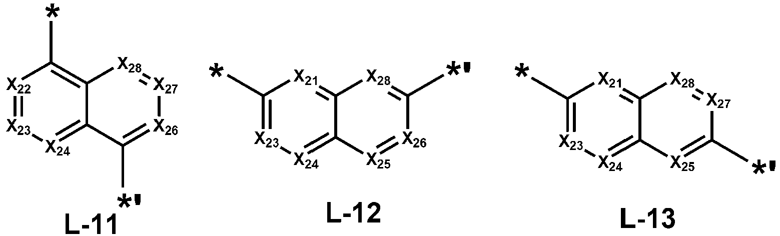 wherein, in the Formulae L-1 to L-13,
Y₂₁ is O or S,
X₂₁ to X₂₈ are each independently N or C(Z_{L}),
Z_{L} is defined in a same manner as R₁₀ₐ in claim 1, and
* and *' each indicate a binding site to a neighboring atom.

12. The light-emitting device of any one of claims 1 to 11, wherein:
(i) in the Formula 2A, Ar₉₁ and Ar₉₂ are each independently a benzene group unsubstituted or substituted with at least one R₁₀ₐ, a naphthalene group unsubstituted or substituted with at least one R₁₀ₐ, an anthracene group unsubstituted or substituted with at least one R₁₀ₐ, a phenanthrene group unsubstituted or substituted with at least one R₁₀ₐ, or a fluorene group unsubstituted or substituted with at least one R₁₀ₐ; and/or
(ii) the group represented by the Formula 2A is represented by one of Formulae 2A-1 to 2A-3: 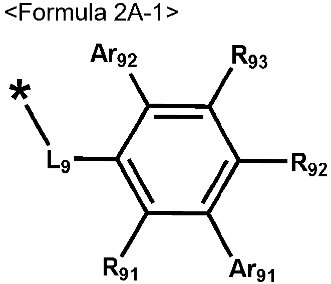 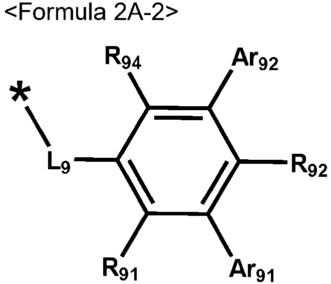 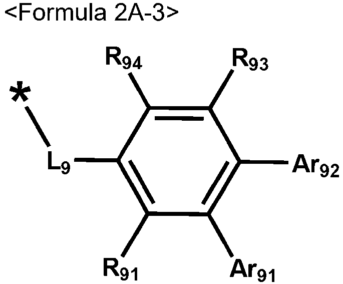
wherein, in the Formulae 2A-1 to 2A-3,
Ar₉₁, Ar₉₂, and L₉ are each as defined in claim 1, R₉₁ to R₉₄ are each defined in a same manner as R₉ in claim 1, and
* indicates a binding site to a neighboring atom.

13. The light-emitting device of any one of claims 1 to 12, wherein the second compound is selected from Compounds P2-1 to P2-51:

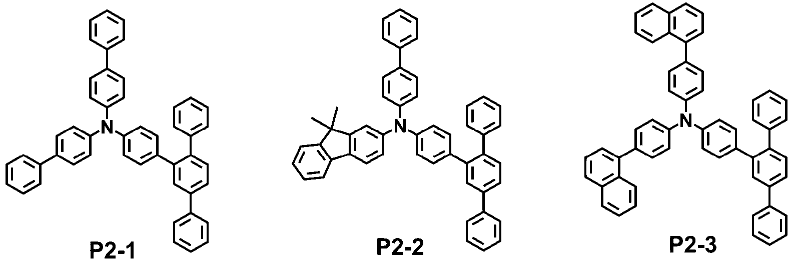

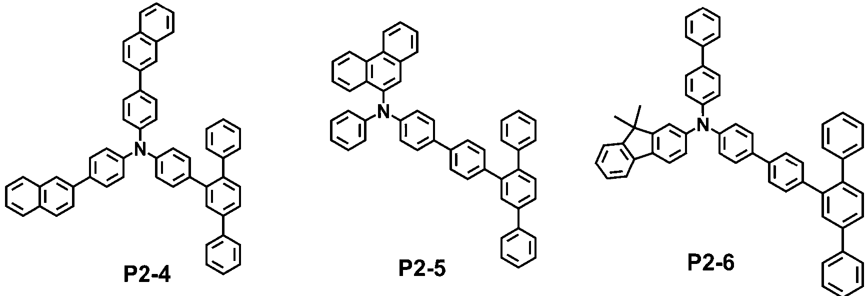

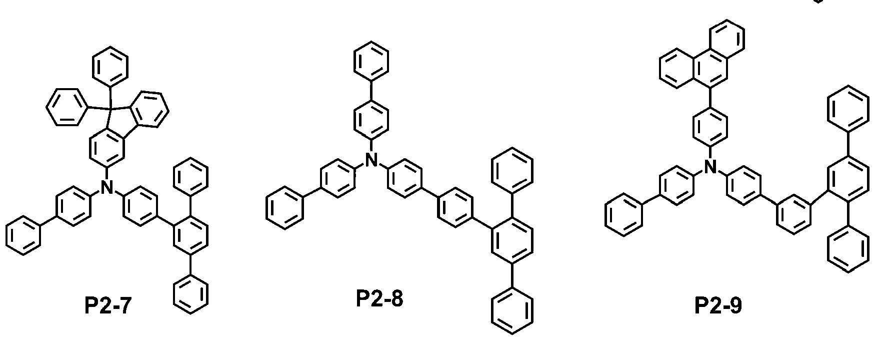

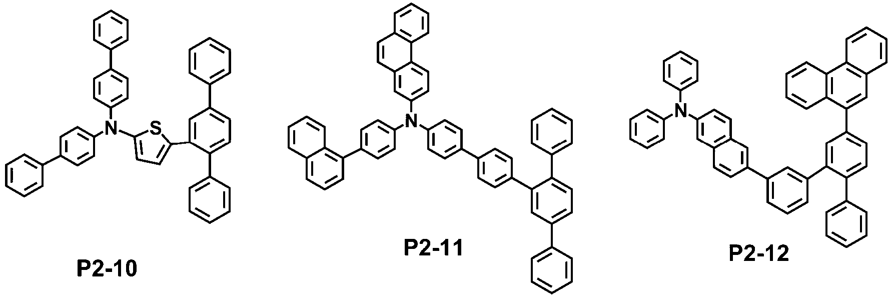

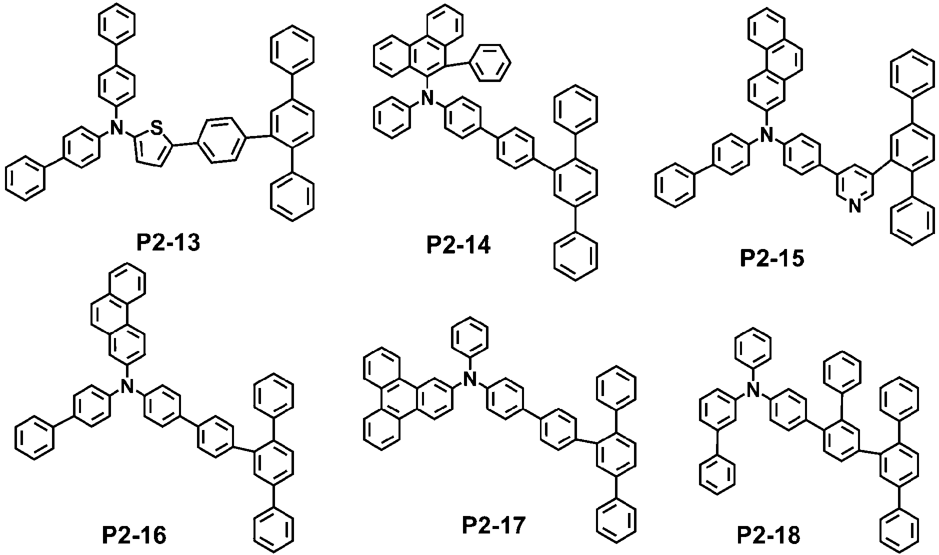

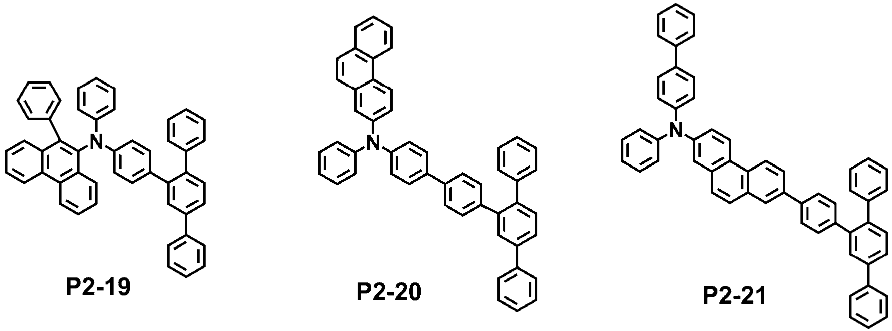

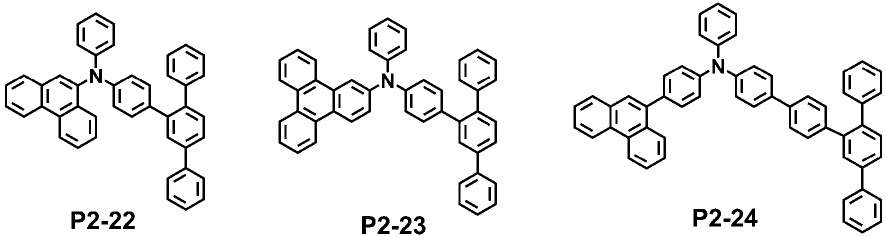

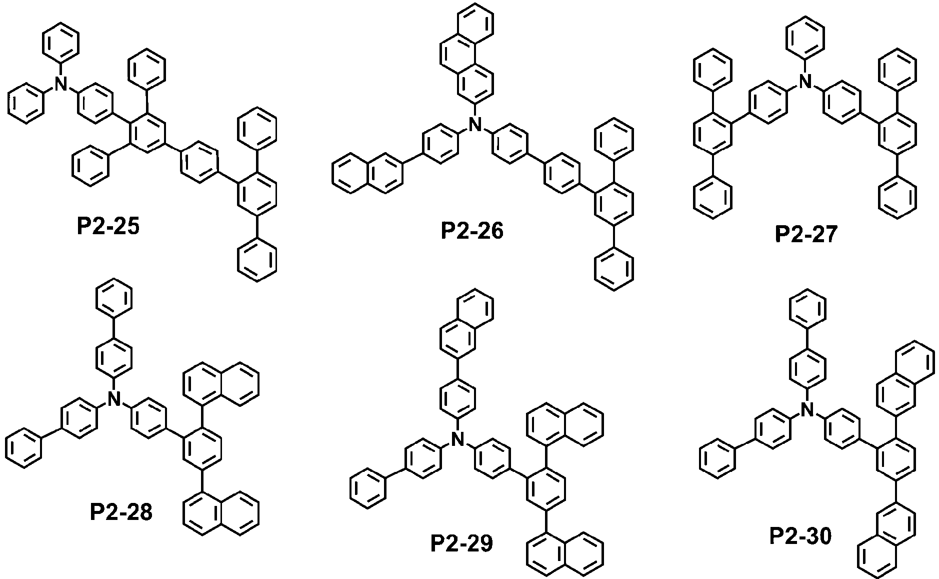

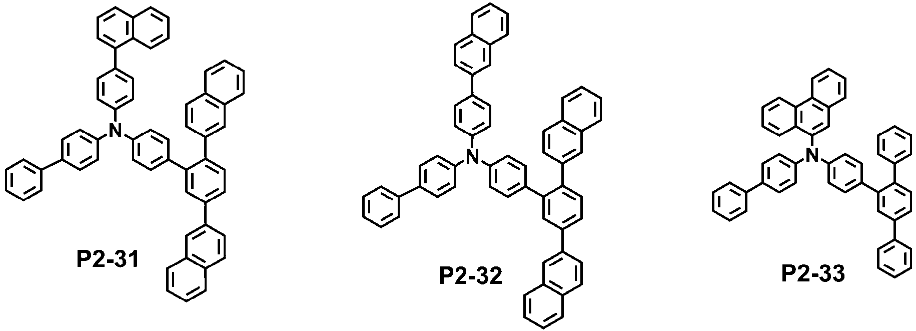

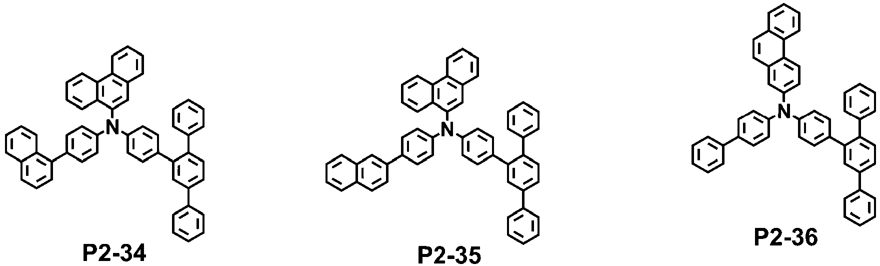

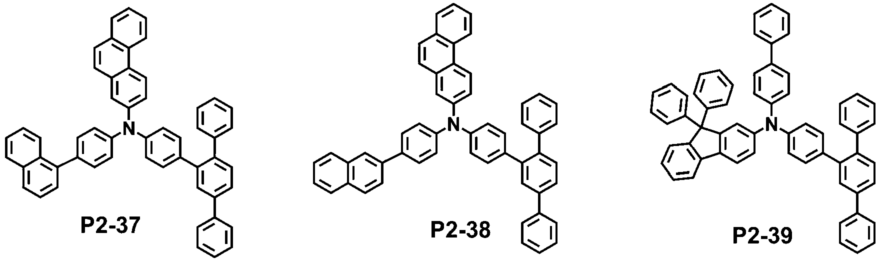

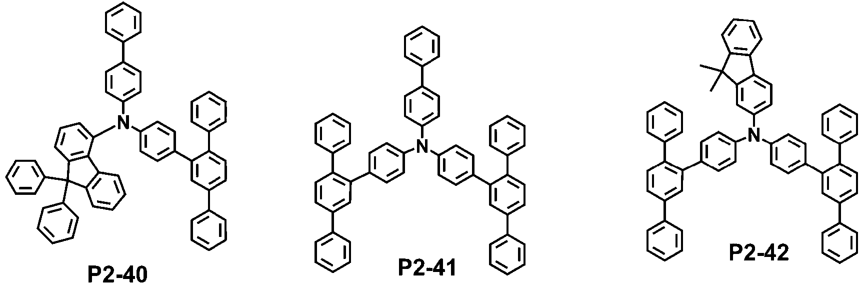

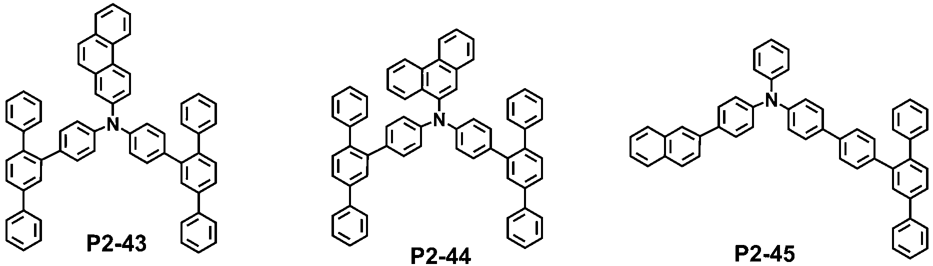

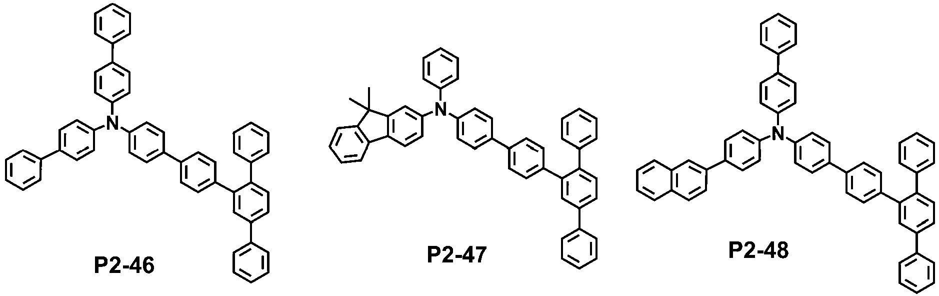

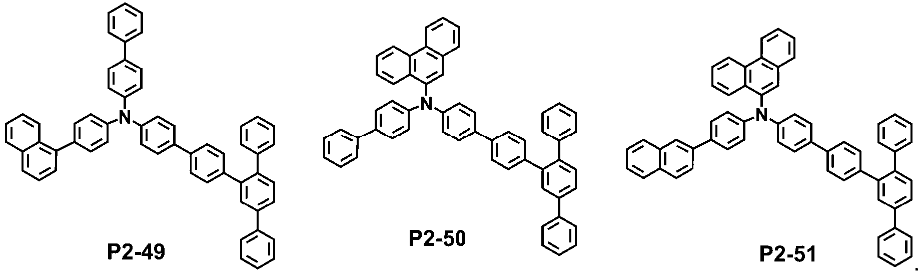

14. An electronic apparatus comprising the light-emitting device (10) of any one of claims 1 to 13.

15. Electronic equipment (1) comprising the light-emitting device (10) of any one of claims 1 to 13, optionally further comprising at least one of:
a processor (12);
a memory (13); and
a power module (14).
